# EUROPEAN PATENT APPLICATION

(11) **EP 4 719 010 A1**
(43) Date of publication of application: **01.04.2026**
(21) Application number: 24832441.0
(22) Date of filing: 26.06.2024
(51) Int. Cl.: H10H 29/01, H10H 20/813, H10H 20/84, H10H 20/831, H10H 20/854, H10H 20/855, H10H 20/857

(54) **PIXEL ELEMENT FOR DISPLAY, AND DISPLAY DEVICE HAVING SAME**

(30) Priority: 26.06.2023 US 202363523224 P; 06.07.2023 US 202363525362 P; 25.06.2024 US 202418753775
(71) Applicant: Seoul Viosys Co., Ltd., Ansan-si, Gyeonggi-do 15429 (KR)
(72) Inventor: CHA, Namgoo, Ansan-si, Gyeonggi-do 15429 (KR); LEE, Chungjae, Ansan-si, Gyeonggi-do 15429 (KR)
(74) Representative: Stolmár & Partner Patentanwälte PartG mbB
(86) International application number: PCT/KR2024/008915
(87) International publication number: WO 2025/005663

(57) **Abstract**

The present disclosure relates to a pixel device for displays and a display apparatus including the same. According to an exemplary embodiment, the pixel device may include: a first light emitting source including a first light emitting structure formed by stacking a first-1 semiconductor layer, a first active layer, and a first-2 semiconductor layer on a first base; a second light emitting source including a second light emitting structure formed by stacking a second-1 semiconductor layer, a second active layer, and a second-2 semiconductor layer on the first light emitting source; a third light emitting source including a third light emitting structure formed by stacking a third-1 semiconductor layer, a third active layer, and a third-2 semiconductor layer on the second light emitting source; and a common electrode electrically connected in common to the first-1 semiconductor layer, the second-1 semiconductor layer, and the third-1 semiconductor layer; a first electrode electrically connected to the first-2 semiconductor layer; a second electrode electrically connected to the second-2 semiconductor layer; and a third electrode electrically connected to the third-2 semiconductor layer. The common electrode and the first electrode may be formed along a side surface of the second-1 semiconductor layer and a side surface of the third-1 semiconductor layer to form a stepped structure.

## Description

### [Technical Field]

Embodiments of the present disclosure relate to a pixel device for displays and a display apparatus including the same.

### [Background Art]

A light emitting device is a semiconductor device using a light emitting diode as an inorganic light source and is widely used in various fields, such as display apparatuses, automotive lamps, and general lighting. With various advantages, such as long lifespan, low power consumption, and fast response time, light emitting diodes are rapidly replacing traditional light sources.

Generally, typical light emitting diodes are used as backlight light sources in a display apparatus and, in recent years, display apparatuses adapted to directly realize images using light emitting diodes have been developed. Such displays are referred to as micro-LED displays.

A display apparatus typically uses a mixture of blue, green and red to realize different colors. To realize various images, the display apparatus includes a plurality of pixels each including blue, green, and red subpixels. The colors of these subpixels determine a color of a particular pixel and an image is realized through combination of these pixels.

In addition, the pixel may have a structure in which a blue subpixel, a green subpixel, and a blue subpixel are sequentially stacked one above another. Further, each sub-pixel includes a light emitting region in which a light emitting structure is formed and a non-light emitting region in which the light emitting structure is omitted. When a plurality of subpixels is stacked, the light emitting region of a subpixel may be disposed on the non-light emitting region of another subpixel. Here, the weight of the light emitting region formed with the light emitting structure at an upper region of the pixel device can cause deformation of the non-light emitting region at a lower region thereof. As a result, the pixel device can suffer from deformation, such as warpage and the like.

In a micro-LED display, a great number of micro-LEDs are mounted on a single substrate so as to be arranged corresponding to each sub-pixel. However, the micro-LEDs have a very small size of 200 µm or less, for example, 100 µm or less, thereby providing a limited effective luminous area. Moreover, electrodes for electrical connection are required for a small light emitting device, thereby causing loss of brightness through reduction in light emitting region.

### [Disclosure]

### [Technical Problem]

Embodiments of the present disclosure provide a pixel device capable of minimizing reduction in luminous area and a display apparatus including the same.

Embodiments of the present disclosure provide a pixel device ensuring emission of a uniform quantity of light per color and a display apparatus including the same.

Embodiments of the present disclosure provide a pixel device capable of simplifying a manufacturing process and a display apparatus including the same.

Embodiments of the present disclosure provide a pixel device capable of preventing deformation and a display apparatus including the same.

Embodiments of the present disclosure provide a pixel device capable of preventing delamination between components thereof and a display apparatus thereof.

### [Technical Solution]

In accordance with one aspect of the present disclosure, a pixel device may include: a first light emitting source including a first light emitting structure formed by stacking a first-1 semiconductor layer, a first active layer, and a first-2 semiconductor layer on a first base; a second light emitting source formed on the first light emitting source and including a second light emitting structure formed by stacking a second-1 semiconductor layer, a second active layer, and a second-2 semiconductor layer; a third light emitting source formed on the second light emitting source and including a third light emitting structure formed by stacking a third-1 semiconductor layer, a third active layer, and a third-2 semiconductor layer; and a common electrode electrically connected in common to the first-1 semiconductor layer, the second-1 semiconductor layer, and the third-1 semiconductor layer; a first electrode electrically connected to the first-2 semiconductor layer; a second electrode electrically connected to the second-2 semiconductor layer; and a third electrode electrically connected to the third-2 semiconductor layer. The common electrode, the first electrode, the second electrode, and the third electrode may be spaced apart from one another. An inner surface of the third-1 semiconductor layer may be formed farther outward than an inner surface of the second-1 semiconductor layer. The common electrode and the first electrode may be formed along a side surface of the second-1 semiconductor layer and a side surface of the third-1 semiconductor layer to form a stepped structure.

The first light emitting source, the second light emitting source, and the third light emitting source may emit different colors of visible light.

The pixel device may further include: a first transparent layer disposed between the first light emitting source and the second light emitting source; and a second transparent layer disposed between the second light emitting source and the third light emitting source.

The common electrode may be formed through the first transparent layer and the second transparent layer to be electrically connected to the second-1 semiconductor layer and the first-1 semiconductor layer. The first electrode may be formed through the first transparent layer and the second transparent layer to be electrically connected to the first-2 semiconductor layer. The second electrode may be formed through the second transparent layer to be electrically connected to the second-2 semiconductor layer.

Each of the common electrode and the first electrode may be disposed on a vertical line on which a central axis of a region thereof formed on the first light emitting source, a central axis of a region thereof formed on the second light emitting source, and a central axis of a region thereof formed on the third light emitting source are different from one another.

The first light emitting source may further include a first insulating layer covering the first light emitting structure, the second light emitting source may further include a second insulating layer covering the second light emitting structure, and the third light emitting source may further include a third insulating layer covering the third light emitting structure.

The common electrode may include: a first-1 metal layer electrically connected to the first-1 semiconductor layer; a second-1 metal layer electrically connected to the second-1 semiconductor layer; and a third-1 metal layer electrically connected to the third-1 semiconductor layer. The second-1 metal layer may be formed from an upper surface of the first-1 metal layer to an upper surface of the second-1 semiconductor layer along an inner surface of the second-1 semiconductor layer. The third-1 metal layer may be formed from an upper surface of the second-1 metal layer to an upper surface of the third-1 semiconductor layer along an inner surface of the third-1 semiconductor layer.

The first insulating layer may include a first-1 opening in which the first-1 semiconductor layer adjoins the first-1 metal layer, the second insulating layer may include a second-3 opening in which the first-2 semiconductor layer adjoins the second-1 metal layer, and the third insulating layer may include a third-3 opening in which the third-1 semiconductor layer adjoins the third-1 metal layer. The second-3 opening may be placed above the outside of the first-1 opening and the third-3 opening may be placed above the outside of the second-3 opening.

The pixel device may include: a second-1 opening in which the first-1 metal layer adjoins the second-1 metal layer; and a third-1 opening in which the second-1 metal layer adjoins the third-1 metal layer. The second-1 opening may be disposed on the first insulating layer and may be formed through the first transparent layer and the second insulating layer to expose a region of the upper surface of the first-1 metal layer. The third-1 opening may be disposed on the second insulating layer and may be formed through the second transparent layer and the third insulating layer to expose a region of the upper surface of the second-1 metal layer.

In one embodiment, the second-1 metal layer may be formed to cover an inner surface of the second-1 opening while exposing the upper surface of the first-1 metal layer. The third-1 metal layer may be formed to cover an inner surface of the third-1 opening while exposing the upper surface of the second-1 metal layer.

In another embodiment, the second-1 metal layer may further cover the upper surface of the first-1 metal layer in the second-1 opening and may have an inner space in the second-1 opening. The third-1 metal layer may further cover the upper surface of the second-1 metal layer in the third-1 opening and may have an inner space in the third-1 opening.

In another embodiment, the second-1 metal layer may be formed to fill the second-1 opening and the third-1 metal layer may be formed to fill the third-1 opening.

The first electrode may include: a first-2 metal layer electrically connected to the first-2 semiconductor layer; a second-2 metal layer formed from an upper surface of the first-2 metal layer to an upper region of the second-2 semiconductor layer along an inner surface of the second light emitting structure; and a third-2 metal layer formed from an upper surface of the second-2 metal layer to an upper region of the third-2 semiconductor layer along an inner surface of the third light emitting structure.

The first insulating layer may include a first-2 opening in which the first-2 semiconductor layer adjoins the first-2 metal layer, the second insulating layer may include a second-2 opening in which the first-2 metal layer adjoins the second-2 metal layer, and the third insulating layer may include a third-2 opening in which the second-2 metal layer adjoins the third-2 metal layer. The second-2 opening may be placed above the first-2 opening to deviate therefrom and the third-2 opening may be placed above the second-2 opening.

The second-2 opening may be disposed on the first insulating layer and may be formed through the first transparent layer and the second insulating layer to expose a region of the upper surface of the first-2 metal layer. The third-2 opening may be disposed on the second insulating layer and may be formed through the second transparent layer and the third insulating layer to expose a region of the upper surface of the second-2 metal layer.

In one embodiment, the second-2 metal layer may cover an inner surface of the second-2 opening while exposing the upper surface of the first-2 metal layer. The third-2 metal layer may cover an inner surface of the third-2 opening while exposing the upper surface of the second-2 metal layer.

In another embodiment, the second-2 metal layer may further cover the upper surface of the first-2 metal layer in the second-2 opening and may have an inner space in the second-2 opening. The third-2 metal layer may further cover the upper surface of the first-2 metal layer in the third-2 opening and may have an inner space in the third-2 opening.

In another embodiment, the second-2 metal layer may be formed to fill the second-2 opening and the third-2 metal layer may be formed to fill the third-2 opening.

The second electrode may include: a second-3 metal layer electrically connected to the second-2 semiconductor layer; and a third-3 metal layer formed from an upper surface of the second-3 metal layer to an upper surface of the third light emitting structure along an inner surface of the third light emitting structure.

The second insulating layer may include a second-4 opening in which the second-2 semiconductor layer adjoins the second-3 metal layer, the third insulating layer may include a third-4 opening in which the second-3 metal layer adjoins the second-3 semiconductor layer, and the third-4 opening may be placed above the second-4 opening.

The third-4 opening may be disposed on the second insulating layer and may be formed through the second transparent layer and the third insulating layer to expose a region of the upper surface of the second-3 metal layer.

In one embodiment, the third-3 metal layer may cover an inner surface of the third-4 opening while exposing the upper surface of the second-3 metal layer.

In another embodiment, the third-3 metal layer may further cover the upper surface of the second-3 metal layer in the third-4 opening and may have an inner space in the third-4 opening.

In another embodiment, the third-3 metal layer may be formed to fill the third-4 opening.

The third electrode may include a third-4 metal layer electrically connected to the third-3 semiconductor layer.

The third insulating layer may include a third-5 opening in which the third-3 semiconductor layer adjoins the third-4 metal layer.

In accordance with another aspect of the present disclosure, there is provided a pixel device including a first light emitting source, a second light emitting source, and a third light emitting source. The first light emitting source may include a first light emitting structure emitting first light and a first buffer structure spaced apart from the first light emitting structure. The second light emitting source may include a second light emitting structure emitting second light and a second buffer structure spaced apart from the second light emitting structure. The third light emitting source may include a third light emitting structure emitting third light and a third buffer structure spaced apart from the third light emitting structure. The second light emitting source is stacked on the first light emitting source and the third light emitting source is stacked on the second light emitting source. Each of the first light emitting source, the second light emitting source, and the third light emitting source includes a first semiconductor layer, an active layer, and a second semiconductor layer. In addition, the first buffer structure, the second buffer structure, and the third buffer structure are disposed in a non-light emitting region of the first light emitting source, the second light emitting source, and the third light emitting source, respectively, and are insulated from one another.

The first light emitting source, the second light emitting source, and the third light emitting source may emit different colors of visible light.

The first light emitting source may include a first-1 semiconductor layer, a first-2 semiconductor layer, and a first active layer formed between the first-1 semiconductor layer and the first-2 semiconductor layer. The second light emitting source may include a second-1 semiconductor layer, a second-2 semiconductor layer, and a second active layer formed between the second-1 semiconductor layer and the second-2 semiconductor layer. In addition, the third light emitting source may include a third-1 semiconductor layer, a third-2 semiconductor layer, and a third active layer formed between the third-1 semiconductor layer and the third-2 semiconductor layer.

The first light emitting structure may include the first active layer and the first-2 semiconductor layer formed on the first-1 semiconductor layer. The second light emitting structure may include the second active layer and the second-2 semiconductor layer formed on the second-1 semiconductor layer. In addition, the third light emitting structure may include the third active layer and the third-2 semiconductor layer formed on the third-1 semiconductor layer.

The first buffer structure may include the first active layer and the first-2 semiconductor layer formed on the first-1 semiconductor layer. The second buffer structure may include the second active layer and the second-2 semiconductor layer formed on the second-1 semiconductor layer. In addition, the third buffer structure may include the third active layer and the third-2 semiconductor layer formed on the third-1 semiconductor layer.

The pixel device may include: a common electrode electrically connected to all of the first-1 semiconductor layer, the second-1 semiconductor layer, and the third-1 semiconductor layer; a first electrode electrically connected to the first-2 semiconductor layer; a second electrode electrically connected to the second-2 semiconductor layer; and a third electrode electrically connected to the third-2 semiconductor layer.

The pixel device may include: a first transparent layer disposed between the first light emitting source and the second light emitting source; and a second transparent layer disposed between the second light emitting source and the third light emitting source.

The common electrode may be electrically connected to the first-1 semiconductor layer and the second-1 semiconductor layer through the first transparent layer and the second transparent layer. The first electrode may be formed through the first transparent layer and the second transparent layer to be electrically connected to the first-2 semiconductor layer. In addition, the second electrode may be formed through the second transparent layer to be electrically connected to the second-2 semiconductor layer.

The common electrode may include a first-1 metal layer, a first-1 connection metal layer, a second-1 metal layer, a second-1 connection metal layer, and a third-1 metal layer. The first-1 metal layer may be formed on the first-1 semiconductor layer of the first light emitting source to contact the first-1 semiconductor layer. The first-1 connection metal layer may be formed through the first transparent layer to contact the first-1 metal layer. The second-1 metal layer may be formed through the second-1 semiconductor layer of the second light emitting source to contact the second-1 semiconductor layer. The second-1 connection metal layer may be formed through the second transparent layer to contact the second-1 metal layer. The third-1 metal layer may be formed through the third-1 semiconductor layer of the third light emitting source to contact the third-1 semiconductor layer. At least a region of the first-1 connection metal layer may be disposed on the first-1 metal layer. At least a region of the second-1 metal layer may be disposed on the first-1 connection metal layer. At least a region of the second-1 connection metal layer may be disposed on the second-1 metal layer. In addition, at least a region of the third-1 metal layer may be disposed on the second-1 connection metal layer.

The first electrode may include a first-2 metal layer, a first-2 connection metal layer, a second-2 metal layer, a second-2 connection metal layer, and a third-2 metal layer. The first-2 metal layer may be formed on the first-2 semiconductor layer of the first light emitting source to be electrically connected to the first-2 semiconductor layer. The first-2 connection metal layer may be formed through the first transparent layer to contact the first-2 metal layer. The second-2 metal layer may be formed through the second-1 semiconductor layer of the second light emitting source and insulated from the second-1 semiconductor layer. The second-2 connection metal layer may be formed through the second transparent layer to contact the second-2 metal layer. The third-2 metal layer may be formed through the third-1 semiconductor layer of the third light emitting source and insulated from the third-1 semiconductor layer. At least a region of the first-2 connection metal layer may be disposed on the first-2 metal layer. At least a region of the second-2 metal layer may be disposed on the first-2 connecting metal layer. At least a region of the second-2 connection metal layer may be disposed on the second-2 metal layer. In addition, at least a region of the third-2 metal layer may be disposed on the second-2 connection metal layer.

The second electrode may include a second-3 metal layer, a second-3 connection metal layer, and a third-3 metal layer. The second-3 metal layer may be formed on the second-2 semiconductor layer of the second light emitting source to be electrically connected to the second-2 semiconductor layer. The second-3 connection metal layer may be formed through the second transparent layer to contact the second-3 metal layer. The third-3 metal layer may be formed through the third-1 semiconductor layer of the third light emitting source and insulated from the third-1 semiconductor layer. At least a region of the second-3 connection metal layer may be disposed on the second-3 metal layer. In addition, at least a region of the third-3 metal layer may be disposed on the second-3 connection metal layer.

The third electrode may include a third-4 metal layer formed on the third-2 semiconductor layer of the third light emitting source to be electrically connected to the third-2 semiconductor layer.

The second light emitting structure may be partially disposed on the first light emitting structure and the third light emitting structure may be partially disposed on the second light emitting structure.

The first buffer structure, the second buffer structure, and the second buffer structure may be formed outside a region in which all of the first light emitting structure, the second light emitting structure, and the third light emitting structure are stacked.

The common electrode, the first electrode, the second electrode, and the third electrode may be formed outside a region in which all of the first light emitting structure, the second light emitting structure, and the third light emitting structure are stacked.

### [Advantageous Effect]

A pixel device according to an embodiment of the present disclosure and a display apparatus including the same can minimize reduction in luminous area by forming electrodes outside a light emitting structure, thereby improving luminous efficacy.

In addition, a pixel device according to an embodiment of the present disclosure and a display apparatus including the same can have the same luminous area for each color of light, thereby ensuring emission of a uniform quantity of light per color.

Further, a pixel device according to an embodiment of the present disclosure and a display apparatus including the same can simplify a manufacturing process by forming openings for formation of electrodes in layers formed of the same material.

Furthermore, a pixel device according to an embodiment of the present disclosure and a display apparatus including the same can prevent deformation of the pixel device, such as warpage.

Furthermore, a pixel device according to an embodiment of the present disclosure and a display apparatus including the same can prevent delamination between stacked components by forming a flat upper surface of a component placed at a lower side.

### [Description of Drawings]

FIG. 1 is a schematic plan view of a display apparatus according to one embodiment of the present disclosure.
FIG. 2 is a schematic plan view of a pixel device according to a first embodiment of the present disclosure.
FIG. 3 is a cross-sectional view (A1-A2) of the pixel device according to the first embodiment of the present disclosure.
FIG. 4 is a perspective cross-sectional view (A3-A4) of the pixel device according to the first embodiment of the present disclosure.
FIG. 5 to FIG. 39 are views illustrating a method of manufacturing the pixel device according to the first embodiment of the present disclosure.
FIG. 40 is a schematic plan view of a pixel device according to a second embodiment of the present disclosure.
FIG. 41 is a cross-sectional view (G1-G2) of the pixel device according to the second embodiment of the present disclosure.
FIG. 42 is another cross-sectional view (G3-G4) of the pixel device according to the second embodiment of the present disclosure.
FIG. 43 is a schematic plan view of a pixel device according to a third embodiment of the present disclosure.
FIG. 44 is a cross-sectional view (H1-H2) of the pixel device according to the third embodiment of the present disclosure.
FIG. 45 is another cross-sectional view (H3-H4) of the pixel device according to the third embodiment of the present disclosure.
FIG. 46 is a cross-sectional view of a pixel device according to a fourth embodiment of the present disclosure.
FIG. 47 is another cross-sectional view of the pixel device according to the fourth embodiment of the present disclosure.
FIG. 48 to FIG. 52 are views of a first light emitting source of a pixel device according to a fifth embodiment of the present disclosure and a manufacturing method thereof.
FIG. 53 to FIG. 57 are views of a second light emitting source of the pixel device according to the fifth embodiment of the present disclosure and a manufacturing method thereof.
FIG. 58 to FIG. 62 are views of a third light emitting source of the pixel device according to the fifth embodiment of the present disclosure and a manufacturing method thereof.
FIG. 63 is a view of a first transparent layer formed on the first light emitting source according to the fifth embodiment of the present disclosure.
FIG. 64 is a view of a first connection metal layer formed on the first transparent layer according to the fifth embodiment of the present disclosure.
FIG. 65 is a view of the second light emitting source according to the fifth embodiment of the present disclosure, with a second base removed therefrom.
FIG. 66 is a view of the first light emitting source and the second light emitting source formed on the first light emitting source according to the fifth embodiment of the present disclosure.
FIG. 67 is a view of a second transparent layer formed on the second light emitting source according to the fifth embodiment of the present disclosure.
FIG. 68 is a view of a second connection metal layer formed on the second transparent layer according to the fifth embodiment of the present disclosure.
FIG. 69 is a view of the third light emitting source according to the fifth embodiment of the present disclosure, with a third base removed therefrom.
FIG. 70 is a view of the pixel device including the first light emitting source, the second light emitting source formed on the first light emitting source, and the third light emitting source formed on the second light emitting source according to the fifth embodiment of the present disclosure.
FIG. 71 is a view of the pixel device according to the fifth embodiment of the present disclosure, with a protective layer formed thereon.

### [Detailed Description of the Illustrated Embodiments]

Hereinafter, pixel devices for displays according to the present disclosure and a display apparatus including the same will be described in detail with reference to the drawings.

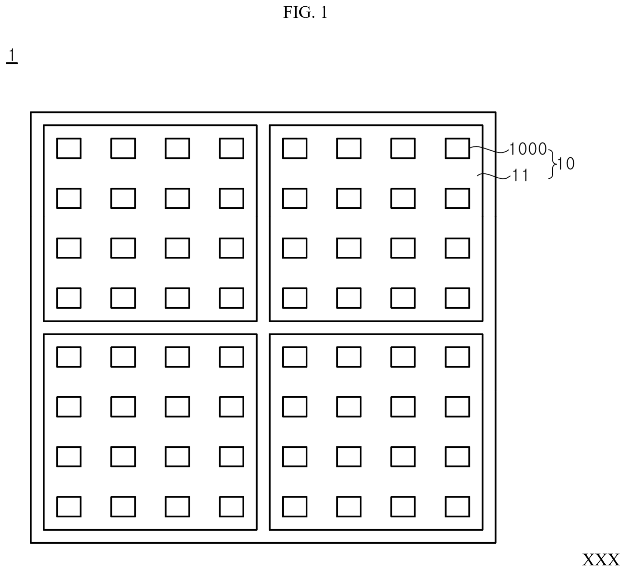

FIG. 1 is a schematic plan view of a display apparatus according to one embodiment of the present disclosure.

Referring to FIG. 1, a display apparatus 1 may include a panel substrate 11 and a plurality of pixel modules 10.

The display apparatus 1 may include a wearable display apparatus 1, such as a smartwatch, a VR headset, and glasses, an AR display apparatus 1, such as augmented reality glasses, or an indoor or outdoor display apparatus 1, such as a micro-LED TV or signboard, without being limited thereto.

The panel substrate 11 and the plurality of pixel modules 10 may be disposed inside the display apparatus 1. Here, each of the pixel modules 10 may be a pixel of the display apparatus 1.

The display apparatus 1 may have a very narrow distance of, for example, 0.01 mm or less between pixels. The display apparatus 1 can realize an image through pixels mounted on a circuit board 1001 or a transparent substrate.

In some display apparatuses 1, the distance between the display apparatus 1 and an external receiver (for example, the user's eye) recognizing the display apparatus may be 200 mm or less. The distance between the pixels may range from 0.005% to 0.1% of the distance between the external receiver and the display apparatus 1.

The display apparatus 1 may send optical signals from a substrate including a curved surface to the external receiver. The display apparatus 1 may also be realized by a transparent display apparatus 1 using a transparent substrate.

The panel substrate 11 may include circuits for passive matrix driving or active matrix driving. In one embodiment, the panel substrate 11 may include interconnections and resistors therein, and in another embodiment, the panel substrate 11 may include interconnections, transistors, and capacitors. The panel substrate 11 may also be provided on an upper surface thereof with pads that may be electrically connected to the circuits thereon.

In one embodiment, the plurality of pixel modules 10 is aligned on the panel substrate 11. Each of the pixel modules 10 may include a circuit board 1001 and a plurality of pixel devices 1000 disposed on the circuit board 1001. Further, the pixel module 10 may include a molding layer (not shown) covering the pixel devices 1000. In other embodiments, the plurality of pixel devices 1000 may be arranged directly on the panel substrate 11 and the molding layer may cover the pixel devices 1000.

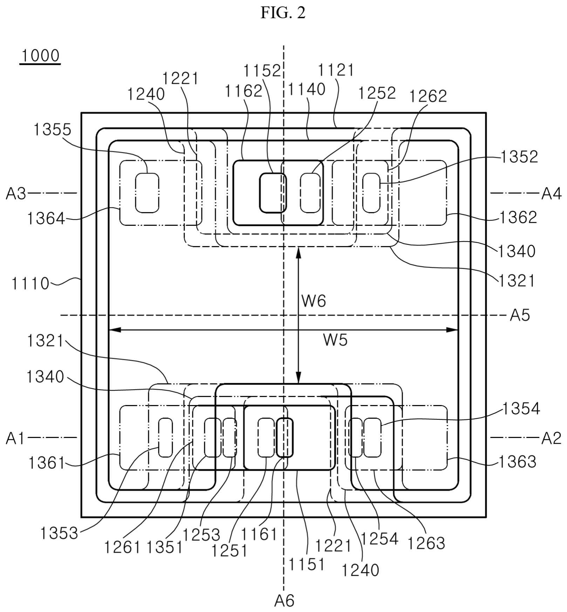

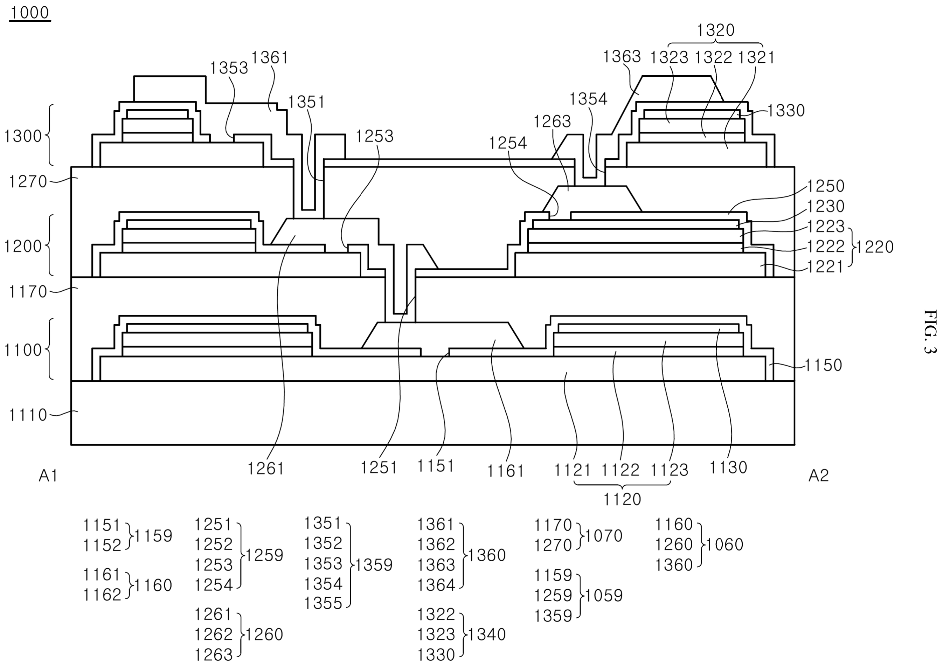

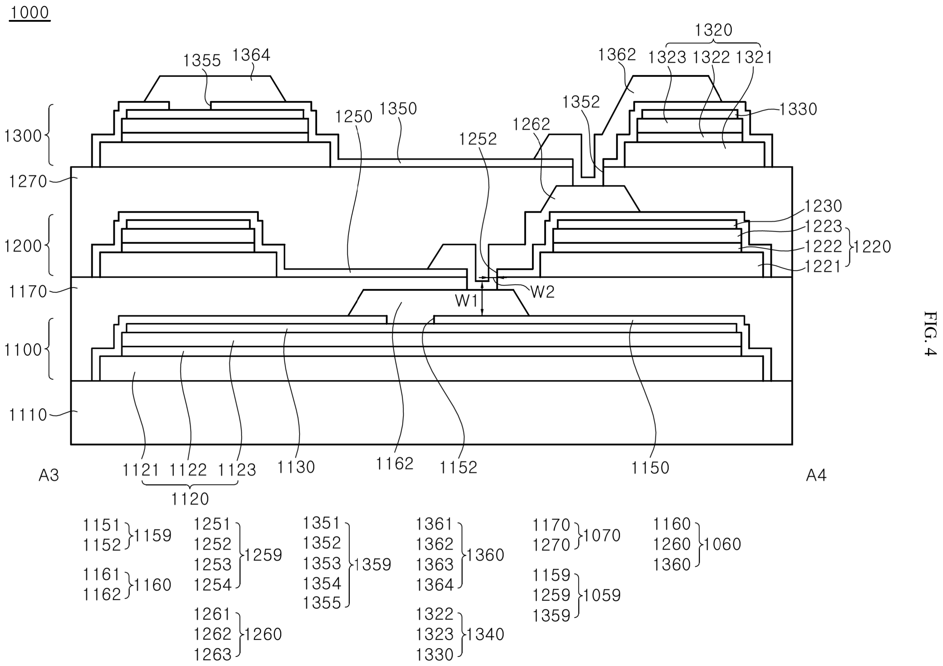

FIG. 2 to FIG. 4 are views of a pixel device 1000 according to a first embodiment of the present disclosure. FIG. 2 is a schematic plan view of the pixel device 1000 according to the first embodiment of the present disclosure. FIG. 3 is a cross-sectional view (A1-A2) of the pixel device 1000 according to the first embodiment of the present disclosure. Further, FIG. 4 is another cross-sectional view (A3-A4) of the pixel device 1000 according to the first embodiment of the present disclosure.

Referring to FIG. 2 to FIG. 4, the pixel device 1000 according to the first embodiment of the present disclosure may include a first base 1110, a first light emitting source 1100, a second light emitting source 1200, and a third light emitting source 1300.

The first light emitting source 1100 may have a structure in which a first-1 semiconductor layer 1121, a first active layer 1122, and a first-2 semiconductor layer 1123 are stacked one above another. The second light emitting source 1200 may have a structure in which a second-1 semiconductor layer 1221, a second active layer 1222, and a second-2 semiconductor layer 1223 are stacked one above another. In addition, the third light emitting source 1300 may have a structure in which a third-1 semiconductor layer 1321, a third active layer 1322, and a third-2 semiconductor layer 1323 are stacked one above another. Here, the first-1 semiconductor layer 1121, the second-1 semiconductor layer 1221, and the third-1 semiconductor layer 1321 may be n-type semiconductor layers. In addition, the first-2 semiconductor layer 1123, the second-2 semiconductor layer 1223, and the third-2 semiconductor layer 1323 may be p-type semiconductor layers. Alternatively, these layers may be set in opposite ways.

For example, the first light emitting source 1100 may emit green light, the second light emitting source 1200 may emit blue light, and the third light emitting source 1300 may emit red light.

Further, the pixel device 1000 has a structure in which the first light emitting source 1100, the second light emitting source 1200, and the third light emitting source 1300 are stacked one above another on the first base 1110. Transparent layers 1070 may be formed between the first light emitting source 1100 and the second light emitting source 1200 and between the second light emitting source 1200 and the third light emitting source 1300, respectively. The transparent layers 1070 may be formed of a light transmissive material. Alternatively, the transparent layers 1070 may be formed of a material that transmits and scatters light. Alternatively, the transparent layers 1070 may be formed of a light transmissive resin with a light scattering material dispersed therein.

A first transparent layer 1170 may be formed between the first light emitting source 1100 and the second light emitting source 1200 and a second transparent layer 1270 may be formed between the second light emitting source 1200 and the third light emitting source 1300. The first transparent layer 1170 may transmit light emitted from the second light emitting source 1200 and the third light emitting source 1300. In addition, the second transparent layer 1270 may transmit light emitted from the third light emitting source 1300.

In addition, the transparent layers 1070 may have an adhesive function. Thus, the first transparent layer 1170 and the second transparent layer 1270 allows the pixel device 1000 to maintain a structure in which the first light emitting source 1100, the second light emitting source 1200, and the third light emitting source 1300 are stacked one above another.

The pixel device 1000 according to this embodiment may include metal layers 1060 for electrical connection to the first light emitting source 1100, the second light emitting source 1200, and the third light emitting source 1300. In addition, the first light emitting source 1100, the second light emitting source 1200, and the third light emitting source 1300 may include insulating layers 1050 to prevent unnecessary electrical connection to the metal layers 1060. Further, the insulating layers 1050 may include openings 1059 to allow the first light emitting source 1100, the second light emitting source 1200, and the third light emitting source 1300 to be electrically connected to the metal layers 1060.

The insulating layers 1050 may include a first insulating layer 1150 of the first light emitting source 1100, a second insulating layer 1250 of the second light emitting source 1200, and a third insulating layer 1350 of the third light emitting source 1300. Further, the first transparent layer 1170 may be formed between the first light emitting source 1100 and the second light emitting source 1200 and the second transparent layer 1270 may be formed between the second light emitting source 1200 and the third light emitting source 1300.

Referring to FIG. 3 and FIG. 4, the first insulating layer 1150 is formed with first openings 1159, which include a first-1 opening 1151 and a first-2 opening 1152.

The second insulating layer 1250 and the first transparent layer 1170 are formed with second openings 1259. The second openings 1259 include a second-3 opening 1253 and a second-4 opening 1254 formed in the second insulating layer 1250, and a second-1 opening 1251 and a second-2 opening 1252 formed in the second insulating layer 1250 and the first transparent layer 1170.

According to the embodiment, second metal layers 1260 are formed to partially cover the second insulating layer 1250. In addition, the first transparent layer 1170 may be partially placed between first metal layers 1160 and the second metal layers 1260. Further, both the second insulating layer 1250 and the first transparent layer 1170 may be partially placed between the first metal layers 1160 and the second metal layers 1260. That is, both the second insulating layer 1250 and the first transparent layer 1170 may be partially embedded between the first metal layers 1160 and the second metal layers 1260. Here, the second insulating layer 1250 is partially stacked on an upper surface of the first transparent layer 1170. Coupling strength between the second insulating layer 1250 and the first transparent layer 1170 can be improved by the first metal layers 1160 and the second metal layers 1260, in which the second insulating layer 1250 and the second transparent layer 1170 are partially embedded.

In addition, the third insulating layer 1350 and the second transparent layer 1270 are formed with third openings 1359. The third openings 1359 include a third-3 opening 1353 and a third-5 opening 1355 formed in the third insulating layer 1350, and a third-1 opening 1351, a third-2 opening 1352, and a third-4 opening 1354 formed in the third insulating layer 1350 and the second transparent layer 1270.

The third insulating layer 1350 and the second transparent layer 1270 may also be partially embedded in a stacked state between the second metal layers 1260 and the third metal layers 1360. As a result, coupling strength between the third insulating layer 1350 and the second transparent layer 1270 can be improved by the second metal layers 1260 and the third metal layers 1360, in which the third insulating layer 1350 and the second transparent layer 1270 are partially embedded.

Referring to FIG. 3, the first-1 opening 1151, the second-1 opening 1251, the second-3 opening 1253, the third-1 opening 1351, and the third-3 opening 1353 may be formed to have central axes placed on different vertical lines, respectively. In addition, the first-1 opening 1151, the second-1 opening 1251, the second-3 opening 1253, the third-1 opening 1351, and the third-3 opening 1353 may be spaced apart from each other.

Further, the second-4 opening 1254 and the third-4 opening 1354 may be formed to have central axes placed on different vertical lines, respectively. In addition, the third-4 opening 1354 may be formed above the second-4 opening 1254.

Referring to FIG. 4, the first-2 opening 1152, the second-2 opening 1252, and the third-2 opening 1352 may be formed to have central axes placed on different vertical lines, respectively. In addition, the first-2 opening 1152, the second-2 opening 1252, and the third-2 opening 1352 may be placed to deviate from each other.

The first light emitting source 1100 may be formed with first metal layers 1160, the second light emitting source 1200 may be formed with second metal layers 1260, and the third light emitting source 1300 may be formed with third metal layers 1360.

The first metal layers 1160 may include a first-1 metal layer 1161 and a first-2 metal layer 1162. The second metal layers 1260 may include second-1 to second-3 metal layers 1261, 1262, 1263. Further, the third metal layers 1360 may include third-1 to third-4 metal layers 1361, 1362, 1363, 1364.

Referring to FIG. 3, the first-1 metal layer 1161 is formed on the first light emitting source 1100 to be electrically connected to the first-1 semiconductor layer 1121 of the first light emitting source 1100. In addition, the first-1 metal layer 1161 may be electrically connected to the second-1 metal layer 1261 formed on the second light emitting source 1200 to be electrically connected to the second-1 semiconductor layer 1221. Further, the second-1 metal layer 1261 may be electrically connected to the third-1 metal layer 1361 formed on the third light emitting source 1300 to be electrically connected to the third-1 semiconductor layer 1321. That is, the first-1 semiconductor layer 1121, the second-1 metal layer 1261, and the third-1 metal layer 1361 may be electrically connected to one another by the first-1 metal layer 1161, the second-1 metal layer 1261, and the third-1 metal layer 1361. Here, the first-1 metal layer 1161, the second-1 metal layer 1261, and the third-1 metal layer 1361 may act as a common electrode that is commonly connected to the first semiconductor layers of the first light emitting source 1100, the second light emitting source 1200, and the third light emitting source 1300. Here, the first semiconductor layers refer to the first-1 semiconductor layer 1121 of the first light emitting source 1100, the second-1 semiconductor layer 1221 of the second light emitting source 1200, and the third-1 semiconductor layer 1321 of the third light emitting source 1300.

Referring to FIG. 2, an imaginary horizontal centerline A5 and an imaginary vertical centerline A6 crossing the center of the pixel device 1000 are shown.

The pixel device 1000 may be divided into one side and the other side with reference to the horizontal centerline A5 shown in FIG. 2. Referring to FIG. 2, the metal layers 1060 are disposed at one side and the other side of the horizontal central line A5. A light emitting region may be formed between the metal layers 1060 disposed at one side and the other side. The light emitting region may be a region in which at least two light emitting sources overlap each other among the first light emitting source 1100, the second light emitting source 1200, and the third light emitting source 1300. Furthermore, the light emitting region may be a portion of a region in which all of the first light emitting source 1100, the second light emitting source 1200, and the third light emitting source 1300 overlap one another, or the entirety thereof.

Referring to FIG. 2, a width W5 of the light emitting region along the horizontal centerline A5 may be different from a width W6 of the light emitting region along the vertical centerline A6. For example, the width W5 of the light emitting region along the vertical central line A5 may be narrower than the width W6 of the light emitting region along the horizontal central line A6.

According to this embodiment, a region of a side surface of the third-1 semiconductor layer 1321 on which the third-1 metal layer 1361 is formed is placed farther outward than a region of a side surface of the second-1 semiconductor layer 1221 on which the second-1 metal layer 1261 is formed. The first-1 metal layer and the third-1 metal layer 1161, 1261, 1361 connected to each other by such a structure may be formed in a stepped structure.

Further, the second-1 metal layer 1261 contacts an upper surface of the first-1 metal layer 1161 disposed outside the first-1 opening 1151 in the first-1 metal layer 1161. That is, the second-1 metal layer 1261 contacts the upper surface of the first-1 metal layer 1161 disposed on the first insulating layer 1150. Further, the third-1 metal layer 1361 also contacts an upper surface of the second-1 metal layer 1261 disposed on the second insulating layer 1250.

A region of the upper surface of the first-1 metal layer 1161 disposed on the first-1 opening 1151 and a region of the upper surface of the second-1 metal layer 1261 disposed on the second-3 opening 1253 may be more concave or convex than other regions of the upper surfaces thereof by the openings 1151, 1253. Accordingly, for a stable process, the second-1 metal layer 1261 may be formed to contact a flat region of the upper surface of the first-1 metal layer 1161 and the third-1 metal layer 1361 may be formed to contact a flat region of the upper surface of the second-1 metal layer 1261. Thus, the second-1 metal layer 1261 may be partially formed on the first-1 metal layer 1161 disposed on the first insulating layer 1150 and the third-1 metal layer 1361 may be partially formed on the second-1 metal layer 1261 disposed on the second insulating layer 1250.

Referring to FIG. 4, the first-2 metal layer 1162 is formed on the first light emitting source 1100 to be electrically connected to the first-2 semiconductor layer 1123 of the first light emitting source 1100. Here, the first-2 metal layer 1162 is electrically connected to the first-2 semiconductor layer 1123 through a first ohmic electrode 1130 formed on the first-2 semiconductor layer 1123. In addition, the first-2 metal layer 1162 may be electrically connected to the second-2 metal layer 1262 formed on the second light emitting source 1200. Further, the second-2 metal layer 1262 may be electrically connected to the third-2 metal layer 1362 formed on the third light emitting source 1300. As such, the first-2 metal layer 1162, the second-2 metal layer 1262, and the third-1 metal layer 1361 may act as a first electrode electrically connected to the first-2 semiconductor layer 1123, which is a p-type semiconductor layer of the first light emitting source 1100. The first electrode may be a p-type electrode of the first light emitting source 1100.

According to this embodiment, the first-2 to third-2 metal layers 1162, 1262, 1362 may also be formed in a stepped structure in which a region of a side surface of the third-2 semiconductor layer 1323 is disposed farther outward than a region of a side surface of the second-2 semiconductor layer 1223.

A region of an upper surface of the first-2 metal layer 1162 disposed on the first-2 opening 1152 may be more concave or convex than other regions of the upper surface thereof by the first-2 opening 1152. Accordingly, for a stable process, the second-2 metal layer 1262 may be formed to contact a flat region of the upper surface of the first-2 metal layer 1162 disposed on the first insulating layer 1150. Further, the third-2 metal layer 1362 may be formed to contact a flat region of the upper surface of the second-2 metal layer 1262 disposed on the second insulating layer 1250.

Referring to FIG. 3, the second-3 metal layer 1263 is formed on the second light emitting source 1200 to be electrically connected to the second-2 semiconductor layer 1223 of the second light emitting source 1200. Here, the second-3 metal layer 1263 may be electrically connected to the second-2 semiconductor layer 1223 through a second ohmic electrode 1230 formed on the second-2 semiconductor layer 1223. Further, the second-3 metal layer 1263 may be electrically connected to the third-3 metal layer 1363 formed on the third light emitting source 1300. As such, the second-3 metal layer 1263 and the third-3 metal layer 1363 may act as a second electrode electrically connected to the second-2 semiconductor layer 1223, which is a p-type semiconductor layer of the second light emitting source 1200. The second electrode may be a p-type electrode of the second light emitting source 1200.

According to this embodiment, the second-3 metal layer 1263 and the third-3 metal layer 1363 may be formed in a stepped structure.

A region of an upper surface of the second-3 metal layer 1263 disposed on the second-4 opening 1254 may be more concave or convex than other regions of the upper surface thereof by the second-4 opening 1254. Accordingly, for a stable process, the third-3 metal layer 1363 may be formed to contact a flat region of the upper surface of the second-3 metal layer 1263 disposed on the second insulating layer 1250.

Referring to FIG. 4, the third-4 metal layer 1364 may be formed on the third light emitting source 1300 to be electrically connected to the third-2 semiconductor layer 1323. Here, the third-4 metal layer 1364 may be electrically connected to the third-2 semiconductor layer 1323 through a third ohmic electrode 1330 formed on the third-2 semiconductor layer 1323. That is, the third-4 metal layer 1364 may act as a third electrode electrically connected to the third-2 semiconductor layer 1323, which is a p-type semiconductor layer of the third light emitting source 1300. The third electrode may be a p-type electrode of the third light emitting source 1300.

A region of an upper surface of the third-4 metal layer 1364 disposed on the third-5 opening 1355 may be more concave or convex than other regions thereof by the third-5 opening 1355.

According to an embodiment, the upper surface of the metal layer 1060 may have a variable height. That is, the upper surface of the metal layer 1060 may have different heights on the openings 1059 and on other regions. Furthermore, some regions of the upper surfaces of the metal layers 1060 disposed on the openings 1059 may be concave or convex and other regions of the upper surface of the metal layer 1060 may be relatively flat. According to this embodiment, the metal layers 1060 may be electrically connected in a flat region of the upper surface thereof.

Referring to FIG. 3 and FIG. 4, the metal layers 1060 formed on the openings 1059 of the transparent layer 1070 cover inner walls and bottom surfaces of the openings 1059. For example, when the metal layers 1060 are formed by a deposition process, the metal layers 1060 may cover the inner walls and the bottom surfaces of the openings 1059 along the openings 1059. Here, the bottom surfaces of the openings 1059 may be upper surfaces of the metal layers 1060 placed at the bottom of the openings 1059 and exposed outside.

For example, referring to FIG. 4, the third-2 metal layer 1362 formed in the third-2 opening 1352 of the second transparent layer 1270 may be formed along an inner wall and a bottom surface of the third-2 opening 1352. Here, the bottom surface of the third-2 opening 1352 corresponds to an exposed region of the upper surface of the second-2 metal layer 1262, which is exposed through the third-2 opening 1352.

Thus, the second-2 metal layer 1262 and the third-2 metal layer 1362 may be stacked on the second insulating layer 1250 disposed below the third-2 opening 1352, in which the third-2 metal layer 1362 is formed on the second-2 metal layer 1262. Similarly, the first-2 metal layer 1162 and the second-2 metal layer 1262 may be stacked on the first insulating layer 1150 disposed below the second-2 opening 1252.

In addition, referring to FIG. 3, the first-1 metal layer 1161 and the second-1 metal layer 1261 may be stacked on the first insulating layer 1150 disposed below the second-1 opening 1251. Further, the second-1 metal layer 1261 and the third-1 metal layer 1361 may be stacked on the second insulating layer 1250 disposed below the third-3 opening 1353. Further, the second-3 metal layer 1263 and the third-3 metal layer 1363 may be stacked on the second insulating layer 1250 disposed below the third-4 opening 1354.

As such, according to this embodiment, the metal layer 1060 placed at a lower side and the metal layer 1060 placed at an upper side are connected to each other on the insulating layer 1050. Therefore, when the openings 1059 are formed on the insulating layer 1050, the metal layers 1060 may be formed in a two-layer structure on the insulating layer 1050. Furthermore, a metal layer 1060 is formed in the opening 1059 placed on the insulating layer 1050.

Accordingly, a thickness W1 of the metal layer 1060 formed on the insulating layer 1050 is greater than a thickness W2 of the metal layer 1060 formed on the inner surface of the opening 1059. Here, the thickness of the metal layer 1060 formed on the insulating layer 1050 refers to a length from a bottom surface of the metal layer 1060 composed of two layers to an upper surface thereof. In addition, the thickness of the metal layer 1060 formed on the inner surface of the opening 1059 refers to a length from the inner surface of the opening 1059 to the inner surface of the metal layer 1060.

Since the pixel device 1000 according to this embodiment has a structure in which the metal layer 1059 formed on the opening 1060 covers the upper surface of the metal layer 1060 placed under the opening, reliability of electrical connection can be improved.

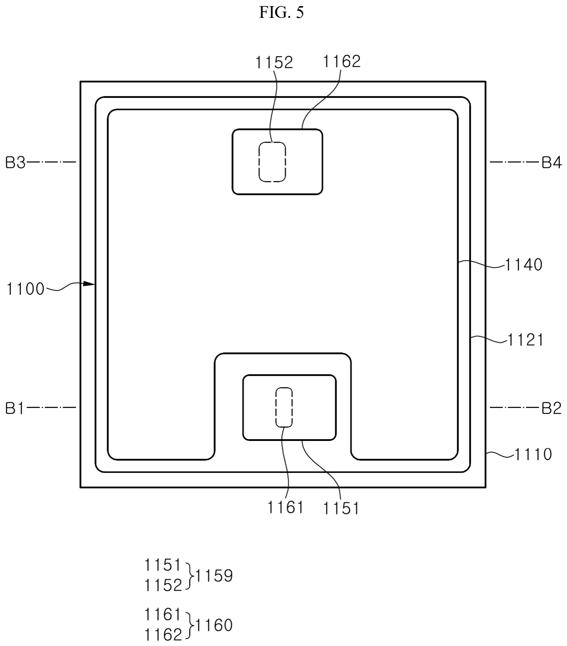

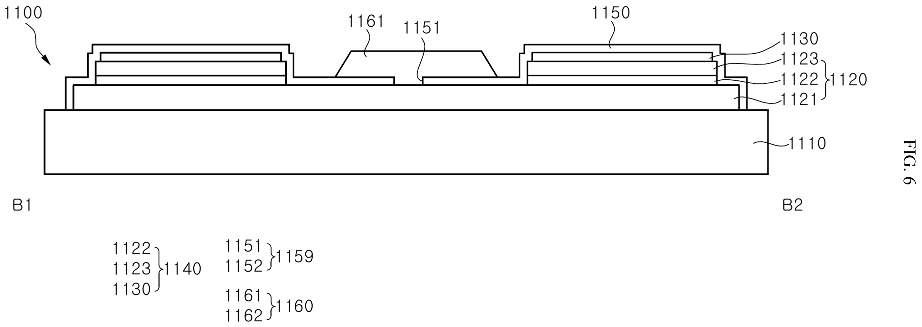

However, the structure of the metal layer 1060 of the pixel device 1000 according to this embodiment is not limited thereto. For example, the metal layer 1060 of the pixel device 1000 may be formed in various structures, as shown in FIG. 5 and FIG. 6.

FIG. 5 to FIG. 39 are views illustrating a method of manufacturing the pixel device according to the first embodiment of the present disclosure.

Referring to FIG. 5 to FIG. 13, the first to third light emitting sources 1100, 1200, 1300 may be formed separately.

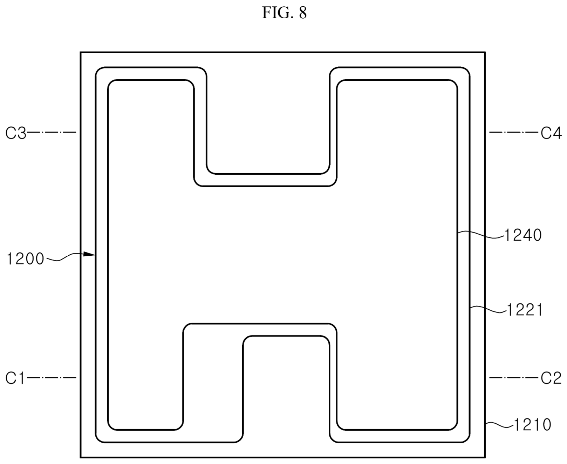

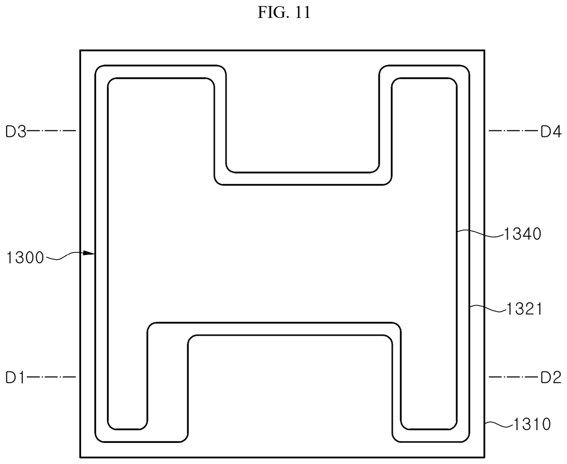

The first light emitting source 1100 shown in FIG. 5, the second light emitting source 1200 shown in FIG. 8, and the third light emitting source 1300 shown in FIG. 11 may generate and emit different colors of light. For example, the first light emitting source 1100 may generate and emit green light. The second light emitting source 1200 can generate and emit blue light. Further, the third light emitting source 1300 may generate and emit red light.

In addition, the first to third light emitting sources 1100, 1200, 1300 may operate individually. Here, the operation refers to a process of generating and emitting light.

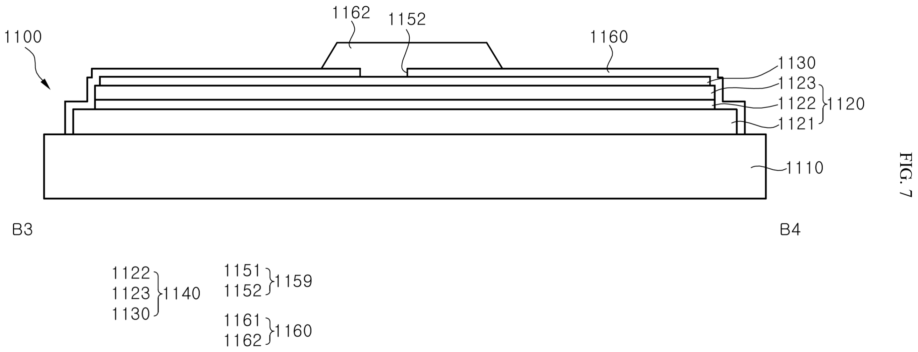

FIG. 5 is a schematic plan view of the first light emitting source 1100 of the pixel device 1000 according to the first embodiment of the present disclosure. FIG. 6 is a first cross-sectional view (B1-B2) of the first light emitting source 1100 of the pixel device 1000 according to the first embodiment of the present disclosure. Further, FIG. 7 is another cross-sectional view (B3-B4) of the first light emitting source 1100 of the pixel device 1000 according to the first embodiment of the present disclosure.

Referring to FIG. 5 to FIG. 7, the first light emitting source 1100 may be formed on the first base 1110. The first light emitting source 1100 may include a first light emitting structure 1120, the first ohmic electrode 1130, the first insulating layer 1150, and the first metal layers 1160.

According to this embodiment, the first base 1110 may serve as a growth substrate that allows growth of semiconductor layers thereon. For example, the first base 1110 may include sapphire. However, the first base 1110 is not limited to the growth substrate. The first base 1110 may also be formed of a light transmissive material, such as silicone, epoxy, and the like. For example, after the first light emitting source 1100 is formed on the growth substrate, the growth substrate may be removed and the first light emitting source 1100 may be disposed on the first base 1110 that is a light transmissive material.

The first light emitting structure 1120 may be formed on the first base 1110. The first light emitting structure 1120 may be grown on the first base 1110 through metal organic chemical vapor deposition (MOCVD) or molecular beam epitaxy (MBE). The second light emitting structure 1220 of the second light emitting source 1200 and the third light emitting structure 1320 of the third light emitting source 1300 described below may be formed in the same manner.

The first light emitting structure 1120 may include the first-1 semiconductor layer 1121, the first-2 semiconductor layer 1123, and the first active layer 1122 formed between the first-1 semiconductor layer 1121 and the first-2 semiconductor layer 1123.

The semiconductor layer 1121 may be an n-type conductive semiconductor layer and the first-2 semiconductor layer 1123 may be a p-type conductive semiconductor layer, or vice versa. Further, the first light emitting structure 1120 may generate and emit green light. That is, the first light emitting source 1100 may emit green light. For example, the first light emitting structure 1120 may include a semiconductor material that emits green light, such as GaN, InGaN, GaP, AlGaInP, AlGaP, and the like.

Referring to FIG. 6 and FIG. 7, the first active layer 1122 and the first-2 semiconductor layer 1123 may be partially etched to expose a region of an upper surface of the first-1 semiconductor layer 1121. Here, the first active layer 1122 and the first-2 semiconductor layer 1123 remaining on the first-1 semiconductor layer 1121 after the etching process may act as a first mesa structure 1140. Referring to FIG. 6, the first mesa structure 1140 may include a plurality of mesa structures.

Referring to FIG. 6 and FIG. 7, the first mesa structure 1140 has a structure in which side surfaces of the first mesa structure 1140 are perpendicular to the upper surface of the first-1 semiconductor layer 1121. However, it should be understood that the structure of the first mesa structure 1140 is not limited thereto. For example, the first mesa structure 1140 may have a structure in which a width and cross-sectional area of the first mesa structure 1140 gradually decreases from the first-1 semiconductor layer 1121 to the first-2 semiconductor layer 1123. That is, the first mesa structure 1140 may have a structure with inclined side surfaces. Not only the first mesa structure 1140 of the first light emitting source 1100, but also the first mesa structures 1140 of the second light emitting source 1200 and the third light emitting source 1300 described below may also be formed in the structure in which the side surfaces thereof are perpendicular or inclined relative to the upper surface of the first-1 semiconductor layer 1121.

Referring to FIG. 2 and FIG. 5, the first mesa structure 1140 of the first light emitting source 1100 may cover most of the upper surface of the first-1 semiconductor layer 1121 excluding a region in which the first-1 metal layer 1161 is formed and a peripheral region thereof. Thus, the first mesa structure 1140 of the first light emitting source 1100 may be formed to surround the side surfaces of the first-1 metal layer 1161 at a distance from the first-1 metal layer 1161. In addition, the first mesa structure 1140 of the first light emitting source 1100 may be formed such that the side surfaces of the first mesa structure 1140 are spaced apart from the side surfaces of the first-1 semiconductor layer 1121 while being placed inside the side surfaces of the first-1 semiconductor layer 1121.

The first ohmic electrode 1130 may be formed on the semiconductor layer 1123. In addition, the first ohmic electrode 1130 may cover an upper surface of the first-2 semiconductor layer 1123. The first ohmic electrode 1130 may cover a region of the upper surface of the first-2 semiconductor layer 1123. Alternatively, the first ohmic electrode 1130 may cover the entirety of the upper surface of the first-2 semiconductor layer 1123.

The first ohmic electrode 1130 can have high transmittance and high electrical conductivity with respect to light emitted from the first light emitting structure 1120. For example, the first ohmic electrode 1130 may be a transparent electrode. Furthermore, the first ohmic electrode 1130 may be formed of indium tin oxide (ITO). In this embodiment, the first mesa structure 1140 may include not only the first active layer 1122 and the first-2 semiconductor layer 1123, but also the first ohmic electrode 1130 disposed on the first-2 semiconductor layer 1123.

The first insulating layer 1150 may cover the first light emitting structure 1120 and the first ohmic electrode 1130. In addition, the first insulating layer 1150 may include a first-1 opening 1151 and a first-2 opening 1152.

The first-1 opening 1151 of the first insulating layer 1150 is an opening 1059 that exposes the first-1 semiconductor layer 1121. Thus, the first-1 opening 1151 may be disposed on the first-1 semiconductor layer 1121 between the first mesa structures 1140.

The first-2 opening 1152 of the first insulating layer 1150 is an opening 1059 that exposes the first ohmic electrode 1130. Thus, the first-2 opening 1152 may be disposed on the first mesa structure 1140. That is, the first-2 opening 1152 may be disposed on the first ohmic electrode 1130 that covers the first-2 semiconductor layer 1123.

The first insulating layer 1150 may be formed of a light transmissive material. For example, the first insulating layer 1150 may be formed of a silicon oxide, such as SiO₂, a silicon nitride, such as Si₃N₄, or a silicon oxynitride.

The first metal layers 1160 may be formed on the first insulating layer 1150. The first metal layers 1160 may be formed of a conductive material and may be electrically connected to the first light emitting structure 1120. For example, the first metal layers 1160 may be formed of at least a metal. Further, the first metal layers 1160 may be formed as a single layer or multiple layers.

The first metal layers 1160 may include a first-1 metal layer 1161 and a first-2 metal layer 1162.

The metal layer 1161 may be formed to fill the first-1 opening 1151 of the first insulating layer 1150 between the first mesa structures 1140. In addition, the first-1 metal layer 1161 may cover a region of the first insulating layer 1150 around the first-1 opening 1151. That is, a width and cross-sectional area of the first-1 metal layer 1161 may be greater than a diameter and cross-sectional area of the first-1 opening 1151 of the first insulating layer 1150.

The metal layer 1162 may be formed on the first mesa structure 1140 to fill the first-2 opening of the first insulating layer 1150. In addition, the first-2 metal layer 1162 may cover a region of the first insulating layer 1150 around the first-2 opening 1152. That is, a width and cross-sectional area of the first-2 metal layer 1162 may be greater than a diameter and cross-sectional area of the first-2 opening 1152 of the first insulating layer 1150.

As such, the first-1 metal layer 1161 may be electrically connected to the first-1 semiconductor layer 1121 through the first-1 opening 1151 of the first insulating layer 1150. In addition, the first-2 metal layer 1162 may be electrically connected to the first ohmic electrode 1130 through the first-2 opening 1152 of the first insulating layer 1150. Further, the first-2 metal layer 1162 may be electrically connected to the first-2 semiconductor layer 1123 through the first ohmic electrode 1130.

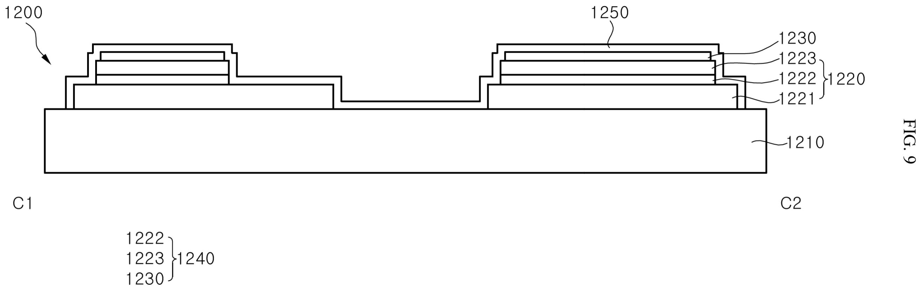

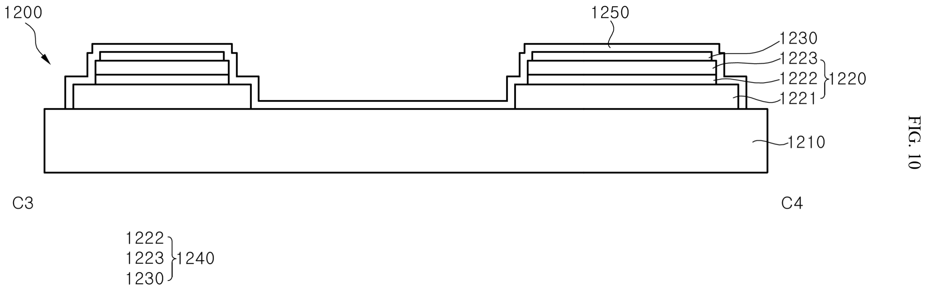

FIG. 8 is a schematic plan view of the second light emitting source 1200 of the pixel device 1000 according to the first embodiment of the present disclosure. Further, FIG. 9 is a cross-sectional view (C1-C2) of the second light emitting source 1200 of the pixel device 1000 according to the first embodiment of the present disclosure. Further, FIG. 10 is another cross-sectional view (C3-C4) of the second light emitting source 1200 of the pixel device 1000 according to the first embodiment of the present disclosure.

Referring to FIG. 8 to FIG. 10, the second light emitting source 1200 may be formed on a second base 1210. The second light emitting source 1200 may include the second light emitting structure 1220, the second ohmic electrode 1230, and the second insulating layer 1250.

According to the embodiment, the second base 1210 may serve as a growth substrate that allows growth of semiconductor layers thereon. For example, the second base 1210 may include sapphire.

The second light emitting structure 1220 may be formed on the second base 1210. The second light emitting structure 1220 may include the second-1 semiconductor layer 1221, the second-2 semiconductor layer 1223, and the second active layer 1222 formed between the second-1 semiconductor layer 1221 and the second-2 semiconductor layer 1223. The second light emitting structure 1220 may be formed in the same manner as the first light emitting structure 1120.

The second-1 semiconductor layer 1221 may be an n-type conductive semiconductor layer and the second-2 semiconductor layer 1223 may be a p-type conductive semiconductor layer, or vice versa. The second light emitting structure 1220 may generate and emit blue light. Accordingly, the second light emitting source 1200 may emit blue light. For example, the second light emitting structure 1220 may include a semiconductor material that emits blue light, such as GaN, InGaN, ZnSe, or the like.

Referring to FIG. 9 and FIG. 10, the second active layer 1222 and the second-2 semiconductor layer 1223 may be partially etched to expose a region of an upper surface of the second-1 semiconductor layer 1221. Here, the second active layer 1222 and the second-2 semiconductor layer 1223 remaining on the second-1 semiconductor layer 1221 after the etching process may act as a second mesa structure 1240. The second light emitting source 1200 may include a plurality of second mesa structures 1240.

The second ohmic electrode 1230 may be formed on the second-2 semiconductor layer 1223. Further, the second ohmic electrode 1230 may cover an upper surface of the second-2 semiconductor layer 1223. The second ohmic electrode 1230 may cover a region of the upper surface of the second-2 semiconductor layer 1223 or the entirety of the upper surface thereof.

Referring to FIG. 2 and FIG. 8, the second-1 semiconductor layer 1221 of the second light emitting source 1200 may be formed so as not to overlap the openings 1059 of the first light emitting source 1100 when the second light emitting source 1200 is stacked on the first light emitting source 1100.

In addition, the second mesa structure 1240 of the second light emitting source 1200 may be formed so as not to overlap the first metal layers 1160 when the second light emitting source 1200 is stacked on the first light emitting source 1100. Thus, the second mesa structure 1240 may be formed in a region other than a region in which the first-1 metal layer 1161 and the first-2 metal layer 1162 are placed at a lower side, as shown in FIG. 2 and FIG. 8.

The ohmic electrode 1230 can have high transmittance and high electrical conductivity with respect to light emitted from the second light emitting structure 1220. For example, the second ohmic electrode 1230 may be a transparent electrode. Furthermore, the second ohmic electrode 1230 may be formed of indium tin oxide (ITO). The second mesa structure 1240 of the second light emitting source 1200 may also include the second ohmic electrode 1230 formed on the second-2 semiconductor layer 1223.

The insulating layer 1250 may cover the second light emitting structure 1220 and the second ohmic electrode 1230. In addition, the second insulating layer 1250 may cover an upper surface of the second base 1210 placed between the mesas.

The insulating layer 1250 may be formed of a light transmissive material. For example, the second insulating layer 1250 may be formed of a silicon oxide, such as SiO₂, a silicon nitride, such as Si₃N₄, or a silicon oxynitride.

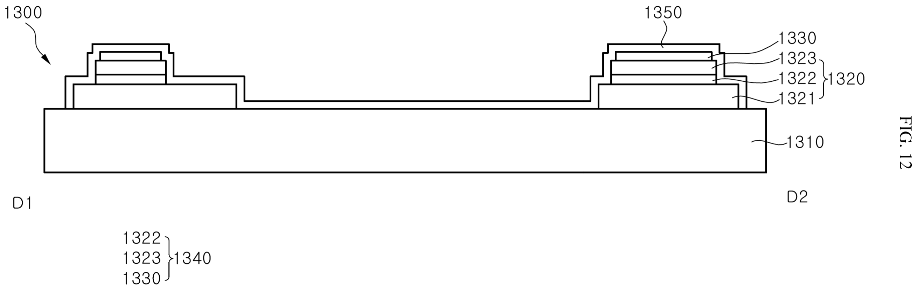

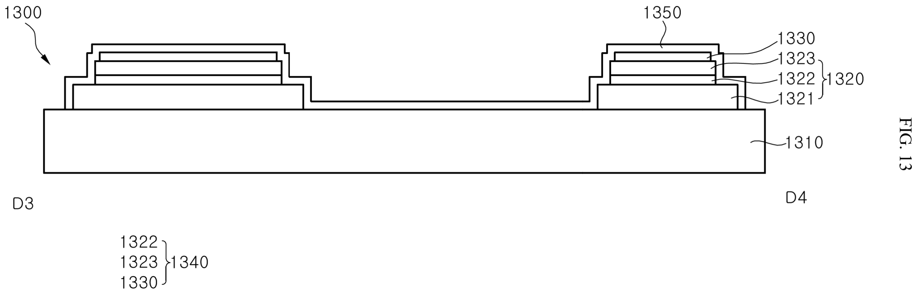

FIG. 11 is a schematic plan view of the third light emitting source 1300 of the pixel device 1000 according to the first embodiment of the present disclosure. FIG. 12 is a cross-sectional view (D1-D2) of the third light emitting source 1300 of the pixel device 1000 according to the first embodiment of the present disclosure. Further, FIG. 13 is another cross-sectional view (D3-D4) of the third light emitting source 1300 of the pixel device 1000 according to the first embodiment of the present disclosure.

Referring to FIG. 11 to FIG. 13, the third light emitting source 1300 may be formed on a third base 1310. The third light emitting source 1300 may include the third light emitting structure 1320, the third ohmic electrode 1330, and the third insulating layer 1350.

According to the embodiment, the third base 1310 may serve as a growth substrate that allows growth of semiconductor layers thereof. For example, the third base 1310 may include sapphire.

The third light emitting structure 1320 may be formed on the third base 1310. The third light emitting structure 1320 may include the third-1 semiconductor layer 1321, the third-2 semiconductor layer 1323, and the third active layer 1322 formed between the third-1 semiconductor layer 1321 and the third-2 semiconductor layer 1323. The third light emitting structure 1320 may be formed in the same manner as the first light emitting structure 1120.

The third-1 semiconductor layer 1321 may be an n-type conductive semiconductor layer and the third-2 semiconductor layer 1323 may be a p-type conductive semiconductor layer, or vice versa. The third light emitting structure 1320 may generate and emit red light. Accordingly, the third light emitting source 1300 may also emit red light. For example, the third light emitting structure 1320 may include a semiconductor material that emits red light, such as AlGaAs, GaAsP, AlGaInP, GaP, or the like.

Referring to FIG. 2 to FIG. 11, the third-1 semiconductor layer 1321 of the third light emitting source 1300 may be formed so as not to overlap the openings 1059 of the first light emitting source 1100 and the second light emitting source 1200 when the third light emitting source 1300 is stacked on the second light emitting source 1200.

In addition, the third mesa structure 1340 of the third light emitting source 1300 may be formed so as not to overlap the first metal layers 1160 of the first light emitting source 1100 and the second metal layers 1260 of the second light emitting source 1200.

Referring to FIG. 12 and FIG. 13, the third active layer 1322 and the third-2 semiconductor layer 1323 may be partially etched to expose a region of the upper surface of the third-1 semiconductor layer 1321. Here, the third active layer 1322 and the third-2 semiconductor layer 1323 remaining on the third-1 semiconductor layer 1321 after the etching process may act as the third mesa structure 1340. Referring to FIG. 12, the third light emitting source 1300 may include a plurality of third mesa structures 1340.

The third ohmic electrode 1330 may be formed on the third-2 semiconductor layer 1323. In addition, the third ohmic electrode 1330 may cover an upper surface of the third-2 semiconductor layer 1323. The third ohmic electrode 1330 may cover a region of the upper surface of the third-2 semiconductor layer 1323 or the entirety of the upper surface thereof.

The third ohmic electrode 1330 may have high electrical conductivity with respect to light emitted from the third light emitting structure 1320. For example, the third ohmic electrode 1330 may be formed of a metal. In addition, the third ohmic electrode 1330 may have high transmittance for light. For example, the third ohmic electrode 1330 may be a transparent electrode. Furthermore, the third ohmic electrode 1330 may be formed of indium tin oxide (ITO).

The third insulating layer 1350 may cover the third light emitting structure 1320 and the third ohmic electrode 1330. Further, the third insulating layer 1350 may cover an upper surface of the third base 1310 placed between the mesas.

The third insulating layer 1350 may be formed of a light transmissive material. For example, the third insulating layer 1350 may be formed of a silicon oxide, such as SiO₂, a silicon nitride, such as Si₃N₄, or a silicon oxynitride.

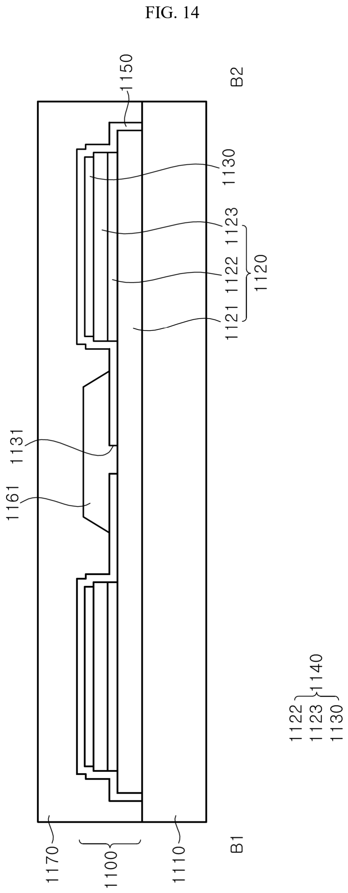

Referring to FIG. 14 to FIG. 26, the second light emitting source 1200 may be stacked on the first light emitting source 1100.

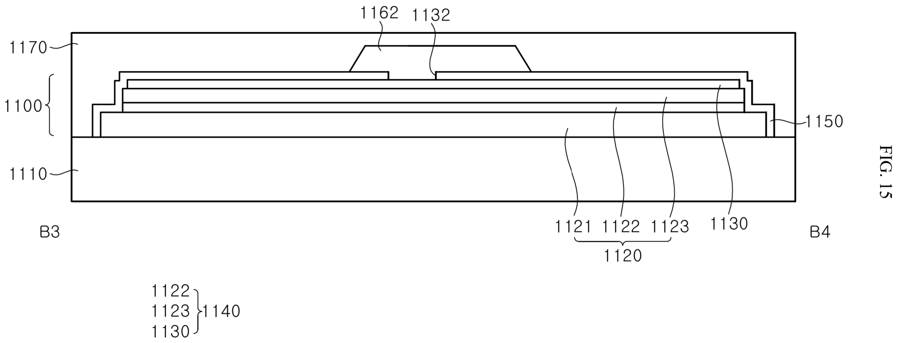

Referring to FIG. 14 and FIG. 15, the first transparent layer 1170 may be formed on the first light emitting source 1100.

The first transparent layer 1170 may cover the first light emitting source 1100 on the first base 1110. Here, the first transparent layer 1170 may include a flat upper surface.

The first transparent layer 1170 may be formed of an insulating light-transmissive material. For example, the first transparent layer 1170 may be formed of the same material as the first insulating layer 1150.

In this embodiment, the first transparent layer 1170 is formed separately after formation of the first light emitting source 1100, without being limited thereto. That is, the first transparent layer 1170 may be included in the first light emitting source 1100.

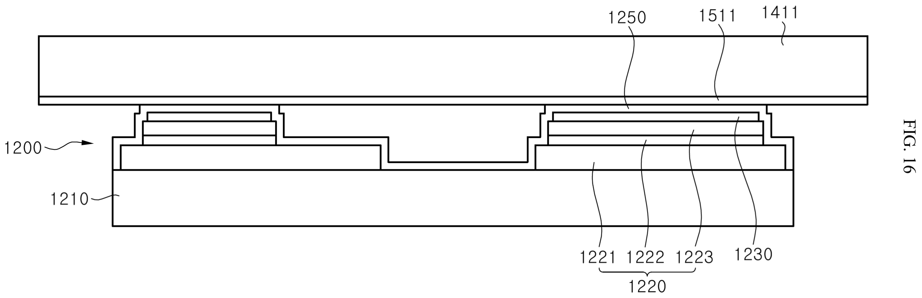

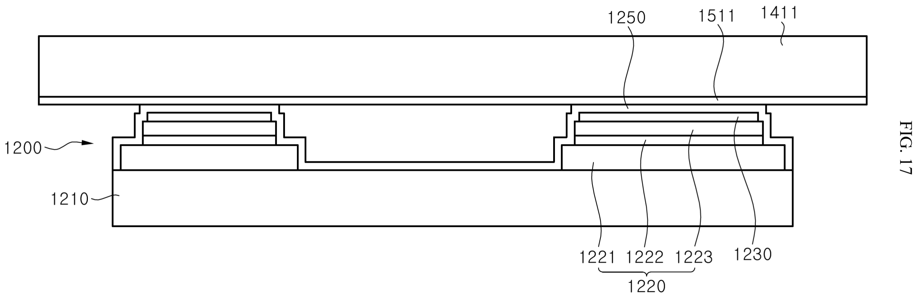

Referring to FIG. 16 and FIG. 17, a first support substrate 1411 may be attached to an upper side of the second light emitting source 1200. The first support substrate 1411 may include any structure capable of supporting the second light emitting source 1200 until the second light emitting source 1200 is stacked on the first light emitting source 1100. That is, the second light emitting source 1200 may be stacked on the first light emitting source 1100 in a state of being attached to the first support substrate 1411. For example, the first support substrate 1411 may be a sapphire substrate or a glass substrate, without being limited thereto.

In addition, the second light emitting source 1200 may be attached to the first support substrate 1411 using an adhesive tape 1511. The adhesive tape 1511 may be formed of a material exhibiting adhesive strength that can reduced by heat or ultraviolet light.

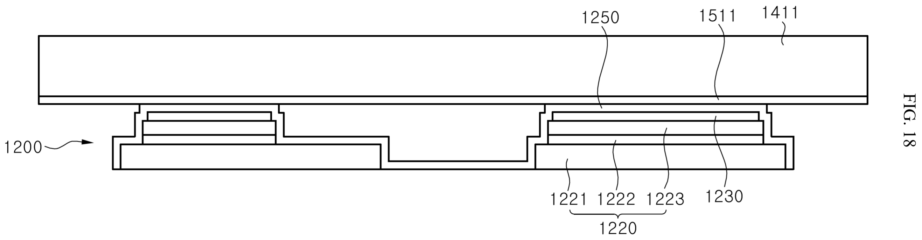

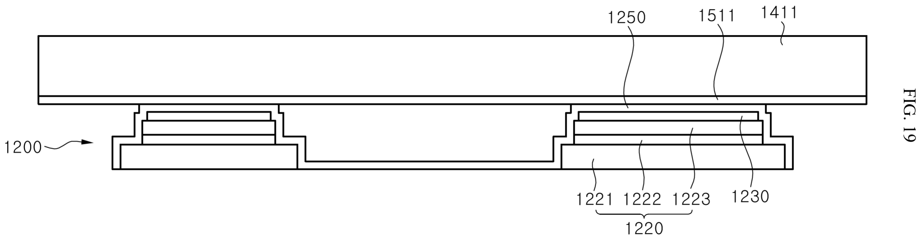

Referring to FIG. 18 and FIG. 19, the second base 1210 is removed from a lower side of the second light emitting source 1200. For example, the second base 1210 may be removed by laser lift-off, chemical lift-off, or wet etching.

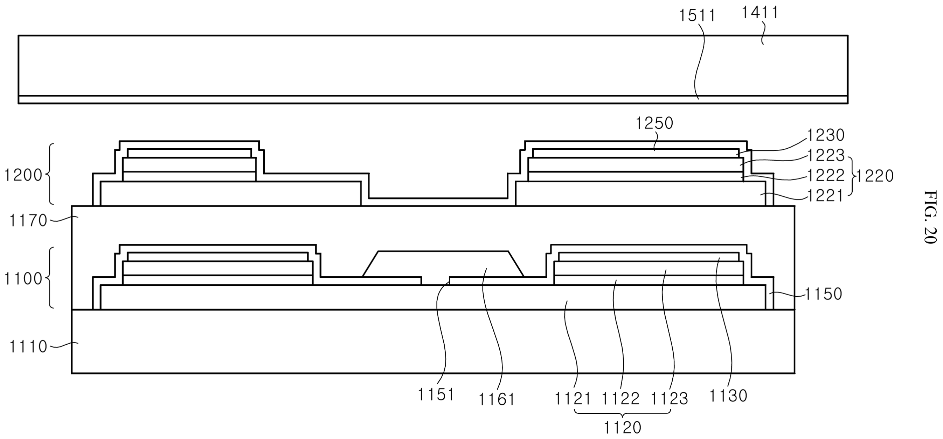

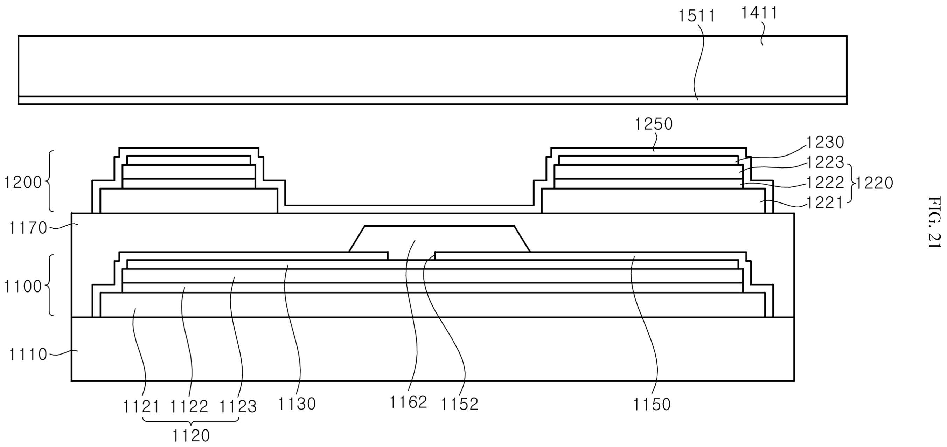

Referring to FIG. 20 and FIG. 21, the second light emitting source 1200 may be stacked on the first light emitting source 1100. The second light emitting source 1200 may be stacked on the first transparent layer 1170 of the first light emitting source 1100. Thus, the second-1 semiconductor layer 1221 of the second light emitting source 1200 may be disposed on the first transparent layer 1170 of the first light emitting source 1100.

After the second light emitting source 1200 is stacked on the first light emitting source 1100, the first support substrate 1411 is removed. For example, heat, ultraviolet light, or infrared light may be utilized to reduce adhesive strength of the adhesive tape 1511 to peel the first support substrate 1411 off of the second light emitting source 1200.

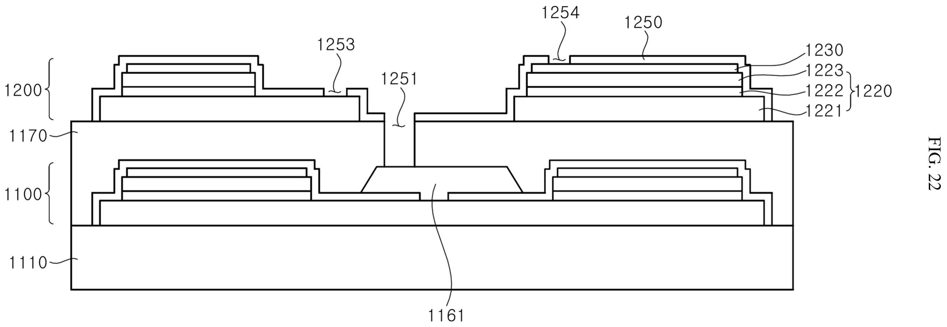

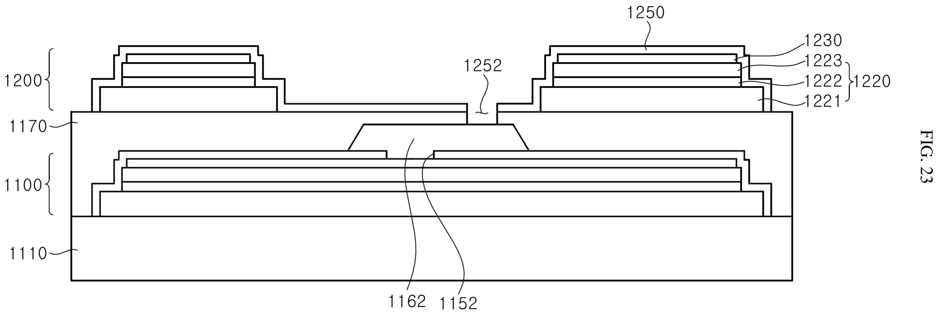

Referring to FIG. 22 and FIG. 23, the second insulating layer 1250 and the first transparent layer 1170 may be patterned. The second openings 1259 may be formed in the second insulating layer 1250 and the first transparent layer 1170. The second openings 1259 may include second-1 to second-4 openings 1251, 1252, 1253, 1254.

Referring to FIG. 22, the second-1 opening 1251 may be formed on the first-1 metal layer 1161. That is, the second-1 opening 1251 may be formed in the second insulating layer 1250 and the first transparent layer 1170 covering the first-1 metal layer 1161 to partially expose the first-1 metal layer 1161.

The second-3 opening 1253 may be formed in the second insulating layer 1250 covering the second-1 semiconductor layer 1221 to partially expose the second-1 semiconductor layer 1221. Here, the second-3 opening 1253 may be formed around the first-1 metal layer 1161 and the second-1 opening 1251.

The second-4 opening 1254 may be formed in the second insulating layer 1250 covering the second-2 semiconductor layer 1223 to partially expose the second-2 semiconductor layer 1223.

Referring to FIG. 23, the second-2 opening 1252 may be formed on the first-2 metal layer 1162. That is, the second-2 opening 1252 may be formed in the second insulating layer 1250 and the first transparent layer 1170 covering the first-2 metal layer 1162 to partially expose the first-2 metal layer 1162.

As such, the second opening 1259 according to this embodiment may be formed by patterning the second insulating layer 1250 or the second insulating layer 1250 and the first transparent layer 1170. Since the second insulating layer 1250 and the first transparent layer 1170 are formed of the same material, a plurality of second openings 1259 may be simultaneously formed through the same process. For example, the second openings 1259 may be formed by dry etching, such as plasma etching or laser etching.

According to this embodiment, the second insulating layer 1250 or the second insulating layer 1250 and the first transparent layer 1170 are formed on all of the first metal layers 1160 and the second-1 semiconductor layer 1221 and the second ohmic electrode 1230 of the second light emitting source 1200. Thus, the second openings 1259 exposing the first metal layers 1160, the second-1 semiconductor layer 1221, and the second ohmic electrode 1230 may be simultaneously formed through a single process.

If a material, such as the metal layers 1060, other than the first insulating layer 1150 and the first transparent layer 1170, is formed on the first metal layers 1160, the second-1 semiconductor layer 1221, and the second ohmic electrode 1230, it is difficult to remove a plurality of layers composed of different materials at the same time. Accordingly, in this case, each layer must be removed separately to form the openings 1059.

However, since the pixel device 1000 according to this embodiment includes only layers composed of the same material on the first metal layers 1160 and the second-1 semiconductor layer 1221 and the second ohmic electrode 1230 of the second light emitting source 1200, the second openings 1259 may be formed simultaneously through a single process. Thus, time and costs for the process can be reduced through simplification of the process.

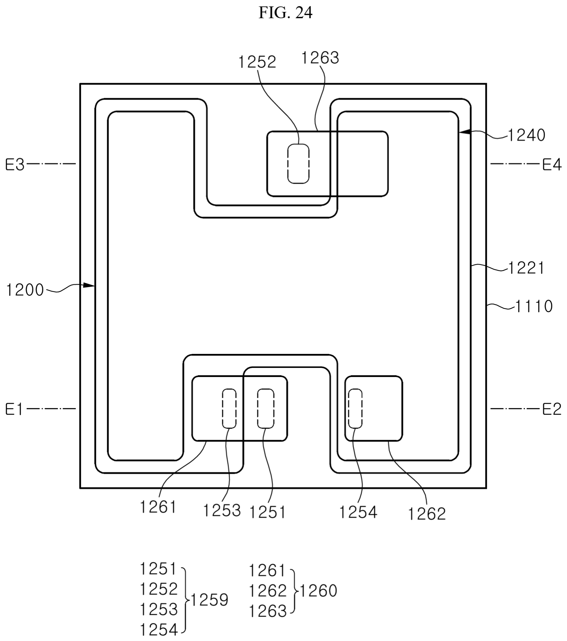

Referring to FIG. 24 to FIG. 26, the second metal layers 1260 may be formed.

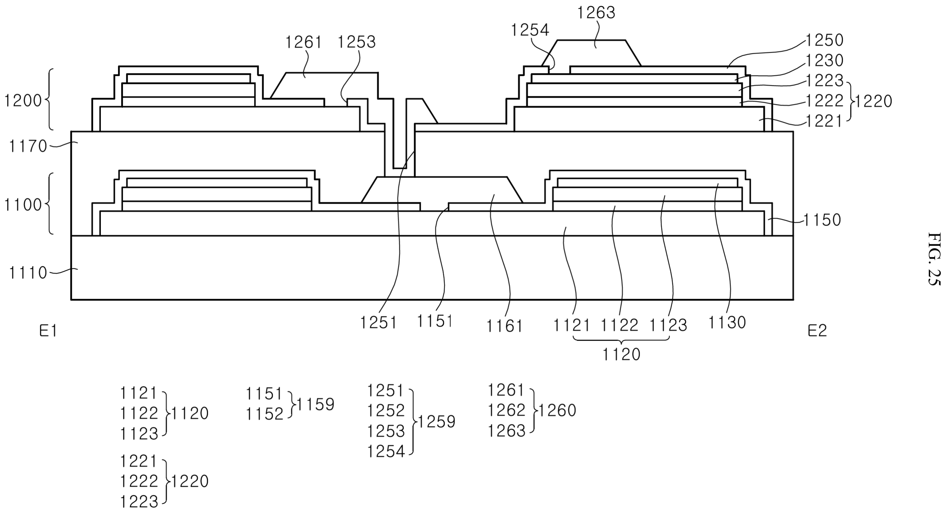

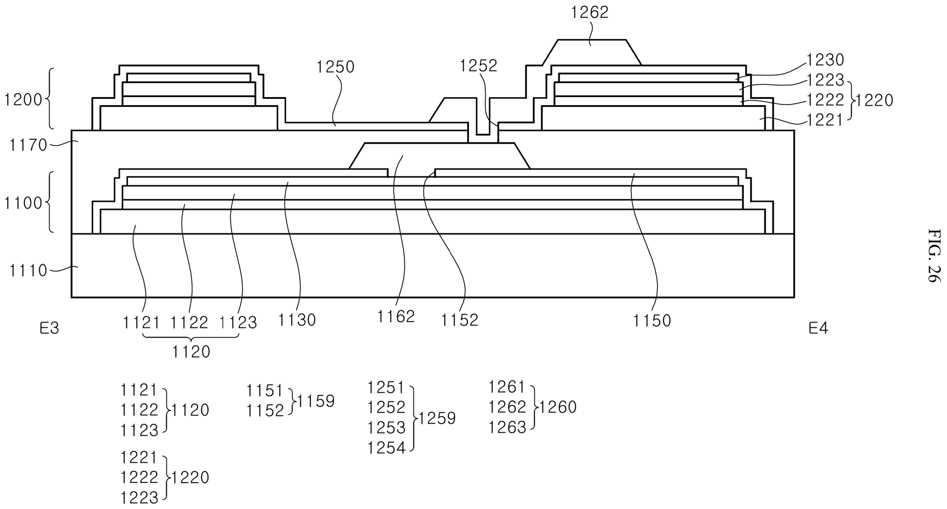

FIG. 24 is a plan view of a stack of the first light emitting source 1100 and the second light emitting source 1200 in which the second metal layers 1260 are formed. FIG. 25 is a cross-sectional view taken along line E1-E2 of FIG. 24. Further, FIG. 26 is another cross-sectional view taken along line E3-E4 of FIG. 24.

The second metal layers 1260 may include a second-1 metal layer 1261, a second-2 metal layer 1262, and a second-3 metal layer 1263.

Referring to FIG. 25, the second-1 metal layer 1261 may be formed to simultaneously fill the second-1 opening 1251 and the second-3 opening 1253. The second-1 metal layer 1261 may contact the first-1 metal layer 1161 through the second-1 opening 1251 to be electrically connected thereto. In addition, the second-1 metal layer 1261 may be electrically connected to the second-1 semiconductor layer 1221 of the second light emitting source 1200 through the second-3 opening 1253.

Further, the second-1 metal layer 1261 may cover an upper surface of the second insulating layer 1250 around the second-1 opening 1251. Furthermore, the second-1 metal layer 1261 may cover the upper surface of the second insulating layer 1250 around the second-3 opening 1253. That is, the second-1 metal layer 1261 may be formed to fill the second-1 opening 1251 and the second-3 opening 1253 while covering peripheral regions thereof.

Further, the second-1 metal layer 1261 may extend from an upper surface of the first-1 metal layer 1161 to an upper surface of the second-1 semiconductor layer 1221 of the second light emitting source 1200 along the second insulating layer 1250.

As such, a region of the second-1 metal layer 1261 is connected to the first-1 metal layer 1161 and another region thereof is also electrically connected to the second-1 semiconductor layer 1221 of the second light emitting source 1200. Accordingly, the first-1 semiconductor layer 1121 of the first light emitting source 1100 and the first-1 semiconductor layer 1121 of the second light emitting source 1200 may be electrically connected to each other through the second-1 metal layer 1261.

The second-3 metal layer 1263 may be formed to fill the second-4 opening 1254. Thus, the second-3 metal layer 1263 may be electrically connected to the second ohmic electrode 1230 through the second-4 opening 1254. Further, the second-3 metal layer 1263 may be electrically connected to the second ohmic electrode 1230 to be electrically connected to the second-2 semiconductor layer 1223 of the second light emitting source 1200. Here, the second-3 metal layer 1263 may cover the upper surface of the second insulating layer 1250 around the second-4 opening 1254. Thus, a width and cross-sectional area of the second-3 metal layer 1263 is greater than a width and cross-sectional area of the second-4 opening 1254.

Referring to FIG. 26, the second-2 metal layer 1262 may be formed to partially fill the second-2 opening 1252. Thus, the second-2 metal layer 1262 may be electrically connected to the first-2 metal layer 1162 through the second-2 opening 1252. Here, the second-2 metal layer 1262 may further cover the insulating layer 1050 around the second-2 opening 1252. In addition, another region of the second-2 metal layer 1262 may be formed on the second light emitting source 1200. More specifically, the other region of the second-2 metal layer 1262 may cover a region of the second insulating layer 1250 on the second ohmic electrode 1230.

In addition, the second-2 metal layer 1262 may extend from an upper surface of the first-2 metal layer 1162 to an upper surface of the second ohmic electrode 1230 along the second insulating layer 1250.

According to an embodiment of the present disclosure, the second metal layers 1260 may be formed by plating or deposition.

In addition, the second-1 opening 1251 may be formed outside the first-1 opening 1151. Thus, the second-1 metal layer 1261 may contact the upper surface of the first-1 metal layer 1161 placed outside the first-1 opening 1151. That is, the second-1 metal layer 1261 may be formed on a flat upper surface of the first-1 metal layer 1161 placed outside the first-1 opening 1151.

When the first-1 metal layer 1161 is formed, the upper surface of the first-1 metal layer 1161 filling the first-1 opening 1151 can become uneven due to a step between the first insulating layer 1150 and the first-1 opening 1151, as compared with other regions of the first-1 metal layer 1161. For example, the upper surface of the first-1 metal layer 1161 disposed on the first-1 opening 1151 may be concave. In addition, when the first-1 metal layer 1161 excessively fills the first-1 opening 1151 or when the first-1 metal layer 1161 is stacked only on the first-1 opening 1151 without filling the first-1 opening 1151 due to a narrow width of the first-1 opening 1151, the upper surface of the first-1 metal layer 1161 on the first-1 opening 1151 may be convex. As such, for various reasons, the upper surface of the first-1 metal layer 1161 on the first-1 opening 1151 may be concave or convex and is thus not flat. As such, when the second metal layers 1260 are formed on an uneven surface, various products can exhibit different performance for electrical connection between the first-1 metal layer 1161 and the second-1 metal layer 1261. For example, various products can have different bonding areas between the first-1 metal layer 1161 and the second-1 metal layer 1261. In addition, bonding between the first-1 metal layer 1161 and the second-1 metal layer 1261 can become unstable. That is, maintaining uniform product quality is difficult.

However, in the pixel device 1000 according to the first embodiment, the second-1 metal layer 1261 is formed in a flat region of the first-1 metal layer 1161 disposed on the first insulating layer 1150. Accordingly, since stable bonding between the first-1 metal layer 1161 and the second-1 metal layer 1261 is possible, it is possible to achieve mass production of products having the same level of quality. Furthermore, not only the second-1 metal layer 1261, but also all of the second metal layers 1260 connected to the first metal layers 1160 may be formed on the flat upper surface of the first metal layers 1160.

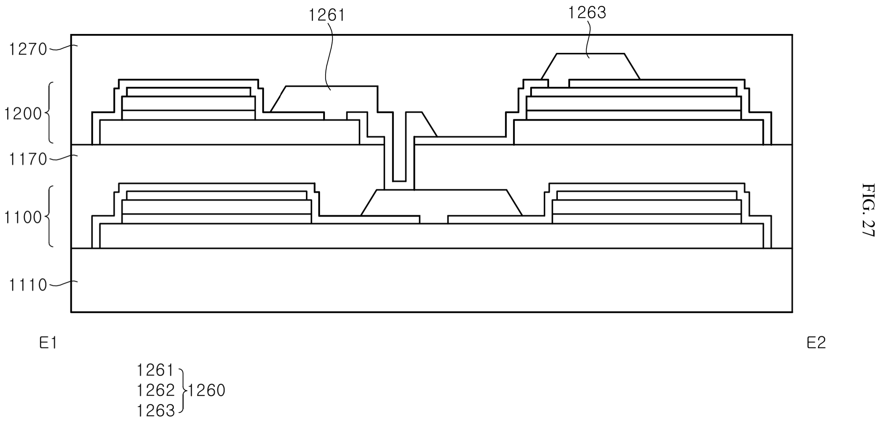

Referring to FIG. 27 to FIG. 39, the third light emitting source 1300 may be stacked on the second light emitting source 1200.

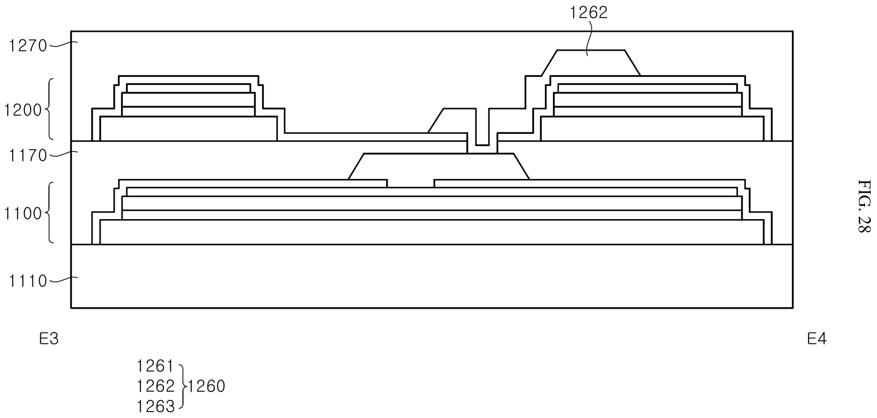

Referring to FIG. 27 and FIG. 28, the second transparent layer 1270 may be formed on the first transparent layer 1170. The second transparent layer 1270 may cover the second light emitting source 1200 and the second metal layers 1260 on the first transparent layer 1170. Here, the second transparent layer 1270 may include a flat upper surface.

The second transparent layer 1270 may be formed of an insulating light transmissive material. For example, the second transparent layer 1270 may be formed of polyimide (PI) or epoxy molding compound (EMC). Alternatively, the second transparent layer 1270 may be formed of the same material as the second insulating layer 1250.

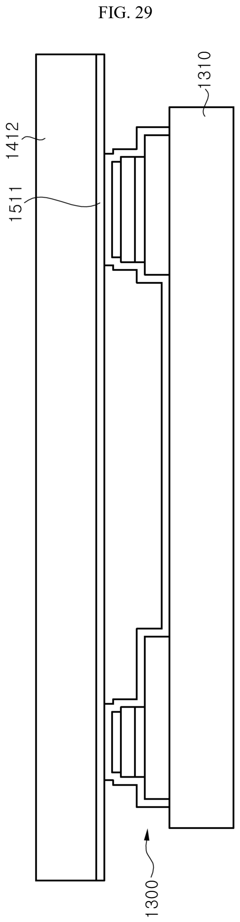

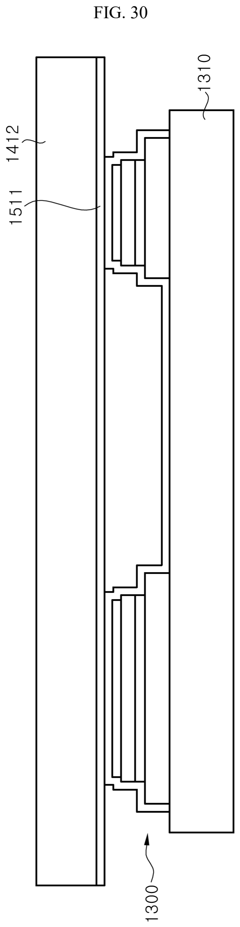

Referring to FIG. 29 and FIG. 30, a second support substrate 1412 may be attached to an upper side of the third light emitting source 1300. The third light emitting source 1300 may be stacked on the second light emitting source 1200 in a state of being attached to the second support substrate 1412. For example, the second support substrate 1412 may be a sapphire substrate or a glass substrate, without being limited thereto. That is, the second support substrate 1412 may include any structure capable of supporting the third light emitting source 1300 until the third light emitting source 1300 is stacked on the second light emitting source 1200.

In addition, the third light emitting source 1300 may be attached to the second support substrate 1412 using an adhesive tape 1511. The adhesive tape 1511 may be made of a material exhibiting adhesive strength that can be reduced by heat or ultraviolet light.

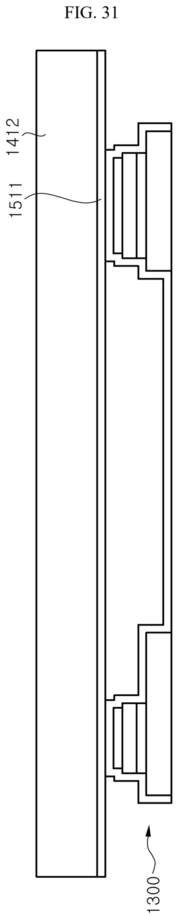

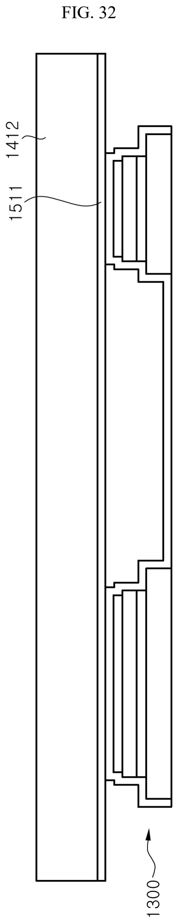

Referring to FIG. 31 and FIG. 32, the third base 1310 is removed from a lower side of the third light emitting source 1300. For example, the third base 1310 may be removed by laser lift-off, chemical lift-off, or wet etching.

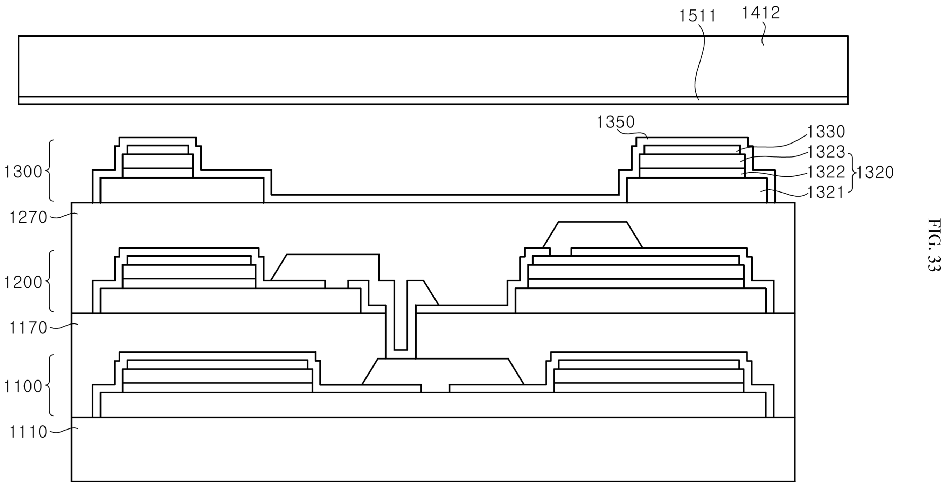

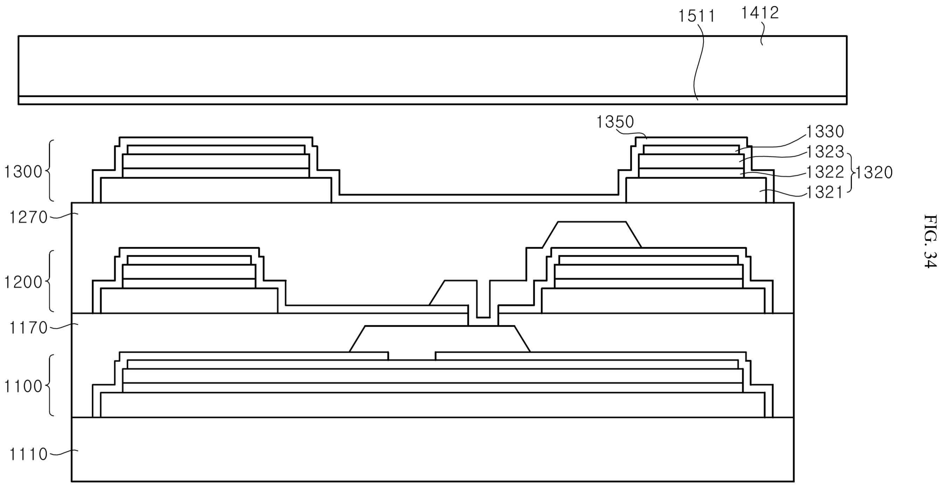

Referring to FIG. 33 and FIG. 34, the third light emitting source 1300 may be stacked on the second light emitting source 1200. The third light emitting source 1300 may be stacked on the second transparent layer 1270 of the second light emitting source 1200. Thus, the third-1 semiconductor layer 1321 of the third light emitting source 1300 may be disposed on the second transparent layer 1270 of the second light emitting source 1200.

After the third light emitting source 1300 is stacked on the second light emitting source 1200, the second support substrate 1412 is removed. For example, heat, ultraviolet light, or infrared light may be utilized to reduce adhesive strength of the adhesive tape 1511 to peel the second support substrate 1412 off of the third light emitting source 1300.

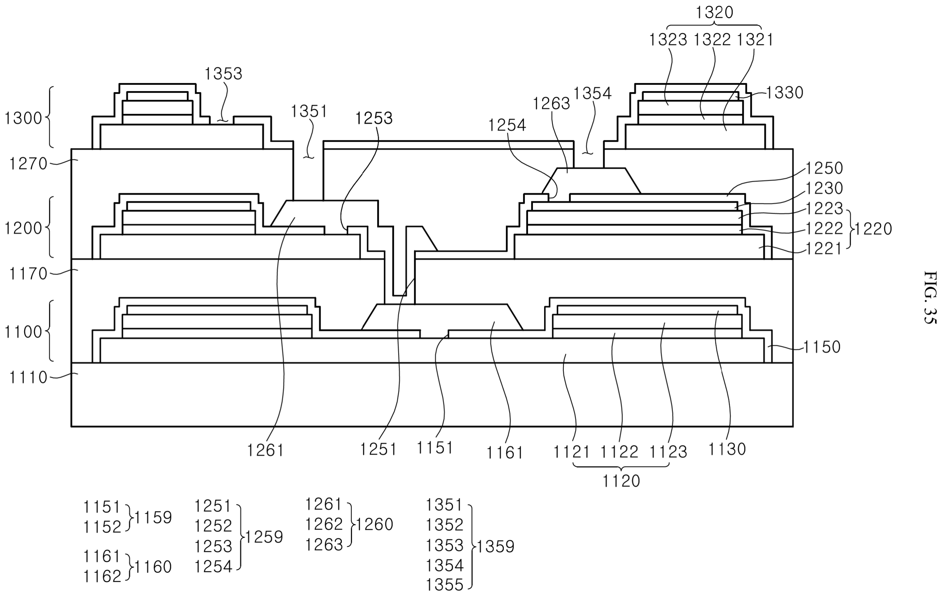

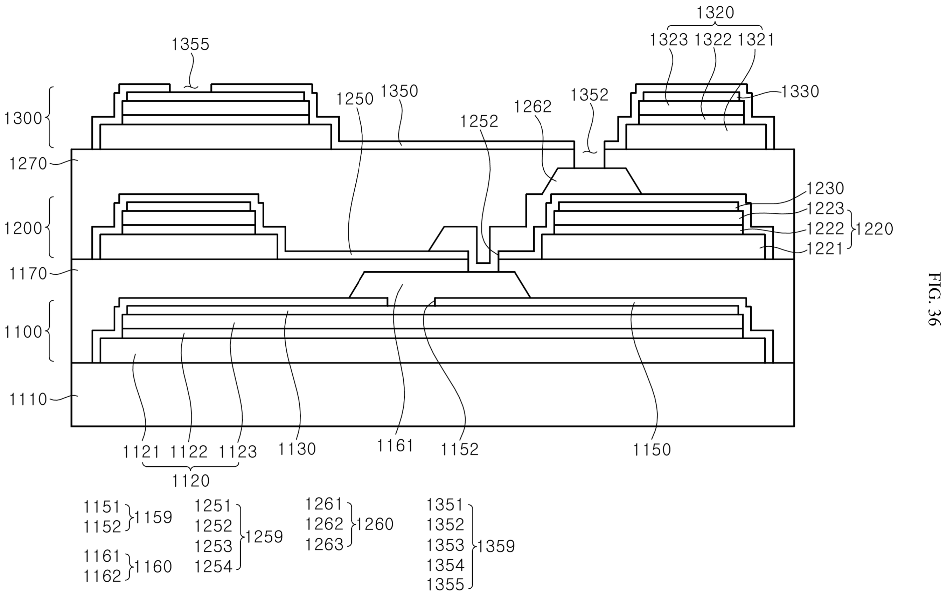

Referring to FIG. 35 and FIG. 36, the third insulating layer 1350 and the second transparent layer 1270 of the third light emitting source 1300 may be patterned. The third openings 1359 may be formed in the third insulating layer 1350 and the second transparent layer 1270. The third openings 1359 may include third-1 to third-5 openings 1351, 1352, 1353, 1354, 1355.

Referring to FIG. 35, the third-1 opening 1351 may be formed on the second-1 metal layer 1261. Here, the third-1 opening 1351 may be formed to expose the second-1 metal layer 1261 disposed on the second-1 semiconductor layer 1221 of the second light emitting source 1200.

The third-3 opening 1353 may be formed in the third insulating layer 1350 covering the third-1 semiconductor layer 1321 of the third light emitting source 1300 to partially expose the third-1 semiconductor layer 1321. Here, the third-3 opening 1353 may be formed at a location adjacent to the third-1 opening 1351.

The third-4 opening 1354 is formed in the second transparent layer 1270 and the third insulating layer 1350 formed on the second-3 metal layer 1263 of the second light emitting source 1200. Thus, the third-4 opening 1354 may partially expose the second-3 metal layer 1263.

Referring to FIG. 36, the third-2 opening 1352 may be formed on the second-2 metal layer 1262. That is, the third-2 opening 1352 may be formed in the third insulating layer 1350 and the second transparent layer 1270 covering the second-2 metal layer 1262 to partially expose the second-2 metal layer 1262.

The third-5 opening 1355 may be formed in the third insulating layer 1350 that covers an upper surface of the third ohmic electrode 1330 of the third light emitting source 1300. Thus, the third-5 opening 1355 may be disposed on the upper surface of the third ohmic electrode 1330 to partially expose the third ohmic electrode 1330.

For example, the third openings 1359 may be formed by dry etching, such as plasma etching or laser etching.

According to this embodiment, the third insulating layer 1350, or the third insulating layer 1350 and the second transparent layer 1270 are formed on the second metal layers 1260 on which the third openings 1359 will be formed, on the third-1 semiconductor layer 1321, and on the third transparent layer 1070. That is, the third openings 1359 may be formed in layers formed of the same material. Thus, like the second openings 1259, time and costs for the process applied to formation of the openings 1059 can be reduced through simplification of the process.

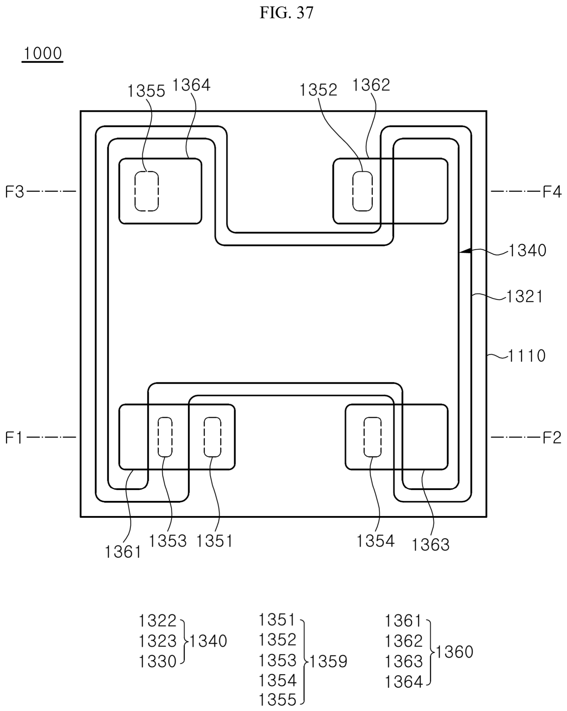

Referring to FIG. 37 to FIG. 39, the third metal layers 1360 may be formed.

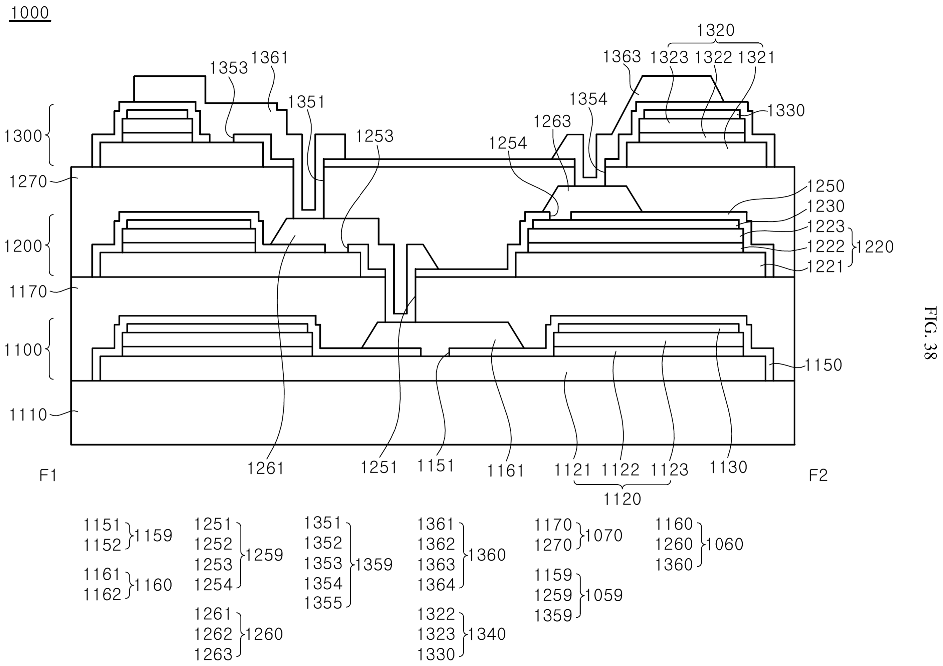

FIG. 37 is a schematic plan view of the pixel device 1000 in which the third metal layers 1360 are formed. FIG. 37 is a cross-sectional view (F1-F2) of the pixel device 1000 in which the third metal layers 1360 are formed. Further, FIG. 38 is another cross-sectional view (F3-F4) of the pixel device 1000 in which the third metal layers 1360 are formed.

The third metal layers 1360 may include third-1 to third-4 metal layers 1361, 1362, 1363, 1364.

Referring to FIG. 38, the third-1 metal layer 1361 may be formed to simultaneously fill the third-1 opening 1351 and the third-3 opening 1353. The third-1 metal layer 1361 may contact the second-1 metal layer 1261 through the third-1 opening 1351 to be electrically connected to each other. In addition, the third-1 metal layer 1361 may be electrically connected to the third-1 semiconductor layer 1321 of the third light emitting source 1300 through the third-3 opening 1353.

Further, the third-1 metal layer 1361 may cover an upper surface of the third insulating layer 1350 around the third-1 opening 1351. Furthermore, the third-1 metal layer 1361 may cover the upper surface of the third insulating layer 1350 around the third-3 opening 1353. That is, the third-1 metal layer 1361 may be formed to fill the third-1 opening 1351 and the third-3 opening 1353 while covering peripheral regions thereof.

Further, the third-1 metal layer 1361 may extend from an upper surface of the second-1 metal layer 1261 to an upper surface of the third-1 semiconductor layer 1321 of the third light emitting source 1300 along the third insulating layer 1350.

In this embodiment, the third metal layers 1360 contacting the second metal layers 1260 may be formed on a flat upper surface of the second metal layers 1260.

As such, a region of the third-1 metal layer 1361 is connected to the second-1 metal layer 1261 and another region thereof is electrically connected to the third-1 semiconductor layer 1321 of the third light emitting source 1300. Accordingly, the second-1 semiconductor layer 1221 of the second light emitting source 1200 and the second-1 semiconductor layer 1221 of the third light emitting source 1300 may be electrically connected to each other through the third-1 metal layer 1361.

The pixel device 1000 according to this embodiment includes the first-1 metal layer 1161, the second-1 metal layer 1261, and the third-1 metal layer 1361 electrically connected to one another. Further, the first-1 metal layer 1161 is electrically connected to the first-1 semiconductor layer 1121 of the first light emitting source 1100, the second-1 metal layer 1261 is electrically connected to the second-1 semiconductor layer 1221 of the second light emitting source 1200, and the third-1 metal layer 1361 is electrically connected to the third-1 semiconductor layer 1321 of the third light emitting source 1300. Thus, in the pixel device 1000 according to this embodiment, the first-1 semiconductor layer 1121 of the first light emitting source 1100, the second-1 semiconductor layer 1221 of the second light emitting source 1200, and the third-1 semiconductor layer 1321 of the third light emitting source 1300 may be electrically connected to one another.

Accordingly, the first-1 metal layer 1161, the second-1 metal layer 1261, and the third-1 metal layer 1361 may act as a common electrode that electrically connect the first light emitting source 1100, the second light emitting source 1200, and the third light emitting source 1300 to one another at the same time.

In addition, a region of the third-1 metal layer 1361 formed on the upper surface of the third ohmic electrode 1330 and exposed to the outside of the pixel device 1000 may act as a pad of the common electrode. That is, the third-1 metal layer 1361 becomes the common electrode pad and an external electrical signal may be simultaneously applied to the first-1 semiconductor layer 1121, the second-1 semiconductor layer 1221, and the third-1 semiconductor layer 1321 of the first to third light emitting sources 1100, 1200, 1300 through the third-1 metal layer 1361.

The third-3 metal layer 1363 may be formed to fill the third-4 opening 1354. Thus, the third-3 metal layer 1363 may be electrically connected to the second-3 metal layer 1263 through the third-4 opening 1354.

The third-3 metal layer 1363 may cover the upper surface of the third insulating layer 1350 around the third-4 opening 1354. In addition, the third-3 metal layer 1363 may extend from the upper surface of the second-3 metal layer 1263 to the upper surface of the third ohmic electrode 1330.

In the pixel device 1000 according to this embodiment, the second-3 metal layer 1263 and the third-3 metal layer 1363 are electrically connected to each other. In addition, the second-3 metal layer 1263 is connected to the second ohmic electrode 1230 of the second light emitting source 1200. Accordingly, the third-3 metal layer 1363 is electrically connected to the second-2 semiconductor layer 1223 of the second light emitting source 1200, which is electrically connected to the second ohmic electrode 1230. Here, the second-3 metal layer 1263 and the third-3 metal layer 1363 electrically connected to the second-2 semiconductor layer 1223 may act as a second electrode.

Here, a region of the third-3 metal layer 1363 formed on the upper surface of the third ohmic electrode 1330 and exposed to the outside of the pixel device 1000 may act as a second electrode pad connected to the second light emitting source 1200. That is, an external electrical signal may be applied to the second-2 semiconductor layer 1223 of the second light emitting source 1200 through the third-3 metal layer 1363, which is the second electrode pad. According to this embodiment, when an electrical signal is applied to the third-3 metal layer 1363 which is the second electrode pad, the second light emitting source 1200 may emit blue light.

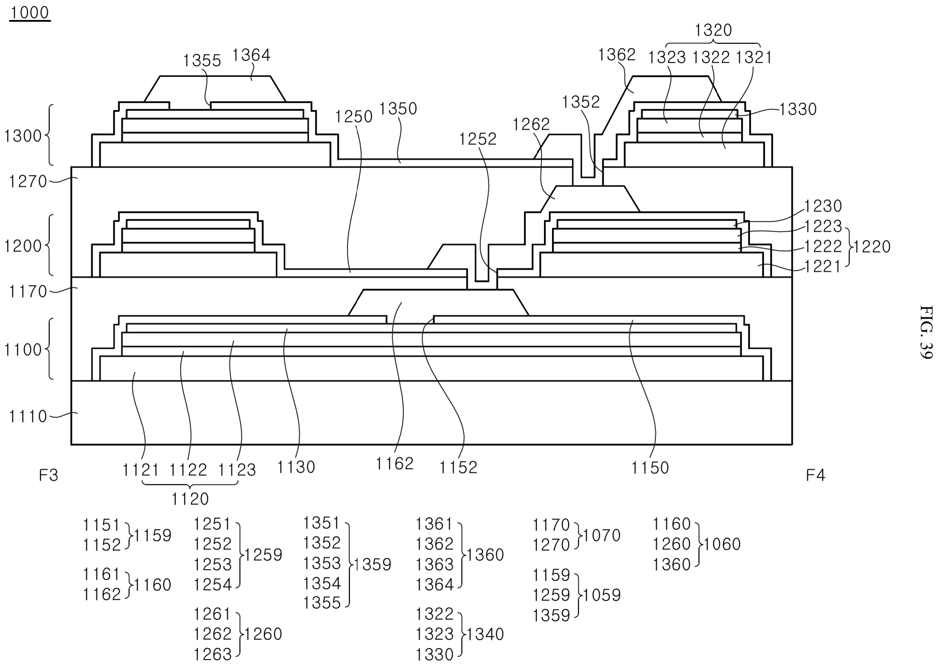

Referring to FIG. 39, the third-2 metal layer 1362 is formed to partially fill the third-2 opening 1352. Thus, the third-2 metal layer 1362 may be electrically connected to the second-2 metal layer 1262 through the third-2 opening 1352. Here, the second-2 metal layer 1262 is electrically connected to the first-2 metal layer 1162. As a result, the third-2 metal layer 1362 may be electrically connected to the first-2 semiconductor layer 1123 of the first light emitting source 1100. Here, the first-2 metal layer 1162, the second-2 metal layer 1262, and the third-2 metal layer 1362 electrically connected to the first-2 semiconductor layer 1123 of the first light emitting source 1100 may act as a first electrode.

Further, a region of the third-2 metal layer 1362 formed on the upper surface of the third ohmic electrode 1330 and exposed to the outside of the pixel device 1000 may act as a first electrode pad connected to the first light emitting source 1100. That is, an external electrical signal may be applied to the first-2 semiconductor layer 1123 of the first light emitting source 1100 through the third-2 metal layer 1362, which is the first electrode pad. According to this embodiment, when an electrical signal is applied to the third-2 metal layer 1362 which is the first electrode pad, the first light emitting source 1100 may emit green light.

Further, the third-2 metal layer 1362 may further cover the insulating layer 1050 around the third-2 opening 1352. In addition, another region of the third-2 metal layer 1362 may be formed on the third light emitting source 1300. More specifically, the other region of the third-2 metal layer 1362 may cover a region of the third insulating layer 1350 on the third ohmic electrode 1330.

In addition, the third-2 metal layer 1362 may extend from the upper surface of the second-2 metal layer 1262 to the upper surface of the third ohmic electrode 1330 along the third insulating layer 1350.

The third-4 metal layer 1364 may be formed to fill the third-5 opening 1355 of the third insulating layer 1350. Thus, the third-4 metal layer 1364 may contact the third ohmic electrode 1330 through the third-5 opening 1355. Accordingly, the third-4 metal layer 1364 may be electrically connected to the third-2 semiconductor layer 1323 of the third light emitting source 1300 through the third ohmic electrode 1330 contacting the third-4 metal layer 1364. Further, the third-4 metal layer 1364 may further cover the third insulating layer 1350 around the third-5 opening 1355. Thus, the width and cross-sectional area of the third-4 metal layer 1364 is greater than the width and cross-sectional area of the third-5 opening 1355.

The externally exposed third-4 metal layer 1364 of the pixel device 1000 may act as a third electrode pad connected to the second light emitting source 1200. That is, an external electrical signal may be applied to the third-2 semiconductor layer 1323 of the third light emitting source 1300 through the third-4 metal layer 1364 which is the third electrode pad. According to this embodiment, when an electrical signal is applied to the third-4 metal layer 1364 which is the third electrode pad, the third light emitting source 1300 may emit red light.

Referring to FIG. 38, the first-1 opening 1151 on the first-1 semiconductor layer 1121, the second-3 opening 1253 on the second-1 semiconductor layer 1221, and the third-3 opening 1353 on the third-1 semiconductor layer 1321 are placed at different locations. Further, a central line of the second-3 opening 1253 is placed between a central line of the first-1 opening 1151 and a central line of the third-3 opening 1353.

Further, a side surface of the second-1 semiconductor layer 1221 and a side surface of the third-1 semiconductor layer 1321 are disposed above the first-1 semiconductor layer 1121. Here, the side surface of the second-1 semiconductor layer 1221 is placed between the first-1 opening 1151 and the side surface of the third-1 semiconductor layer 1321.

Thus, the first-1 metal layer 1161, the second-1 metal layer 1261, and the third-1 metal layer 1361, which act as common electrodes filling the openings 1059 to be electrically connected to one another, may be formed in a stepped structure in which the centers thereof are placed on different vertical and horizontal lines.

Furthermore, the second-3 metal layer 1263 and the third-3 metal layer 1363 electrically connected to each other have centers placed on different vertical lines and different horizontal lines, respectively. Accordingly, the second-3 metal layer 1263 and the third-3 metal layer 1363, which are the second electrode, may also be formed in a stepped structure.

Referring to FIG. 39, the first-2 metal layer 1162, the second-2 metal layer 1262, and the third-2 metal layer 1362, which are electrically connected to one another, have centers placed on different vertical lines and different horizontal lines, respectively. Accordingly, the first electrode may also be formed in a stepped structure.

Typically, the first light emitting source or the third light emitting source is formed to have a cross-sectional area gradually decreasing with increasing distance from the first base and includes electrodes formed along an outer periphery of the first light emitting source or the third light emitting source. In this structure, although the electrodes are not formed on an inner surface of the first light emitting source or the third light emitting source, the first light emitting source and the third light emitting source have different luminous areas. Accordingly, the pixel device emits different quantities of light for each color.

According to the first embodiment, the pixel device 1000 may be formed such that the area of the first mesa structure 1140 of the first light emitting source 1100 of FIG. 5, the area of the second mesa structure 1240 of the second light emitting source 1200 of FIG. 8, and the area of the third mesa structure 1340 of the third light emitting source 1300 of FIG. 11 are as similar to each other as possible. That is, the pixel device 1000 according to the first embodiment may be formed such that light emitting surfaces of the first light emitting source 1100, the second light emitting source 1200, and the third light emitting source 1300 have a maximum area excluding the metal layer 1060 placed at a lower region of each light emitting source so as to minimize difference in luminous area between the light emitting surfaces of the light emitting sources. Accordingly, the first light emitting source 1100, the second light emitting source 1200, and the third light emitting source 1300 may emit similar quantities of light.

In addition, typically, in order to allow the first metal layer and the third metal layer to contact the first light emitting source and the third light emitting source, the first to third light emitting structures are formed with holes, which will not be filled with a conductive material. That is, electrodes are formed on an inner surface of the first to third light emitting sources. In this structure, the luminous areas of the first to third light emitting sources are reduced by the electrodes therein.

However, the pixel device 1000 according to this embodiment can prevent the luminous areas of the first to third light emitting sources 1100, 1200, 1300 from being reduced by the electrodes, thereby preventing loss of luminance due to reduction in luminous area.

In addition, typically, a metal layer for electrical connection to each of the light emitting sources is formed after the first to third light emitting sources are stacked. Therefore, the openings for electrical connection of the metal layers and the light emitting sources must be formed in layers formed of different materials.

In the pixel device 1000 according to this embodiment, the openings 1059 are formed on different vertical lines and are formed in layers formed of the same material, and the metal layers 1060 are formed thereon each time that the light emitting source is stacked. Thus, the pixel device 1000 according to this embodiment does not need to form the openings 1059 by patterning multiple layers composed of different materials at the same time, thereby improving convenience of the process while reducing costs and time for the process through further simplification of the process.

In the drawings illustrating the pixel device 1000 according to the first embodiment, each of the metal layers 1060 is shown as being a single layer formed of a single material. However, the metal layer 1060 according to this embodiment may have a multilayer structure. That is, the metal layer 1060 may include a plurality of layers, at least a layer of which may be formed of a different material than other layers.

Furthermore, although it has been described that, in the pixel device 1000 according to the first embodiment, the first light emitting source 1100 emits green light, the second light emitting source 1200 emits blue light, and the third light emitting source 1300 emits red light, it should be understood that the present disclosure is not limited thereto. The first light emitting source 1100, the second light emitting source 1200, and the third light emitting source 1300 emit at least a of green light, blue light, or red light, and may emit different colors of light. For example, the first light emitting source 1100 may emit blue light, the second light emitting source 1200 may emit green light, and the third light emitting source 1300 may emit red light.

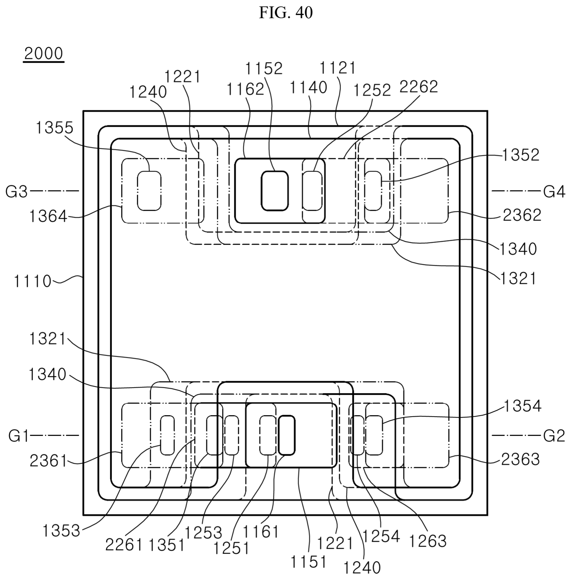

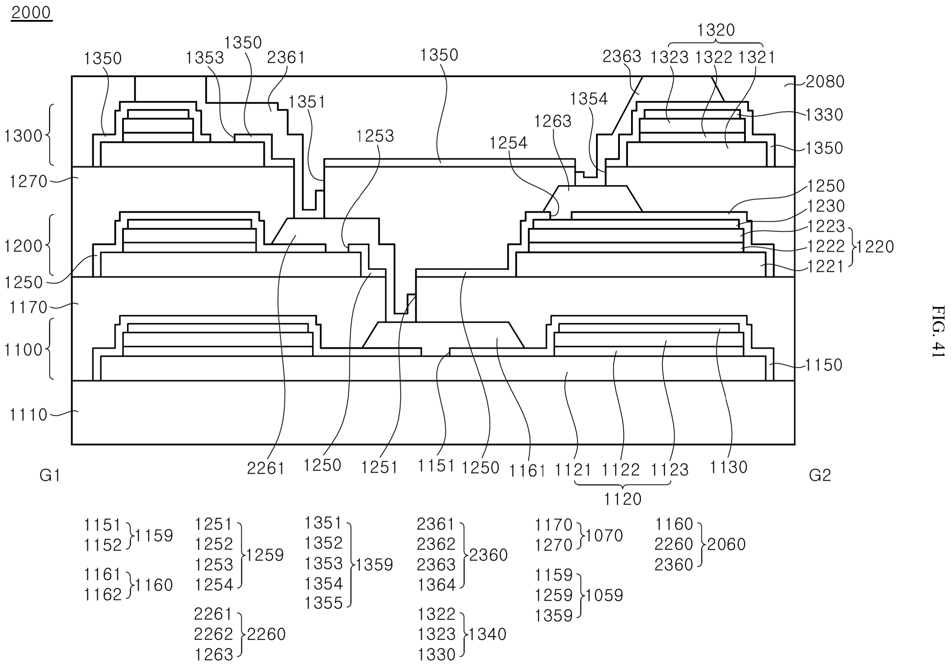

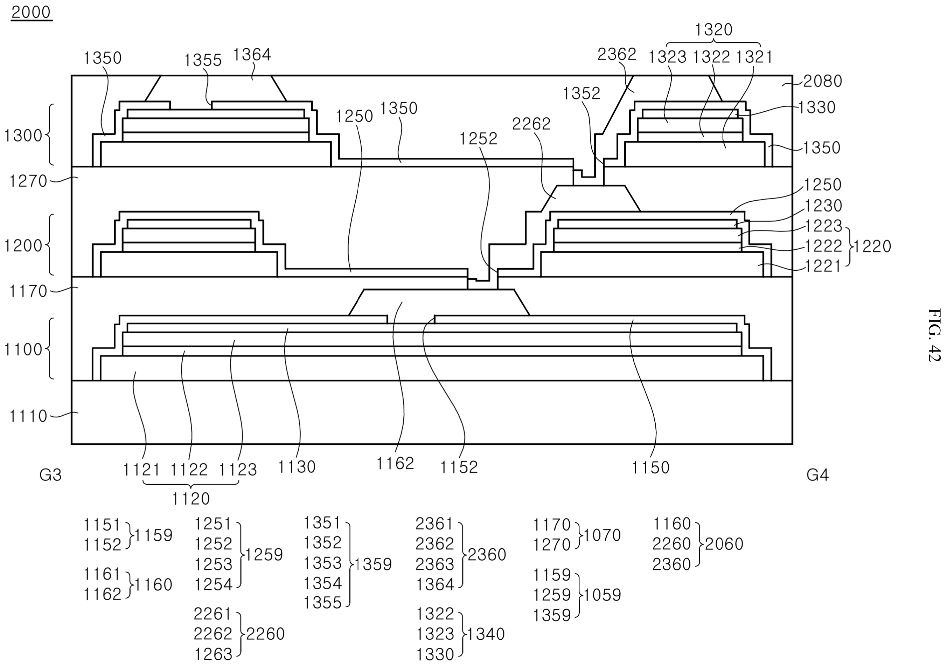

FIG. 40 to FIG. 42 show a pixel device 2000 according to a second embodiment of the present disclosure. FIG. 40 is a schematic plan view of the pixel device according to the second embodiment of the present disclosure. FIG. 41 is a cross-sectional view (G1-G2) of the pixel device 2000 according to the second embodiment of the present disclosure. Further, FIG. 42 is another cross-sectional view (G3-G4) of the pixel device 2000 according to the second embodiment of the present disclosure.

The pixel device 2000 according to this embodiment includes metal layers 2060 that have a different structure from the metal layers 1060 of the pixel device 1000 according to the first embodiment.

The metal layers 2060 formed on the openings 1059 of the transparent layer 1070 are formed to cover a region of an inner wall and a bottom surface of each of the openings 1059. For example, when the metal layer 2060 is formed by deposition, the metal layer 2060 may be formed along the bottom surface from an inner wall of the opening 1059 to cover a region of the other inner wall thereof. An inner wall of the transparent layer 1070 in the openings 1059 may be partially exposed by the metal layers 2060 with such a structure. That is, a region of the metal layers 2060 may have an asymmetrical cross-section within the opening 1059.

More specifically, regions of a second-1 metal layer 2261 and a second-2 metal layer 2262 formed in the second-1 opening 1251 and the second-2 opening 1252 of the first transparent layer 1170, and regions of a third-1 metal layer 2361, a third-2 metal layer 2362, and a third-3 metal layer 2363 formed in the third-1 opening 1351, the third-2 opening 1352 and the third-4 opening 1354 of the second transparent layer 1270 may be formed along the inner wall and the bottom surface of each of the openings 1059. Here, the inner walls of the second-1 opening 1251, the second-2 opening 1252, the third-1 opening 1351, the third-2 opening 1352, and the third-4 opening 1354 may be partially exposed through the metal layer 2060 formed on each of the openings 1059. Here, the inner walls of the second openings 1259 exposed through the metal layers 2060 correspond to the first transparent layer 1170 and the second insulating layer 1250, and the inner walls of the third openings 1359 exposed through the metal layers 2060 correspond to the second transparent layer 1270 and the third insulating layer 1350.

The second transparent layer 1270 may be formed to fill the second-1 opening 1251 and the second-2 opening 1252. Accordingly, in the second-1 opening 1251 and the second-2 opening 1252, a region of the first transparent layer 1170 may contact the second metal layer 2260 and another region thereof may contact the second transparent layer 1270.

As such, the second transparent layer 1270 may partially fill the second openings 1259, thereby covering an end of the second metal layer 2260 within the second openings 1259. Thus, in this embodiment, the second transparent layer 1270 can prevent delamination of the end of the second metal layer 2260 within the second openings 1259.

In addition, the pixel device 2000 may include a protective layer 2080 formed on the third light emitting source 1300, a third metal layer 2360, and the second transparent layer 1270 to cover the third light emitting source 1300, the third metal layer 2360 and the second transparent layer 1270. The protective layer 2080 may be formed of an insulating material. In addition, the protective layer 2080 may be formed of or include a material that reflects light. Further, the protective layer 2080 may be formed of a material that transmits light, as needed.

The protective layer 2080 may be formed to fill the third openings 1359. More specifically, the protective layer 2080 may fill a third-1 opening 2351, a third-2 opening 2352, and a third-4 opening 2354. Thus, in some third openings 2359, a region of the second transparent layer 1270 may contact the third metal layer 2360 and another region thereof may contact the protective layer 2080.

In addition, the protective layer 2080 partially fills the third openings 1359, thereby covering an end of the third metal layer 2360 within the third openings 1359. Thus, the protective layer 2080 can prevent the end of the third metal layer 2360 from delaminating within the third openings 1359.

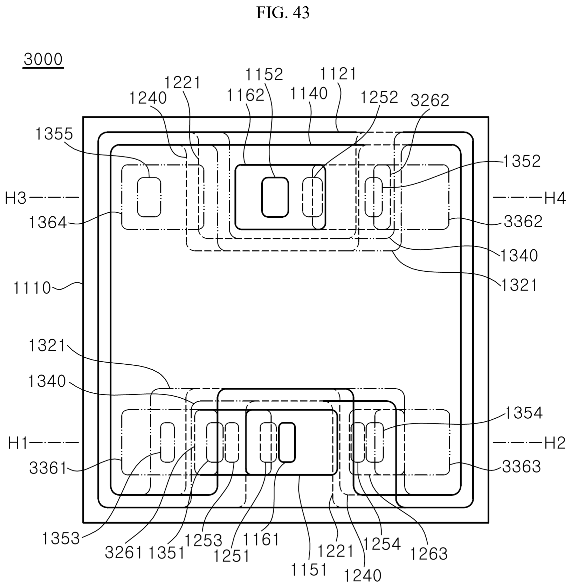

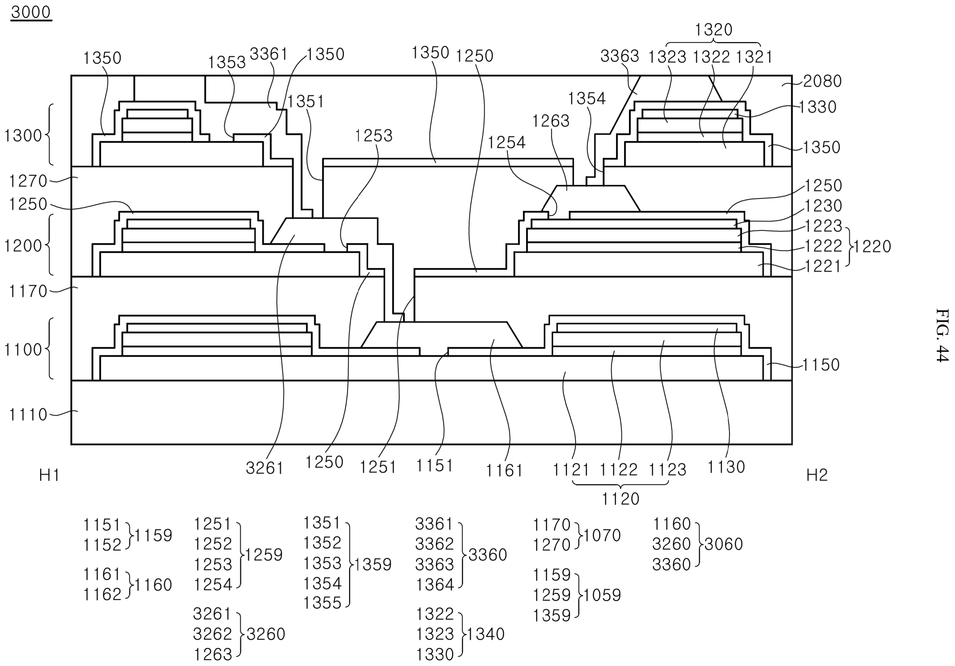

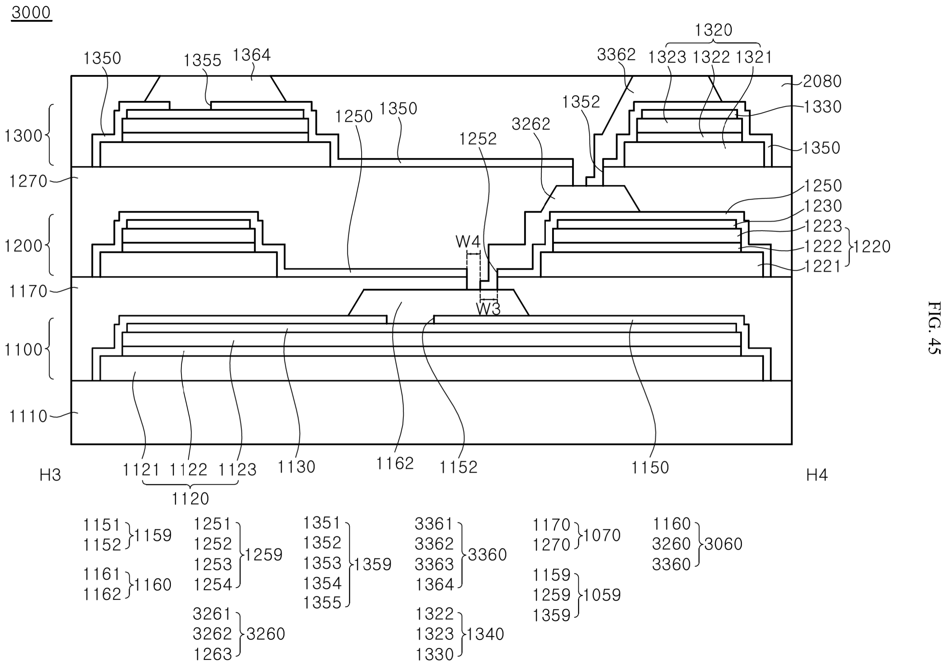

FIG. 43 to FIG. 45 are views of a pixel device 3000 according to a third embodiment of the present disclosure. FIG. 43 is a schematic plan view of the pixel device according to the third embodiment of the present disclosure. FIG. 44 is a cross-sectional view (H1-H2) of the pixel device 3000 according to the third embodiment of the present disclosure. Further, FIG. 45 is another cross-sectional view (H3-H4) of the pixel device 3000 according to the third embodiment of the present disclosure.

The pixel device 3000 according to this embodiment includes metal layers 3060 that have a different structure from the metal layers 1060 of the pixel device 1000 according to the first embodiment.

The metal layers 3060 formed on the openings 1059 of the transparent layer 1070 cover a region of the inner wall and the bottom surface of the openings 1059. For example, when the metal layers 3060 are formed by deposition, the metal layers 3060 may be formed on an inner wall of the opening 1059 along the bottom surface thereof so as to cover only a region of the bottom surface. That is, a region of the metal layer 3060 may have an asymmetrical cross-section within the opening 1059. With this configuration, the metal layers 3060 can partially expose the inner wall of the transparent layer 1070 in the openings 1059 and the metal layer 3060 placed at the bottom of the opening 1059.

More specifically, regions of a second-1 metal layer 3261 and a second-2 metal layer 3262 formed in the second-1 opening 1251 and the second-2 opening 1252 of the first transparent layer 1170, and regions of a third-1 metal layer 3361, a third-2 metal layer 3362 and a third-3 metal layer 3363 formed in the third-1 opening 1351, the third-2 opening 1352 and the third-4 opening 1354 of the second transparent layer 1270 may be formed along the inner wall and the bottom surface of each of the openings 1059 to partially cover the inner wall and the bottom surface thereof. Here, the inner walls of the second-1 opening 1251, the second-2 opening 1252, the third-1 opening 1351, the third-2 opening 1352, and the third-4 opening 1354 may be partially exposed through the metal layer 3060 formed on each of the openings 11059. Here, the inner walls of the second openings 1259 exposed through the metal layer 3060 correspond to the first transparent layer 1170 and the second insulating layer 1250, and the inner walls of the third opening 3359 exposed through the metal layer 3060 correspond to the second transparent layer 1270 and the third insulating layer 1350. In addition, the upper surfaces of the first-1 metal layer 1161, the first-2 metal layer 1162, the second-1 metal layer 3261, the second-1 metal layer 3262, the second-2 metal layer 3262, and the second-3 metal layer 3263 placed at lower sides of the second-1 opening 1251, the second-2 opening 1252, the third-1 opening 1351, the third-2 opening 1352, and the third-4 opening 1354 may also be partially exposed outside.

The second transparent layer 1270 may be formed to fill the second-1 opening 1251 and the second-2 opening 1252. Thus, in the second-1 opening 1251 and the second-2 opening 1252, a region of the first transparent layer 1170 may contact a second metal layer 3260 and another region thereof may contact the second transparent layer 1270. Further, in the second-1 opening 1251 and the second-2 opening 1252, a region of the second transparent layer 1270 may contact the first transparent layer 1170, another region thereof may contact the first metal layers 1160, a third region thereof may contact the second metal layer 3260, and a fourth region thereof may contact the second insulating layer 1250.

As such, the second transparent layer 1270 may partially fill the second openings 1259, thereby covering the end of the second metal layer 3260 within the second openings 1259. Thus, in this embodiment, the second transparent layer 1270 can prevent the end of the second metal layer 3260 from delaminating within the second openings 1259.

In addition, the pixel device 3000 may include a protective layer 2080 formed on the third light emitting source 1300, a third metal layer 3360 and the second transparent layer 1270 to cover the third light emitting source 1300, the third metal layer 3360 and the second transparent layer 1270. The protective layer 2080 may be formed of an insulating material. In addition, the protective layer 2080 may be formed of or include a material that reflects light. Further, the protective layer 2080 may be formed of a material that transmits light, as needed.

The protective layer 2080 may be formed to fill the third openings 1359. More specifically, the protective layer 2080 may fill a third-1 opening 3351, a third-2 opening 3352, and a third-4 opening 3354. Thus, in the third-1 openings 3351, the third-2 opening 3352, and the third-4 opening 3354, a region of the protective layer 2080 may contact the second transparent layer 1270, another region thereof may contact the second metal layer 3260, a third region thereof may contact the third metal layer 3360, and a fourth region thereof may contact the third insulating layer 1350.

In addition, the protective layer 2080 partially fills the third opening 1359, thereby covering an end of the third metal layer 3360 within the third openings 1359. Thus, the protective layer 2080 can prevent the end of the third metal layer 3360 from delaminating within the third openings 1359.

Referring to FIG. 45, a width W3 of the first-2 metal layer 1162 contacting the second-2 metal layer 3262 in the second-2 opening 1252 may be greater than a width W4 of the first-2 metal layer 1162 contacting the second transparent layer 1270 therein. Further, a contact area of the first-2 metal layer 1162 with the second-2 metal layer 3262 in the second-2 opening 1252 may be greater than a contact area of the first-2 metal layer 1162 with the second transparent layer 1270 therein. In addition, referring to FIG. 44, a width or area of the first-1 metal layer 1161 contacting the second-1 metal layer 3261 in the second-1 opening 1251 may be greater than the width or area of the first-1 metal layer 1161 contacting the second transparent layer 1270 therein. Further, referring to FIG. 44 and FIG. 45, a width or area of the second metal layer 3260 contacting the third metal layer 3360 in the third opening 1359 may be greater than a width or area of the second metal layer 3260 contacting the protective layer 2080 therein.

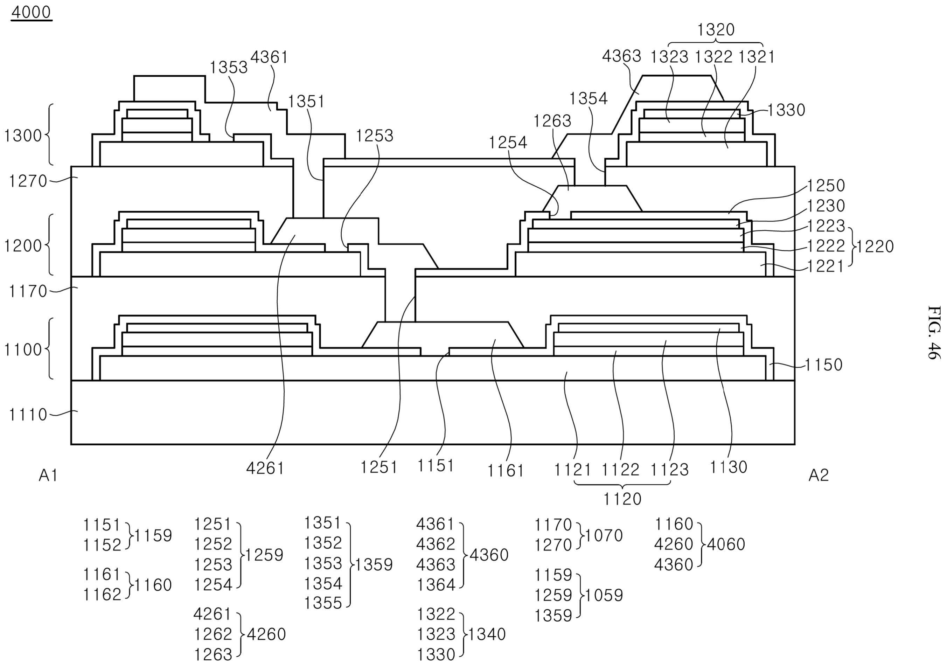

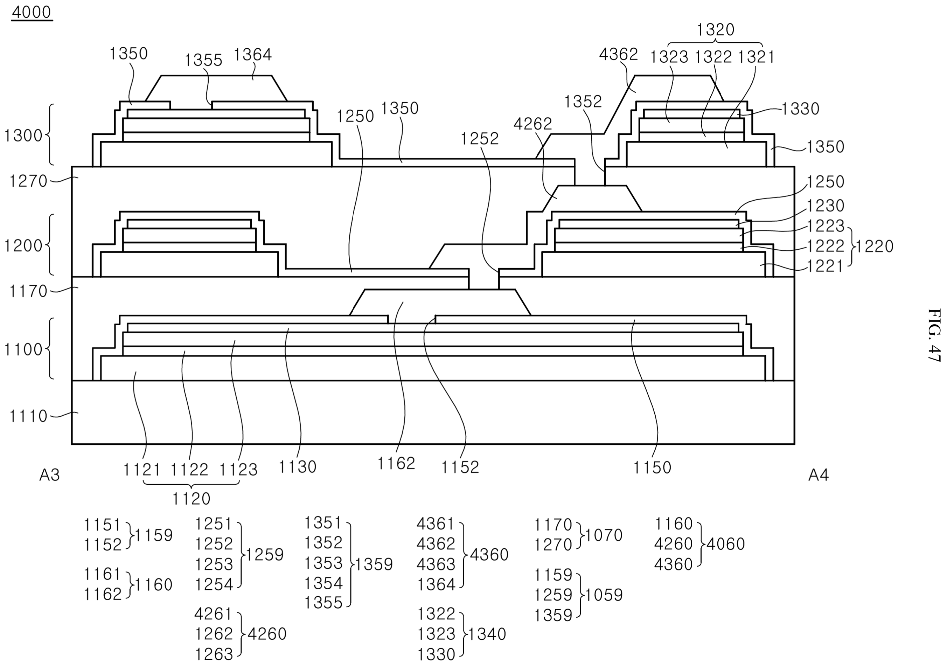

FIG. 46 and FIG. 47 are views of a pixel device 4000 according to a fourth embodiment of the present disclosure. FIG. 46 is a cross-sectional view of the pixel device 4000 according to the fourth embodiment of the present disclosure. More specifically, FIG. 46 is a cross-sectional view taken along line A1-A2 of FIG. 2. Further, FIG. 47 is another cross-sectional view of the pixel device 4000 according to the fourth embodiment of the present disclosure. More specifically, FIG. 47 is a cross-sectional view taken along line A3-A4 of FIG. 2.

The pixel device 4000 according to this embodiment includes metal layers 4060 that have a different structure than the metal layers of the pixel device 1000 according to the first embodiment.

In the pixel device 4000 according to this embodiment, the metal layers 1060 are formed on the openings 1059 to cover the inner walls of the openings 1059 while filling the openings 1059.

For example, referring to FIG. 46, a second-1 metal layer 4261, a third-1 metal layer 4361, and a third-3 metal layer 4363 fill the second-1 opening 1251, the third-3 opening 1353, and the third-4 opening 1354, respectively.

In addition, referring to FIG. 47, a second-2 metal layer 4262 and a third-2 metal layer 4362 fill the second-2 opening 1252 and the third-2 opening 1352, respectively.

When the metal layer 1060 fills the openings 1059, the metal layer 1060 may be formed by plating.

Although the drawings illustrating the pixel devices 1000, 4000 according to the first and fourth embodiments do not show the protective layer 2080, the protective layer 2080 may be added thereto, as needed.

For the pixel device according to the present disclosure, the metal layers may be formed in various structures, as described in the first to fourth embodiments.

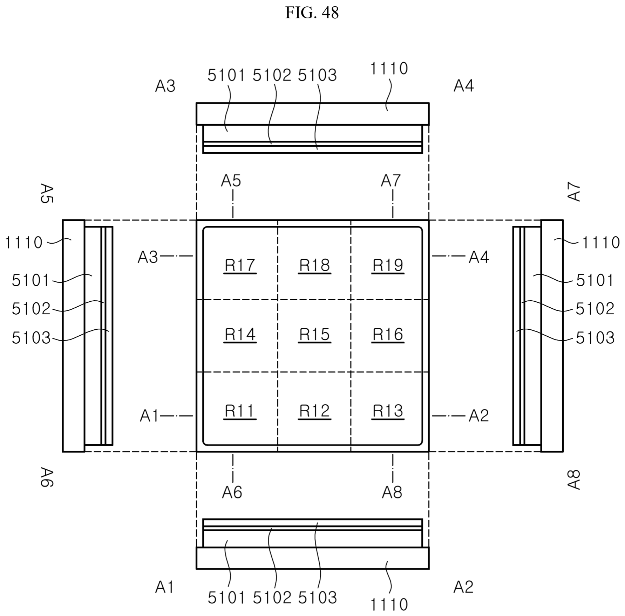

FIG. 48 to FIG. 71 are views of a pixel device according to a fifth embodiment of the present disclosure and a method of manufacturing the same.

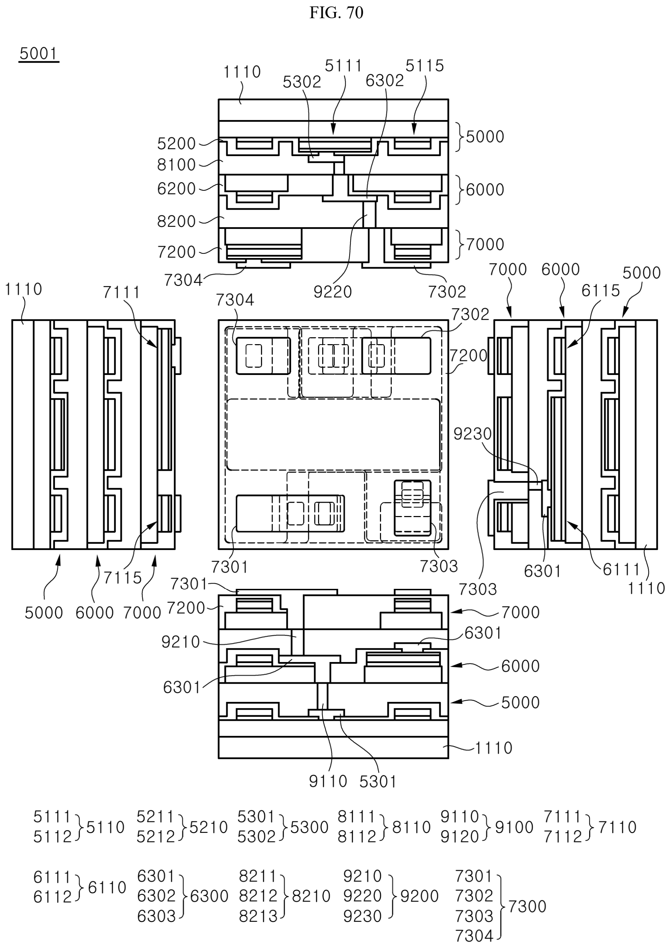

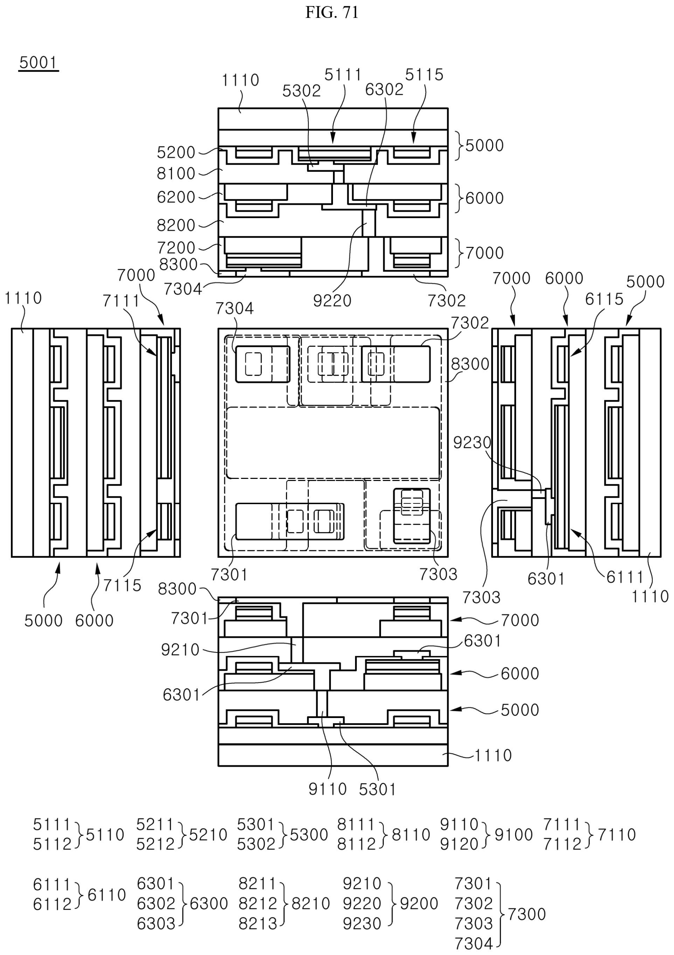

Referring to FIG. 70 and FIG. 71, a pixel device 5001 according to the fifth embodiment may include a first base 1110, a first light emitting source 5000, a second light emitting source 6000, and a third light emitting source 7000. According to this embodiment, the first light emitting source 5000 may emit green light or blue light, the second light emitting source 6000 may emit blue light or green light, and the third light emitting source 7000 may emit red light. However, it should be understood that the present disclosure is not limited thereto. The first light emitting source 5000, the second light emitting source 6000, and the third light emitting source 7000 may emit at least a light of green light, blue light, or red light and may emit different colors of light.

Referring to FIG. 48 to FIG. 62, the first to third light emitting sources 5000, 6000, 7000 may be formed separately.

FIG. 48 to FIG. 52 are views of the first light emitting source 5000 of the pixel device 5001 of the fifth embodiment of the present disclosure and a manufacturing method thereof.

Referring to FIG. 48 to FIG. 52, the first light emitting source 5000 may be formed on a first base 1110. The first light emitting source 5000 may include a first semiconductor structure, a first ohmic electrode 5104, a first insulating layer 5200, and first metal layers 5300.

Referring to FIG. 48, the first semiconductor structure may be formed on the first base 1110. The first semiconductor structure may include a first-1 semiconductor layer 5101, a first active layer 5102, and a first-2 semiconductor layer 5103.

According to this embodiment, the first base 1110 may serve as a growth substrate that allows growth of semiconductor layers thereon. For example, the first base 1110 may include sapphire. In a final product, the first base 1110 is not essentially included in the pixel device and the first base 1110 may be removed therefrom.

The first-1 semiconductor layer 5101 may be formed on the first base 1110, the first active layer 5102 may be formed on the first-1 semiconductor layer 5101, and the first-2 semiconductor layer 5103 may be formed on the first active layer 5102.

The first semiconductor structure may be formed by metal organic chemical vapor deposition (MOCVD) or molecular beam epitaxy (MBE). A second semiconductor structure of the second light emitting source 6000 and a third semiconductor structure of the third light emitting source 7000 may also be formed in the same manner.

The first-1 semiconductor layer 5101 may be an n-type conductive semiconductor layer and the first-2 semiconductor layer 5103 may be a p-type conductive semiconductor layer, or vice versa. For example, the first semiconductor structure may include a semiconductor material that emits green light or blue light, such as GaN, InGaN, AlGaN, InAlGaN, GaP, AlGaInP, AlGaP, or the like.

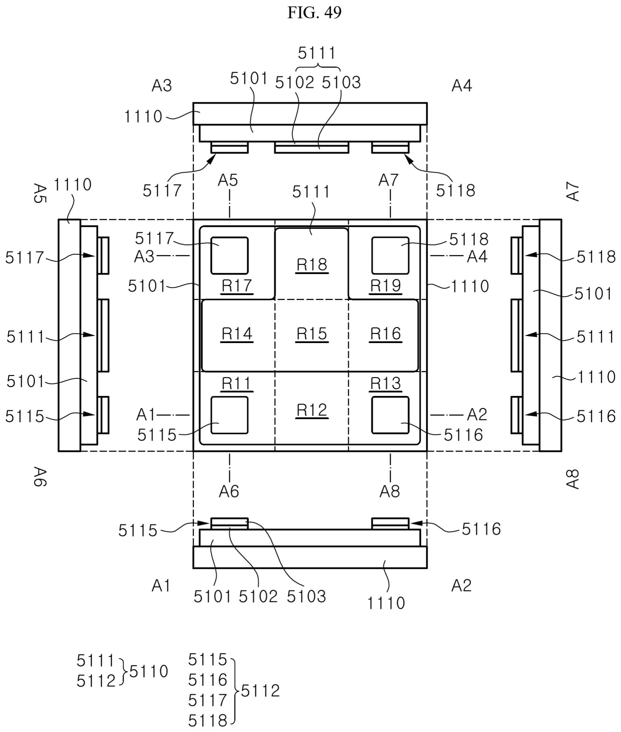

Referring to FIG. 49, the first semiconductor structure may be patterned to form a first mesa structure 5110. The first active layer 5102 and the first-2 semiconductor layer 5103 may be partially etched to partially expose an upper surface of the first-1 semiconductor layer 5101. The first active layer 5102 and some regions of the first-2 semiconductor layer 5103 and the first-1 semiconductor layer 5101 remaining on the first-1 semiconductor layer 5101 after the etching process may become the first mesa structure 5110.

The first mesa structure 5110 has a structure in which side surfaces of the first mesa structure 5110 are perpendicular to the upper surface of the first-1 semiconductor layer 5101. However, it should be understood that the structure of the first mesa structure 5110 is not limited thereto. For example, the first mesa structure 5110 may have a structure in which the width and cross-sectional area of the first mesa structure 5110 gradually decreases from a lower surface of the first active layer 5102 to an upper surface of the first-2 semiconductor layer 5103. That is, the first mesa structure 5110 may have a structure with inclined side surfaces. The mesa structure of each of the second light emitting source 6000 and the third light emitting source 7000 described below may also have a structure in which the side surfaces thereof are perpendicular or inclined with respect to the upper surface of the first semiconductor layer.

According to this embodiment, the first mesa structure 5110 may include a first light emitting structure 5111 and first buffer structures 5112. That is, a region of the first mesa structure 5110 may become the first light emitting structure 5111 and another region of the first mesa structure 5110 may become the first buffer structure 5112. The first light emitting structure 5111 and the first buffer structures 5112 may be disposed on the same plane.

The first buffer structures 5112 may share the first light emitting structure 5111 and the first-1 semiconductor layer 5101. Thus, the first buffer structures 5112 may be electrically connected to an electrode electrically connected to the first-1 semiconductor layer 5101 of the first light emitting structure 5111 while maintaining a non-emissive state.

In another embodiment, the first buffer structures 5112 may be spaced apart from the first light emitting structure 5111, with a first transparent layer 8100 interposed between the first buffer structures 5112 and the first light emitting structure 5111. Thus, the first buffer structures 5112 may be electrically insulated from other structures and may be kept in a non-emissive state. Thus, the first transparent layer 8100 and the second transparent layer 8200 may contact each other in a region thereof.

The first light emitting structure 5111 may be a light emitting region that emits light when the first light emitting source 5000 is powered by electricity. However, the first buffer structure 5112 does not emit light even when the first light emitting source 5000 is powered by electricity. The first buffer structure 5112 may be spaced apart from the first light emitting structure 5111 to be kept in a non-emissive state regardless of light emission from the first light emitting structure 5111.

Referring to FIG. 48, an upper surface of the first base 1110 or the first-1 semiconductor layer 5101 may be divided into 9 regions (3x3). The nine regions may include first-1 to first-9 regions R11, R12, R13, R14, R15, R16, R17, R18, R19.

The first light emitting structure 5111 is formed in a first-4 region R14, in a first-6 region R16, in a first-8 region R18, and in a first-5 region R15 at the center, in which regions of the first light emitting structure 5111 formed in these regions are connected to each other. That is, the first light emitting structure 5111 includes a plurality of regions extending in different directions from the first-5 region R15 at the center.

The first buffer structures 5112 may be placed in regions where the first light emitting structure 5111 is not formed. The first buffer structures 5112 may be placed at respective corners relative to a plane of the first base 1110. The first buffer structures 5112 may include a first-1 buffer structure 5115, a first-2 buffer structure 5116, a first-3 buffer structure 5117, and a first-4 buffer structure 5118 formed adjacent to the corners of the first base 1110 or the first-1 semiconductor layer 5101, respectively. Referring to FIG. 49, the first-1 buffer structure 5115 may be formed in the first-1 region R11, the first-2 buffer structure 5116 may be formed in the first-3 region R13, the first-3 buffer structure 5117 may be formed in the first-7 region R17, and the first-4 buffer structure 5118 may be formed in the first-9 region R19.

With respect to the first buffer structures 5112, the first light emitting structure 5111 is disposed between the first buffer structures 5112. Referring to FIG. 49, the first light emitting structure 5111 is formed in the first-8 region R18 between the first-3 buffer structure 5117 and the first-4 buffer structure 5118, in the first-4 region R14 between the first-1 buffer structure 5115 and the first-3 buffer structure 5117, in the first-6 region R16 between the first-2 buffer structure 5116 and the first-4 buffer structure 5118, and in the first-5 region R15 at the center, in which regions of the first light emitting structure formed in these regions are connected to each other.

The first buffer structures 5112 and the first light emitting structure 5111 are formed through the same etching process so as to have the same height.

In this embodiment, the first light emitting source 5000 includes a plurality of first buffer structures 5112 and a single first light emitting structure 5111. However, it should be understood that the first light emitting source 5000 is not limited thereto and may include a plurality of first light emitting structures 5111 or a single first buffer structures 5112.

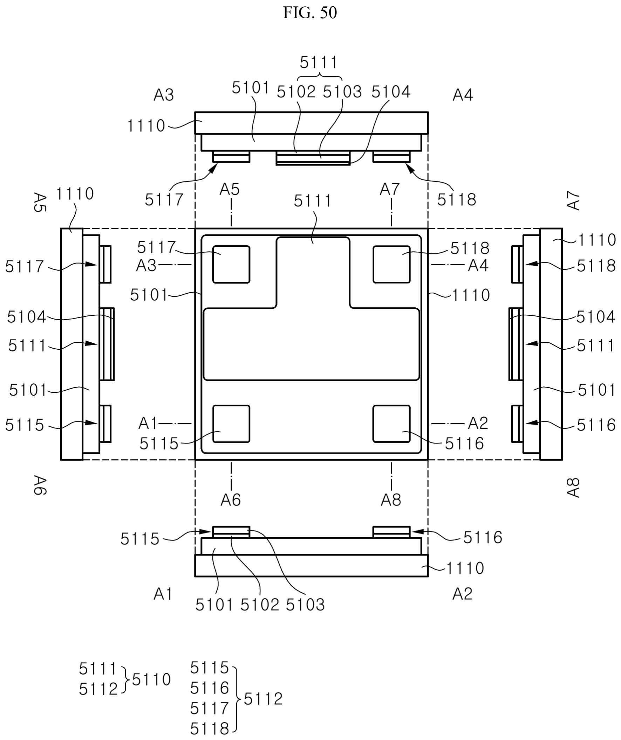

Referring to FIG. 50, the first ohmic electrode 5104 may be formed on the first light emitting structure 5111. More specifically, the first ohmic electrode 5104 may cover an upper surface of the first-2 semiconductor layer 5103 of the first light emitting structure 5111.

The first ohmic electrode 5104 may have high transmittance and high electrical conductivity with respect to light emitted from the first light emitting structure 5111. For example, the first ohmic electrode 5104 may be a transparent electrode. In addition, the first ohmic electrode 5104 may be formed of indium tin oxide (ITO). In this embodiment, the first light emitting structure 5111 may include not only the first active layer 5102 and the first-2 semiconductor layer 5103, but also the first ohmic electrode 5104. That is, the first mesa structure 5110 may also include the first ohmic electrode 5104.

Although the first ohmic electrode 5104 is formed only on the first-2 semiconductor layer 5103 of the first light emitting structure 5111, it should be understood that the present disclosure is not limited thereto. When the first ohmic electrode 5104 is formed on the first-2 semiconductor layer 5103 of the first light emitting structure 5111, the first ohmic electrode 5104 may also be formed on the first-2 semiconductor layer 5103 of the first buffer structure 5112.

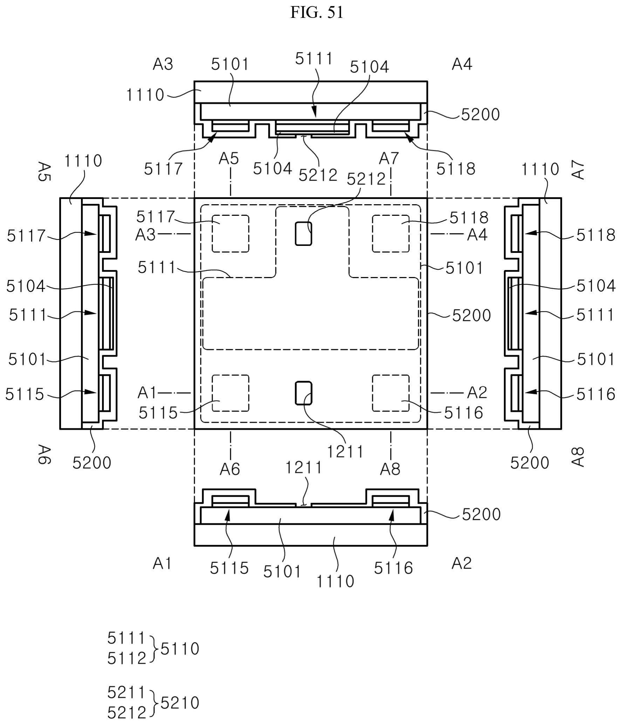

Referring to FIG. 51, the first insulating layer 5200 may be formed. The first insulating layer 5200 may cover the first mesa structure 5110 and the first-1 semiconductor layer 5101 exposed through the first mesa structure 5110.

The first insulating layer 5200 may be formed of a light transmissive material. For example, the first insulating layer 5200 may be formed of a silicon oxide, such as SiO₂, a silicon nitride, such as Si₃N₄, or a silicon oxynitride.

The first insulating layer 5200 may include first openings 5210. Further, the first openings 5210 may include a first-1 opening 5211 to expose the first semiconductor layer 5101 and a first-2 opening 5212 to expose the first ohmic electrode 5104.

Referring to FIG. 51, the first-1 opening 5211 may be disposed on the first-1 semiconductor layer 5101 between the first-1 buffer structure 5115 and the first-2 buffer structure 5116. In addition, the first-2 opening 5212 may be disposed on the first ohmic electrode 5104 of the first light emitting structure 5111 between the first-3 buffer structure 5117 and the first-4 buffer structure 5118.

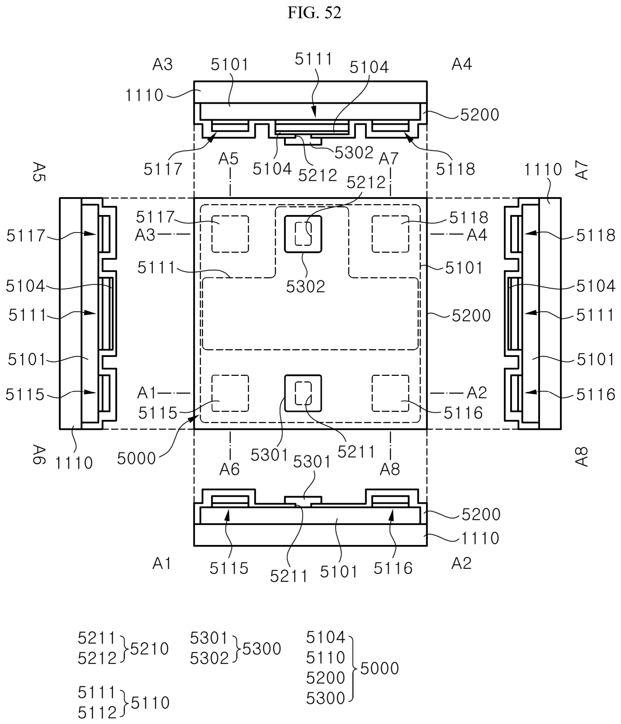

Referring to FIG. 52, the first metal layers 5300 may be formed. The first metal layers 5300 may be formed to fill the first openings 5210 of the first insulating layer 5200.

The first metal layer 5300 may be formed of a conductive material. For example, the first metal layers 5300 may be formed of at least a metal. Further, the first metal layers 5300 may be formed as a single layer or multiple layers.

The first metal layers 5300 may include a first-1 metal layer 5301 and a first-2 metal layer 5302.

The first-1 metal layer 5301 may be formed to fill the first-1 opening 5211 and may contact the first-1 semiconductor layer 5101. Thus, the first-1 metal layer 5301 may be electrically connected to the first-1 semiconductor layer 5101. In addition, the first-1 metal layer 5301 may further cover an upper surface of the first insulating layer 5200 adjacent to the first-1 opening 5211. That is, a cross-sectional area or width of an upper surface of the first-1 metal layer 5301 may be larger than a cross-sectional area or width of the first-1 opening 5211.

The first-2 metal layer 5302 may be formed to fill the first-2 opening 5212 and may contact the first ohmic electrode 5104. Thus, the first-2 metal layer 5302 may be electrically connected to the first ohmic electrode 5104 and the first-2 semiconductor layer 5103. Further, the first-2 metal layer 5302 may further cover an upper surface of the first insulating layer 5200 adjacent to the first-2 opening 5212. That is, a cross-sectional area or width of the upper surface of the first-2 metal layer 5302 may be larger than a cross-sectional area or width of the first-2 opening 5212.

When electricity is supplied to the first light emitting structure 5111 through the first-1 metal layer 5301 connected to the first-1 semiconductor layer 5101 and the first-2 metal layer 5302 connected to the first light emitting structure 5111, light can be emitted from the first light emitting structure 5111 by a current flow passing through the first light emitting structure 5111. However, since no current flow is created in the first buffer structures 5112, the first buffer structures 5112 may be kept in a non-emissive state even when electricity is supplied to the first light emitting source 5000.

The first base 1110 is not limited to the growth substrate. The first base 1110 may also be formed of a light transmissive material, such as silicone, epoxy, or the like. For example, after the first light emitting source 5000 is formed on the growth substrate, the growth substrate may be removed therefrom and the first light emitting source 5000 may be disposed on the first base 1110, which is a light transmissive material.

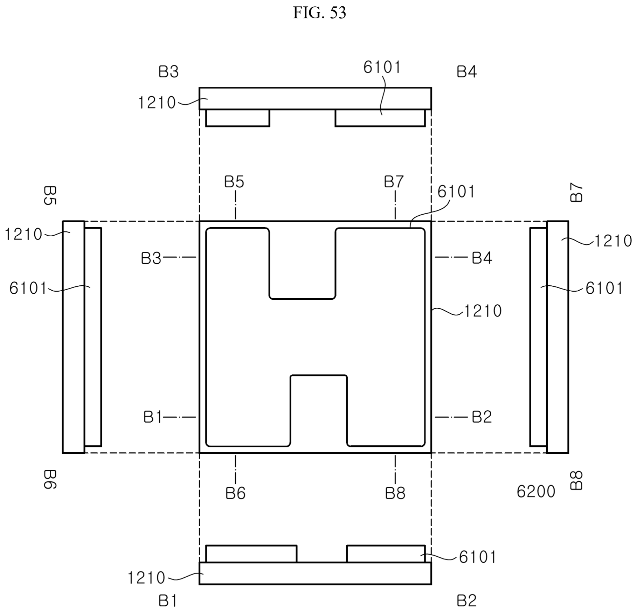

FIG. 53 to FIG. 57 are views of the second light emitting source 6000 of the pixel device 5001 of the fifth embodiment of the present disclosure and a manufacturing method thereof.

Referring to FIG. 53 to FIG. 57, the second light emitting source 6000 may be formed on a second base 1210. The second light emitting source 6000 may include a second semiconductor structure, a second ohmic electrode 6104, a second insulating layer 6200, and second metal layers 6300.

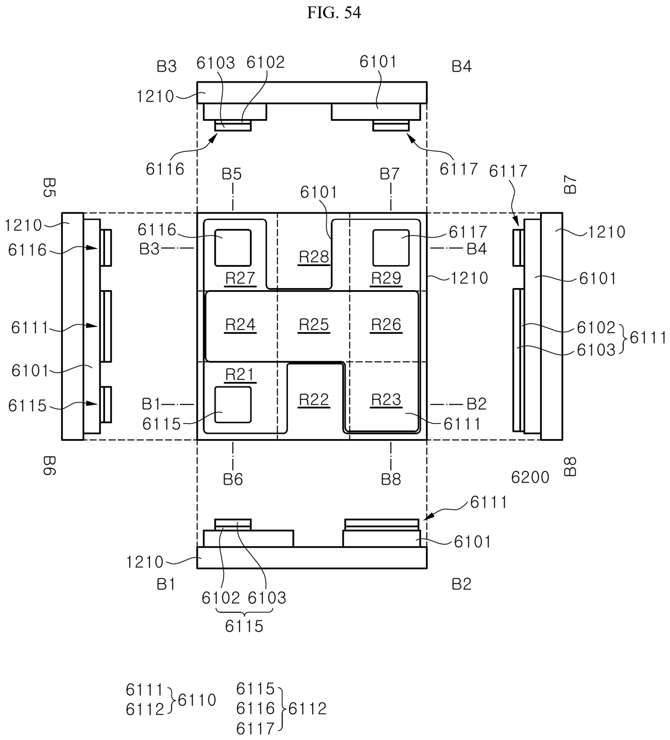

Referring to FIG. 53 and FIG. 54, the second semiconductor structure may be formed on the second base 1210. The second semiconductor structure may include a second-1 semiconductor layer 6101, a second active layer 6102, and a second-2 semiconductor layer 6103.

According to this embodiment, the second base 1210 may serve as a growth substrate that allows growth of semiconductor layers thereon. For example, the second base 1210 may include sapphire.

The semiconductor structure may be formed by metal organic chemical vapor deposition (MOCVD) or molecular beam epitaxy (MBE). The second semiconductor structure of the second light emitting source 6000 and the third semiconductor structure of the third light emitting source 7000 may be formed in the same manner.

The second-1 semiconductor layer 6101 may be an n-type conductive semiconductor layer and the second-2 semiconductor layer 6103 may be a p-type conductive semiconductor layer, or vice versa. For example, the second semiconductor structure may include a semiconductor material that emits blue light or green light, such as GaN, InGaN, AlGaN, InAlGaN, ZnSe, or the like.

Referring to FIG. 53, the second-1 semiconductor layer 6101 may be formed on the second base 1210. Here, as shown in FIG. 53, the second-1 semiconductor layer 6101 may be formed in a region excluding a region corresponding to an upper region of the first metal layer 5300 of the first light emitting source 5000 when the second light emitting source 6000 is disposed on the first light emitting source 5000.

Referring to FIG. 54, a second mesa structure 6110 including the second active layer 6102 and the second-2 semiconductor layer 6103 may be formed on the second-1 semiconductor layer 6101. The second mesa structure 6110 may cover a region of an upper surface of the second-1 semiconductor layer 6101 while exposing another region of the upper surface thereof. The second mesa structure 6110 may have a structure in which side surfaces of the second mesa structure are perpendicular or inclined to the upper surface of the second-1 semiconductor layer 6101.

The second mesa structure 6110 may include a second light emitting structure 6111 and second buffer structures 6112.

The second light emitting structure 6111 may act as a light emitting region that emits light when the pixel device 5001 or the second light emitting source 6000 is powered by electricity. However, the second buffer structures 6112 do not emit light even when the second light emitting source 6000 is powered by electricity. The second buffer structure 6112 may be spaced apart from the second light emitting structure 6111 to be kept in a non-emissive state regardless of light emission from the second light emitting structure 6111.

The second light emitting structure 6111 and the second buffer structures 6112 are formed in different regions. More specifically, the second buffer structures 6112 may be formed in regions in which the second light emitting structure 6111 is not formed. The second light emitting structure 6111 and the second buffer structures 6112 may be disposed on the same plane.

The second buffer structures 6112 may share the second light emitting structure 6111 and the second-1 semiconductor layer 6101. Thus, the second buffer structures 6112 may be electrically connected to an electrode electrically connected to the second-1 semiconductor layer 6101 of the second light emitting structure 6111 while maintaining a non-emissive state.

In another embodiment, the second buffer structures 6112 may be spaced apart from the second light emitting structure 6111, with a second transparent layer 8200 interposed between the second buffer structures 6112 and the second light emitting structure 6111. Thus, the second buffer structures 6112 may be electrically insulated from other structures and may be kept in a non-emissive state. Thus, the first transparent layer 8100 and the second transparent layer 8200 may contact each other in a region thereof, and the second transparent layer 8200 and the third transparent layer 8300 may contact each other in a region thereof.

Referring to FIG. 54, an upper surface of the second base 1210 may be divided into 9 regions. The nine regions may include second-1 to second-9 regions R21, R22, R23, R24, R25, R26, R27, R28, R29, similar to the structure shown in FIG. 48.

The second buffer structures 6112 may include a second-1 buffer structure 6115, a second-2 buffer structure 6116, and a second-3 buffer structure 6117. Referring to FIG. 54, the second-1 buffer structure 6115 may be formed in a second-1 region R21, the second-2 buffer structure 6116 may be formed in a second-7 region R27, and the second-3 buffer structure 6117 may be formed in a second-9 region R29. Here, when the second light emitting source 6000 is disposed on the first light emitting source 5000, the second-1 buffer structure 6115 may be disposed on the first-1 buffer structure 5115, the second-2 buffer structure 6116 may be disposed on the first-3 buffer structure 5117, and the second-3 buffer structure 6117 may be disposed on the first-4 buffer structure 5118.

The second-1 light emitting structure 6111 may be formed in regions, in which the second buffer structures 6112 are not formed, on the upper surface of the second-1 semiconductor layer 6101. That is, referring to FIG. 54, the second light emitting structure 6111 is formed in the second-3 region R23, the second-4 region R24, the second-5 region R25, and the second-6 region R26, in which regions of the second light emitting structure 6111 formed in these regions are connected to each other. That is, the second light emitting structure 6111 includes a plurality of regions extending in different directions from the second-5 region R25 at the center.

The second buffer structures 6112 and the second light emitting structure 6111 may be formed through the same etching process so as to have the same height.

In this embodiment, the second light emitting source 6000 includes a plurality of second buffer structures 6112 and a single second light emitting structure 6111. However, it should be understood that the second light emitting source 6000 is not limited thereto and may include a plurality of second light emitting structures 6111 or a single second buffer structure 6112.

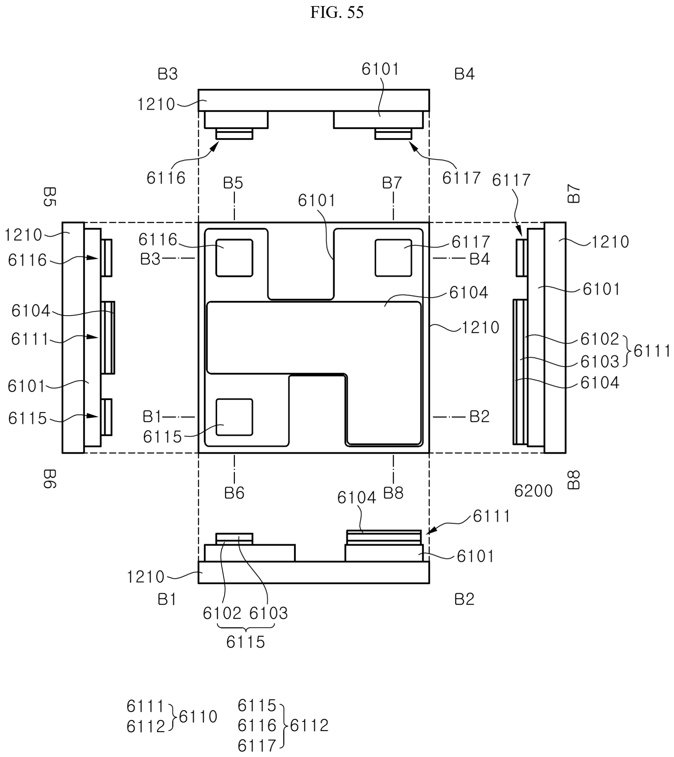

Referring to FIG. 55, the second ohmic electrode 6104 may be formed on the second light emitting structure 6111. More specifically, the second ohmic electrode 6104 may cover an upper surface of the second-2 semiconductor layer 6103 of the second light emitting structure 6111.

The second ohmic electrode 6104 may have high transmittance and high electrical conductivity with respect to light emitted from the second light emitting structure 6111. For example, the second ohmic electrode 6104 may be a transparent electrode. In addition, the second ohmic electrode 6104 may be formed of indium tin oxide (ITO). In this embodiment, the second light emitting structure 6111 may include not only the second active layer 6102 and the second-2 semiconductor layer 6103, but also the second ohmic electrode 6104. That is, the second mesa structure 6110 may also include the second ohmic electrode 6104.

Although the second ohmic electrode 6104 is shown as being formed only on the second-2 semiconductor layer 6103 of the second light emitting structure 6111 in FIG. 55, it should be understood that the present disclosure is not limited thereto. The second ohmic electrode 6104 may be formed not only on the second buffer structure 6112 but also on the second light emitting structure 6111.

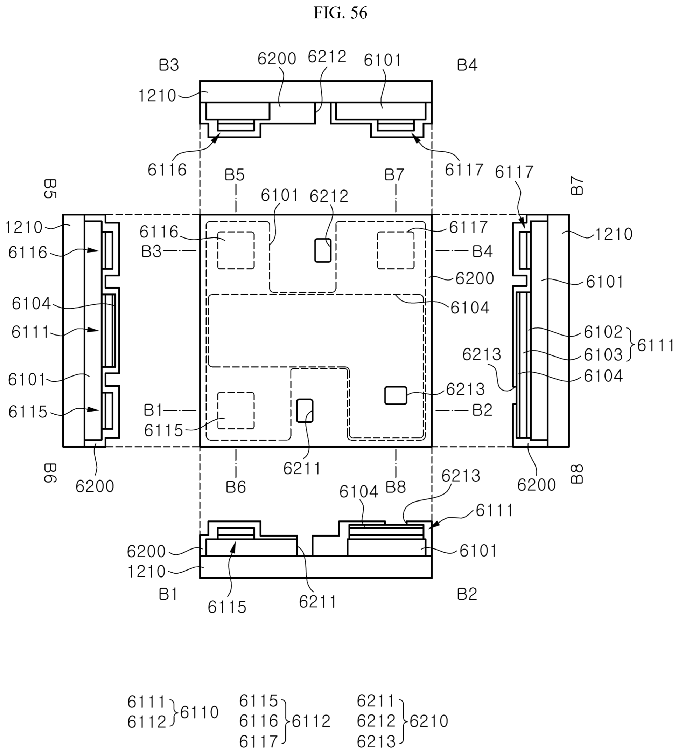

Referring to FIG. 56, the second insulating layer 6200 may be formed. The second insulating layer 6200 may cover the second mesa structure 6110 and the second-1 semiconductor layer 6101 exposed through the second mesa structure 6110.

The second insulating layer 6200 may be formed of a light transmissive material. For example, the second insulating layer 6200 may be formed of a silicon oxide, such as SiO₂, a silicon nitride, such as Si₃N₄, or a silicon oxynitride.

The second insulating layer 6200 may include second openings 6210. Further, the second opening 6210 may include a second-1 opening 6211, a second-2 opening 6212, and a second-3 opening 6213.

Referring to FIG. 56, the second-1 opening 6211 may be formed between side surfaces of the second-1 semiconductor layer 6101 and the second light emitting structure facing each other at a side of the second-1 buffer structure 6115. Further, the second-2 opening 6212 may be formed between side surfaces of the second-1 semiconductor layer 6101 facing each other at a side of the second-2 buffer structure 6116. That is, the second-1 opening 6211 and the second-2 opening 6212 may be formed in regions, in which the second semiconductor structure is not formed, to expose the upper surface of the second base 1210.

In addition, the second-1 opening 6211 may be formed to partially expose the side surface of the second-1 semiconductor layer 6101, as shown in FIG. 56.

When the second light emitting source 6000 is disposed on the first light emitting source 5000, the second-1 opening 6211 may be formed such that at least a region of the second-1 opening 6211 is disposed on the first-1 opening 5211 or on the first-1 metal layer 5301. Further, the second-2 opening 6212 may be formed such that at least a region of the second-2 opening 6212 is disposed on the first-2 opening 5211 or on the first-2 metal layer 5302.

The second-3 opening 6213 may be disposed on the second ohmic electrode 6104 of the second light emitting structure 6111. Thus, the second-3 opening 6213 may be formed to expose the upper surface of the second ohmic electrode 6104 of the second light emitting structure 6111. Further, when the second light emitting source 6000 is disposed on the first light emitting source 5000, the second-3 opening 6213 may be formed on the first-2 buffer structure 5116 of the first light emitting source 5000.

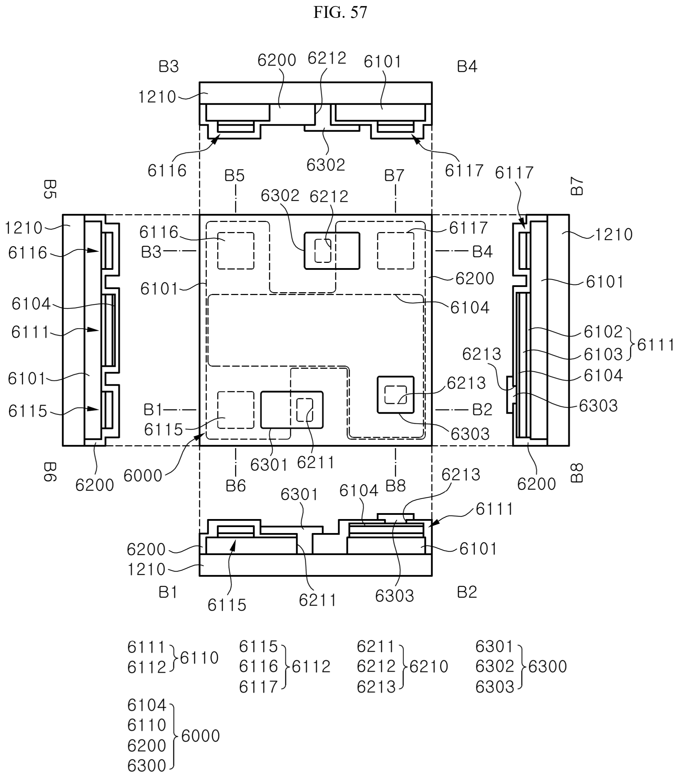

Referring to FIG. 57, the second metal layers 6300 may be formed. The second metal layer 6300 may be formed to fill the second opening 6210 of the second insulating layer 6200.

The second metal layers 6300 may be formed of a conductive material. For example, the second metal layers 6300 may be formed of at least a metal. Further, the second metal layer 6300 may be formed as a single layer or multiple layers.

The second metal layers 6300 may include a second-1 metal layer 6301, a second-2 metal layer 6302, and a second-3 metal layer 6303.

The second-1 metal layer 6301 may be formed to fill the second-1 opening 6211. Here, the second-1 metal layer 6301 may contact the second-1 semiconductor layer 6101 through the second-1 opening 6211 partially exposing a side surface of the second-1 semiconductor layer 6101. That is, the second-1 metal layer 6301 may be electrically connected to the second-1 semiconductor layer 6101. In addition, the second-1 metal layer 6301 may further cover an upper surface of the second insulating layer 6200 adjacent to the second-1 opening 6211. That is, a cross-sectional area or width of an upper surface of the second-1 metal layer 6301 may be greater than a cross-sectional area or width of the second-1 opening 6211.

The second-2 metal layer 6302 may be formed to fill the second-2 opening 6212. In addition, the second-2 metal layer 6302 may further cover the upper surface of the second insulating layer 6200 adjacent to the second-2 opening 6212. That is, a cross-sectional area or width of an upper surface of the second-2 metal layer 6302 may be greater than a cross-sectional area or width of the second-2 opening 6212.

The second-3 metal layer 6303 may be formed to fill the second-3 opening 6213. Here, the second-3 metal layer 6303 may contact the second ohmic electrode 6104. Thus, the second-3 metal layer 6303 may be electrically connected to the second ohmic electrode 6104 and the second-2 semiconductor layer 6103. In addition, the second-3 metal layer 6303 may further cover the upper surface of the second insulating layer 6200 adjacent to the second-3 opening 6213. That is, a cross-sectional area or width of an upper surface of the second-3 metal layer 6303 may be greater than a cross-sectional area or width of the second-3 opening 6213.

When electricity is supplied to the second light emitting structure 6111 through the second-1 metal layer 6301 connected to the second-1 semiconductor layer 6101 and the second-3 metal layer 6303 connected to the second light emitting structure 6111, light can be emitted from the second light emitting structure 6111. However, since no current flow is created in the second buffer structure 6112, the second buffer structure 6112 may be kept in a non-emissive state even when electricity is supplied to the second light emitting source 6000.

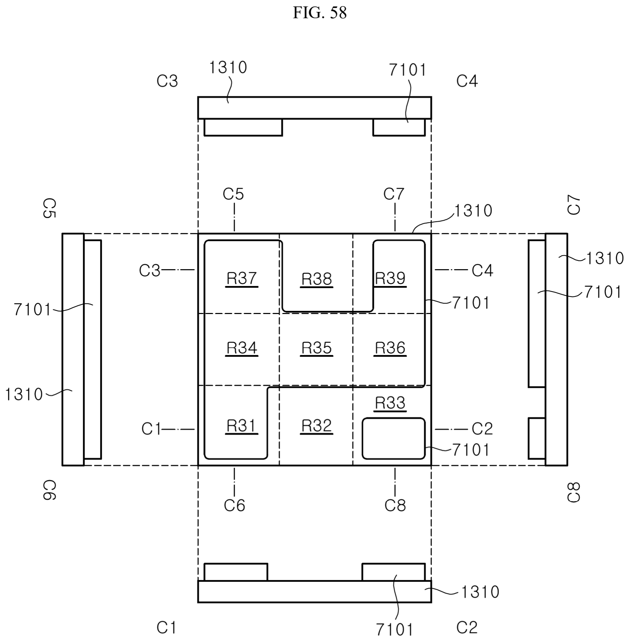

FIG. 58 to FIG. 62 are views of the third light emitting source 7000 of the pixel device 5001 of the fifth embodiment of the present disclosure and a manufacturing method thereof.

Referring to FIGS. 58 through 62, the third light emitting source 7000 may be formed on a third base 1310. The third light emitting source 7000 may include a third semiconductor structure, a third ohmic electrode 7104, a third insulating layer 7200, and third metal layers 7300.

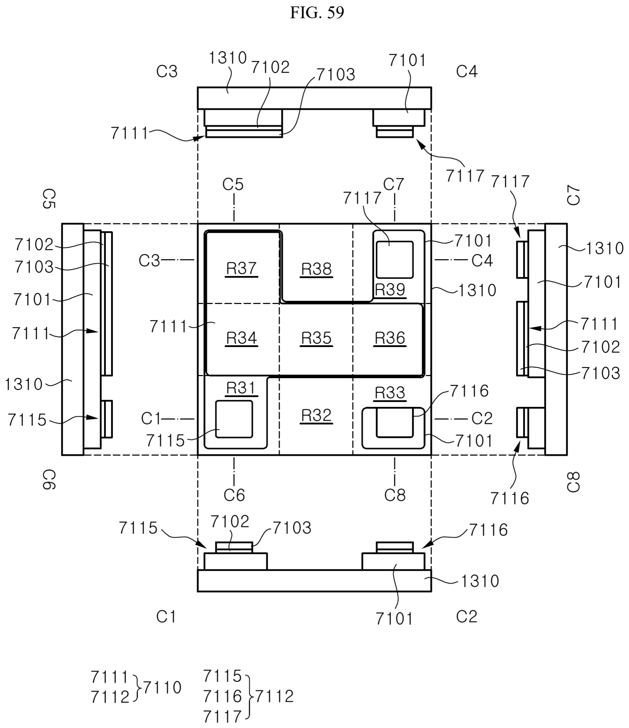

Referring to FIG. 58 and FIG. 59, the third semiconductor structure may be formed on the third base 1310. The third semiconductor structure may include a third-1 semiconductor layer 7101, a third active layer 7102, and a third-2 semiconductor layer 7103.

According to an embodiment, the third base 1310 may serve as a growth substrate that allows growth of semiconductor layers thereon. For example, the third base 1310 may include sapphire.

The third semiconductor structure may be formed by metal organic chemical vapor deposition (MOCVD) technology or molecular beam epitaxy (MBE) technology. The third semiconductor structure of the third light emitting source 7000 and the third semiconductor structure of the third light emitting source 7000 may be formed in the same manner.

The third-1 semiconductor layer 7101 may be an n-type conductive semiconductor layer and the third-2 semiconductor layer 7103 may be a p-type conductive semiconductor layer, or vice versa. For example, the third semiconductor structure may include a semiconductor material that emits red light, such as AlGaAs, GaAsP, AlGaInP, GaP, or the like.

Referring to FIG. 58, the third-1 semiconductor layer 7101 may be formed on the third base 1310. Here, as shown in FIG. 58, the third-1 semiconductor layer 7101 may be formed in a region excluding a region corresponding to an upper region of the first metal layer 5300 of the first light emitting source 5000 when the third light emitting source 7000 is disposed on the first light emitting source 5000 and the second light emitting source 6000.

Referring to FIG. 58 and FIG. 59, an upper surface of the third base 1310 may be divided into 9 regions. The nine regions may include third-1 to third-9 regions R31, R32, R33, R34, R35, R36, R37, R38, R39.

Referring to FIG. 58, the third-1 semiconductor layer 7101 is formed in a third-1 region R31, in third-4 to third-7 regions R34, R35, R36, R37, and in a third-9 region R39, in which regions of the third-1 semiconductor layers 7101 formed in these regions may be connected to each other. Further, the third-1 semiconductor layer 7101 may be formed on an inner surface of the third-3 region R33 to be spaced apart from other third-1 semiconductor layers 7101.

Referring to FIG. 59, a third mesa structure 7110 including the third active layer 7102 and the third-2 semiconductor layer 7103 may be formed on the third-1 semiconductor layer 7101. The third mesa structure 7110 may cover a region of an upper surface of the third-1 semiconductor layer 7101 while exposing another region of the upper surface thereof. The third mesa structure 7110 may have a structure in which side surfaces of the third mesa structure are perpendicular or inclined to the upper surface of the third-1 semiconductor layer 7101.

The third mesa structure 7110 may include a third light emitting structure 7111 and third buffer structures 7112.

The third light emitting structure 7111 may act as a light emitting region that emits light when the pixel device 5001 or the third light emitting source 7000 is powered by electricity. However, the third buffer structures 7112 do not emit light when the third light emitting source 7000 is powered by electricity. The third buffer structures 7112 may be spaced apart from the third light emitting structure 7111 to be kept in a non-emissive state regardless of light emission from the third light emitting structure 7111.

The third light emitting structure 7111 and the third buffer structures 7112 are formed in different regions. More specifically, the third buffer structures 7112 may be formed in a region in which the third light emitting structure 7111 is not formed. The third light emitting structure 7111 and the third buffer structures 7112 may be disposed on the same plane.

The third buffer structures 7112 may share the third light emitting structure 7111 and the third-1 semiconductor layer 7101. Thus, the third buffer structure 7112 may be electrically connected to an electrode electrically connected to the third-1 semiconductor layer 7101 of the third light emitting structure 7111 while maintaining a non-emissive state.

In another embodiment, the third buffer structures 7112 may be spaced apart from the third light emitting structure 7111, with a third transparent layer 8300 interposed between the third buffer structure 7112 and the third light emitting structure 7111. Thus, the third buffer structures 7112 may be electrically from other structures and may be kept in a non-emissive state. Thus, the third transparent layer 8300 and the second transparent layer 8200 may have contact each other in a region thereof.

The third buffer structures 7112 may include a third-1 buffer structure 7115, a third-2 buffer structure 7116, and a third-3 buffer structure 7117. Referring to FIG. 59, the third-1 buffer structure 7115 may be formed on an inner surface of the third-1 region R31, the third-2 buffer structure 7116 may be formed on an inner surface of the third-3 region R33, and the third-3 buffer structure 7117 may be formed on an inner surface of the third-9 region R39. Here, when the third light emitting source 7000 is disposed on the first light emitting source 5000 and the second light emitting source 6000, the third-1 buffer structure 7115 may be disposed on the first-1 buffer structure 5115 and the second-1 buffer structure 6115. In addition, the third-2 buffer structure 7116 may be disposed on the first-2 buffer structure 5116. Further, the third-3 buffer structure 7117 may be disposed on the first-4 buffer structure 5118 and the second-2 buffer structure.

The third light emitting structure 7111 may be formed in regions, in which the third buffer structures 7112 are not formed, on the upper surface of the third-1 semiconductor layer 7101. That is, referring to FIG. 59, the third light emitting structure 7111 is formed in the third-4 to third-7 regions R34, R35, R36, R37, in which regions of the third light emitting structures 7111 formed in these regions are connected to each other.

The third buffer structures 7112 and the third light emitting structure 7111 may be formed through the same etching process so as to have the same height.

In this embodiment, the third light emitting source 7000 includes a plurality of third buffer structures 7112 and a single third light emitting structures 7111. However, it should be understood that the third light emitting source 7000 is not limited thereto and may include a plurality of third light emitting structures 7111 or a single third buffer structures 7112.

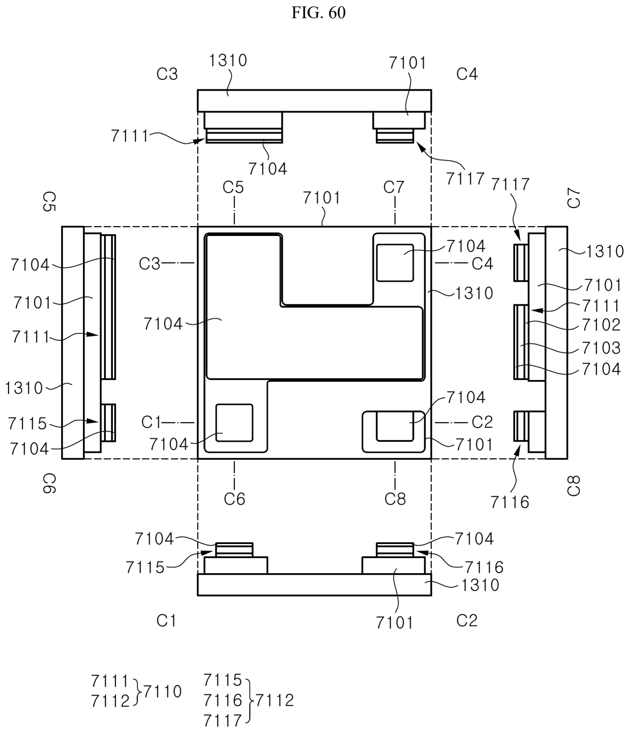

Referring to FIG. 60, the third ohmic electrode 7104 may be formed on the third mesa structure 7110. That is, the third ohmic electrode 7104 may cover the third-2 semiconductor layer 7103.

The third ohmic electrode 7104 may have high electrical conductivity. In addition, the third ohmic electrode 7104 may have high light transparency with respect to light emitted from the third light emitting structure 7111. For example, the third ohmic electrode 7104 may be a transparent electrode. In addition, the third ohmic electrode 7104 may be formed of indium tin oxide (ITO). In this embodiment, the third mesa structure 7110 may include not only the third active layer 7102 and the third-2 semiconductor layer 7103, but also the third ohmic electrode 7104.

Although FIG. 60 shows that the third ohmic electrode 7104 is formed on the entire upper surface of the third-2 semiconductor layer 7103, the third ohmic electrode 7104 may be omitted on the upper surface of the third-2 semiconductor layer 7103 of the third buffer structure 7112. That is, the third ohmic electrode 7104 may be formed only on the third-2 semiconductor layer 7103 of the third light emitting structure 7111.

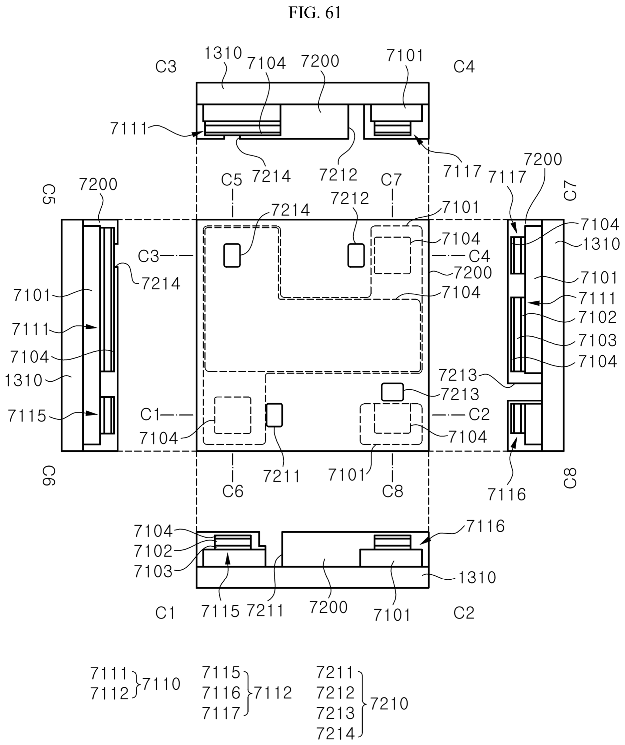

Referring to FIG. 61, the third insulating layer 7200 may be formed. The third insulating layer 7200 may cover the third mesa structure 7110 and the third-1 semiconductor layer 7101 exposed through the third mesa structure 7110.

The third insulating layer 7200 may be formed of a light transmissive material. For example, the third insulating layer 7200 may be formed of a silicon oxide, such as SiO₂, a silicon nitride, such as Si₃N₄, or a silicon oxynitride.

The third insulating layer 7200 may include third openings 7210. Further, the third openings 7210 may include a third-1 opening 7211, a third-2 opening 7212, a third-3 opening 7213, and a third-4 opening 7214.

Referring to FIG. 61, the third-1 opening 7211 may be formed between side surfaces of the third-1 semiconductor layer 7101 and the third light emitting structure facing each other at a side of the third-1 buffer structure 7115. Further, when the third light emitting source 7000 is disposed on the second light emitting source 6000, the third-1 opening 7211 may be formed such that at least a region of the third-1 opening 7211 is disposed on the second-1 opening 6211 or on the second-1 metal layer 6301. In addition, the third-1 opening 7211 may be formed to partially expose a side surface of the third-1 semiconductor layer 7101, as shown in FIG. 61.

The third-2 opening 7212 may be formed between side surfaces of the third-1 semiconductor layer 7101 facing each other at a side of the third-3 buffer structure 7117. Further, when the third light emitting source 7000 is disposed on the second light emitting source 6000, the third-2 opening 7212 may be formed such that at least a region of the third-2 opening 7212 is disposed on the second-2 opening 6212 or on the second-2 metal layer 6302.

The third-3 opening 7213 may be placed between side surfaces of the third-2 buffer structure 7116 and the third light emitting structure 7111 facing each other at a side of the third-2 buffer structure 7116. Further, when the third light emitting source 7000 is disposed on the second light emitting source 6000, the third-3 opening 7213 may be formed such that at least a region of the third-3 opening 7213 is disposed on the second-3 opening 6213 or on the second-3 metal layer 6303.

As such, the third-1 to third-3 openings 7211, 7212, 7213 may be formed in regions, in which the third semiconductor structure is not formed, to expose the upper surface of the third base 1310.

The third-4 opening 7214 may be disposed on the third ohmic electrode 7104 of the third light emitting structure 7111. Thus, the third-4 opening 7214 may be formed to expose the upper surface of the third ohmic electrode 7104 of the third light emitting structure 7111. In addition, when the third light emitting source 7000 is disposed on the first light emitting source 5000 and the second light emitting source 6000, the third-4 opening 7214 may be formed on the first-3 buffer structure 5117 or on the second-2 buffer structure 6116.

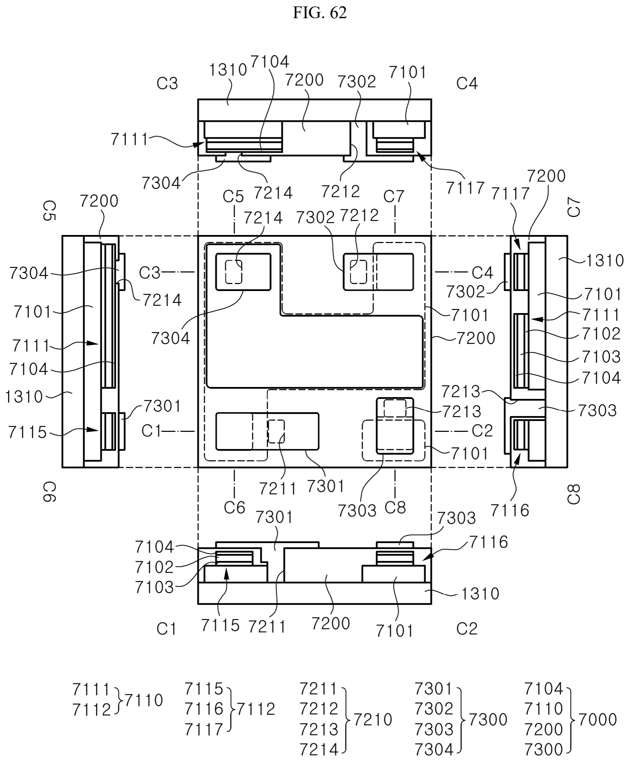

Referring to FIG. 62, the third metal layers 7300 may be formed. The third metal layers 7300 may be formed to fill the third openings 7210 of the third insulating layer 7200.

The third metal layer 7300 may be formed of a conductive material. For example, the third metal layer 7300 may be formed of at least a metal. Further, the third metal layer 7300 may be formed as a single layer or multiple layers.

The third metal layer 7300 may include a third-1 metal layer 7301, a third-2 metal layer 7302, a third-3 metal layer 7303, and a third-4 metal layer 7304.

The third-1 metal layer 7301 may be formed to fill the third-1 opening 7211. Here, since the third-1 opening 7211 partially exposes a side surface of the third-1 semiconductor layer 7101, the third-1 metal layer 7301 may contact the third-1 semiconductor layer 7101. That is, the third-1 metal layer 7301 may be electrically connected to the third-1 semiconductor layer 7101. Further, the third-1 metal layer 7301 may further cover an upper surface of the third insulating layer 7200 adjacent to the third-1 opening 7211. That is, a cross-sectional area or width of an upper surface of the third-1 metal layer 7301 may be greater than a cross-sectional area or width of the third-1 opening 7211.

The third-2 metal layer 7302 may be formed to fill the third-2 opening 7212. In addition, the third-2 metal layer 7302 may further cover the upper surface of the third insulating layer 7200 adjacent to the third-2 opening 7212. That is, a cross-sectional area or width of an upper surface of the third-2 metal layer 7302 may be greater than a cross-sectional area or width of the third-2 opening 7212.

The third-3 metal layer 7303 may be formed to fill the third-3 opening 7213. In addition, the third-3 metal layer 7303 may further cover the upper surface of the third insulating layer 7200 adjacent to the third-3 opening 7213. Thus, a cross-sectional area or width of an upper surface of the third-3 metal layer 7303 may be greater than a cross-sectional area or width of the third-3 opening 7213.

The third-4 metal layer 7304 may be formed to fill the third-4 opening 7214. Here, the third-4 metal layer 7304 may contact the third ohmic electrode 7104. Thus, the third-4 metal layer 7304 may be electrically connected to the third ohmic electrode 7104 and the third-2 semiconductor layer 7103. In addition, the third-4 metal layer 7304 may further cover the upper surface of the third insulating layer 7200 adjacent to the third-4 opening 7214. That is, a cross-sectional area or width of an upper surface of the third-4 metal layer 7304 may be greater than a cross-sectional area or width of the third-4 opening 7214.

When electricity is supplied to the third light emitting structure 7111 through the third-1 metal layer 7301 connected to the third-1 semiconductor layer 7101 and the third-4 metal layer 7304 connected to the third light emitting structure 7111, light can be emitted from the third light emitting structure 7111. However, since no current flow is created in the third buffer structure 7112, the third buffer structure 7112 may be kept in a non-emissive state even when electricity is supplied to the third light emitting source 7000.

As such, when the first to third light emitting sources 5000, 6000, 7000 are individually formed, the second light emitting source 6000 and the third light emitting source 7000 may be stacked on the first light emitting source 5000 to form the pixel device 5001.

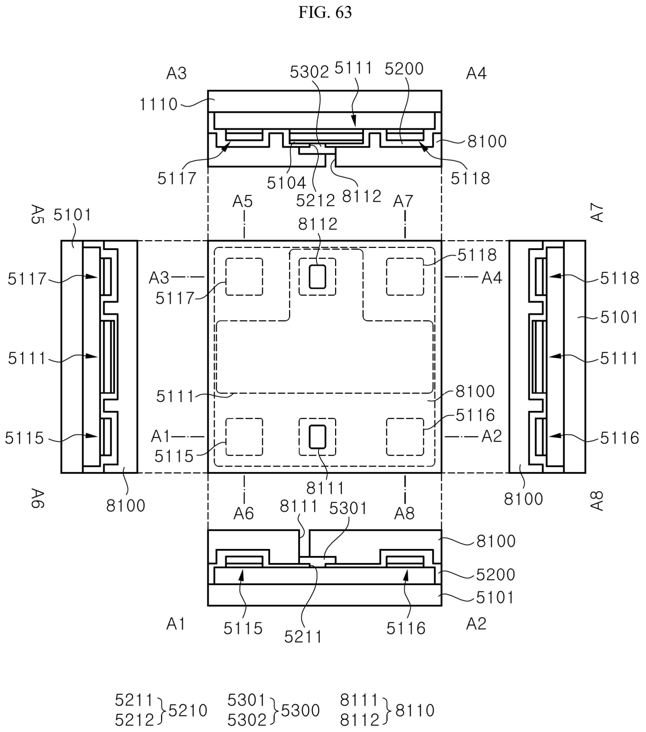

Referring to FIG. 63, a first transparent layer 8100 may be formed on the first light emitting source 5000.

The first transparent layer 8100 may cover the first light emitting source 5000 and the first metal layer 5300.

The first transparent layer 8100 may be formed of an insulating light transmissive material. For example, the first transparent layer 8100 may be formed of the same material as the first insulating layer 5200. Further, the first transparent layer 8100 may exhibit adhesive strength. Accordingly, when the second light emitting source 6000 is stacked on the first light emitting source 5000, the second light emitting source 6000 may be secured to the first light emitting source 5000 by adhesive strength of the first transparent layer 8100.

The first transparent layer 8100 may include a flat upper surface.

A typical pixel device forms a light emitting structure only in a light emitting region and does not form the light emitting structure in a non-light emitting region. That is, the non-light emitting region of the typical pixel device may be a region formed with a structure having a lower height than the light emitting region in which the light emitting structure is formed, or a region in which the light emitting structure is omitted. Accordingly, in formation of a transparent layer covering an upper surface of a light emitting source for stacking another light emitting source on the light emitting source, there is difficulty forming a flat upper surface of the transparent layer due to a difference in height of the structures between the non-light emitting region and the light emitting region. For example, an upper surface of a region of the transparent layer in the light emitting region may be higher than an upper surface of a region thereof in the non-light emitting region. In this case, when another light emitting source is stacked on the transparent layer covering the light emitting source, the other light emitting source cannot be adhered to the transparent layer or can be easily delaminated therefrom by external impact.

Referring to FIG. 63, the first buffer structures 5112 in an insulated state are formed in the regions in which the first light emitting structure 5111 and the first metal layers 5300 are not disposed. In addition, the first buffer structures 5112 are formed to have the same or similar height to the first light emitting structure 5111. That is, in the first light emitting source 5000 according to this embodiment, the first light emitting structure 5111 is formed in the light emitting region and the first buffer structures 5112 having a similar height to the first light emitting structure 5111 are distributed in the non-light emitting region. Thus, the first light emitting source 5000 has a structure in which structures with similar heights are distributed over the entire region.

Thus, the first buffer structures 5112 allow the first transparent layer 8100 to be easily formed on the first light emitting source 5000 to include a flat upper surface, with the same height or a minimal height difference between the light emitting region and the non-light emitting region. Accordingly, when the second light emitting source 6000 is stacked on the upper surface of the first transparent layer 8100, the second light emitting source 6000 can be prevented from tilting, thereby enabling stable stacking and bonding.

After the first transparent layer 8100 is formed on the first light emitting source 5000, fourth openings 8110 may be formed in the first transparent layer 8100. The fourth openings 8110 may include a fourth-1 opening 8111 and a fourth-2 opening 8112.

The fourth-1 opening 8111 may be formed on the first-1 metal layer 5301 to expose at least a region of the upper surface of the first-1 metal layer 5301. Here, the fourth openings 8111 may include a region in which the first-1 metal layer 5301 overlaps the second-1 metal layer 6301 with reference to the vertical line when the second light emitting source 6000 is stacked on the first light emitting source 5000.

Further, the fourth-2 opening 8112 may be formed on the first-2 metal layer 5302 to expose at least a region of the upper surface of the first-2 metal layer 5302. Here, the fourth-2 opening 8112 may include a region in which the first-2 metal layer 5302 overlaps the second-2 metal layer 6302 with reference to the vertical line when the second light emitting source 6000 is stacked on the first light emitting source 5000.

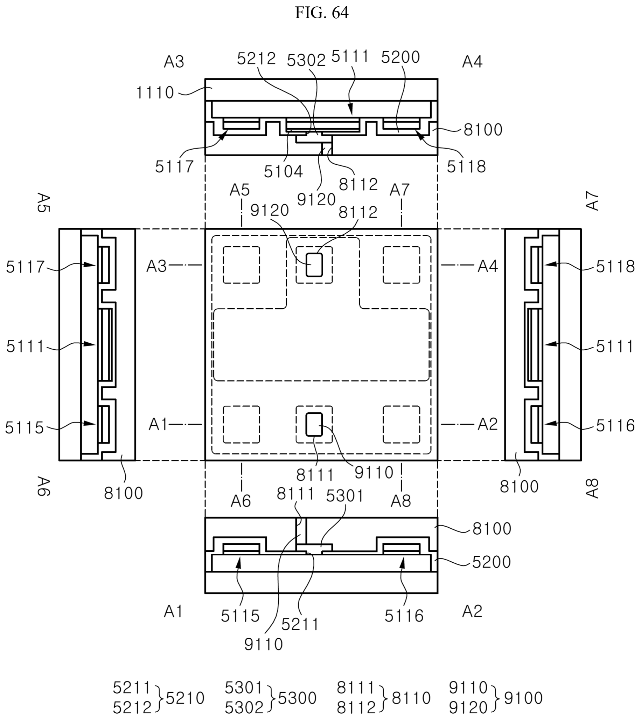

Referring to FIG. 64, a first connection metal layer 9100 may be formed to fill the fourth openings 8110 of the first transparent layer 8100. The first connection metal layer 9100 may include a first-1 connection metal layer 9110 and a first-2 connection metal layer 9120.

The first-1connection metal layer 9110 may be formed to fill the fourth-1 opening 8111. Here, a lower surface of the first-1 connection metal layer 9110 contacts the upper surface of the first-1 metal layer 5301, which may be coplanar with the upper surface of the first transparent layer 8100.

In addition, the first-2 connection metal layer 9120 may be formed to fill the fourth-2 opening 8112. Here, a lower surface of the first-2 connection metal layer 9120 contacts the upper surface of the first-2 metal layer 5302, which may be coplanar with the upper surface of the first transparent layer 8100.

The first connection metal layer 9100 may be formed of a conductive material. For example, the first connection metal layer 9100 may be formed of at least a metal. Alternatively, the first connection metal layer 9100 may be formed of a conductive paste. Further, the first connection metal layer 9100 may be formed as a single layer or multiple layers.

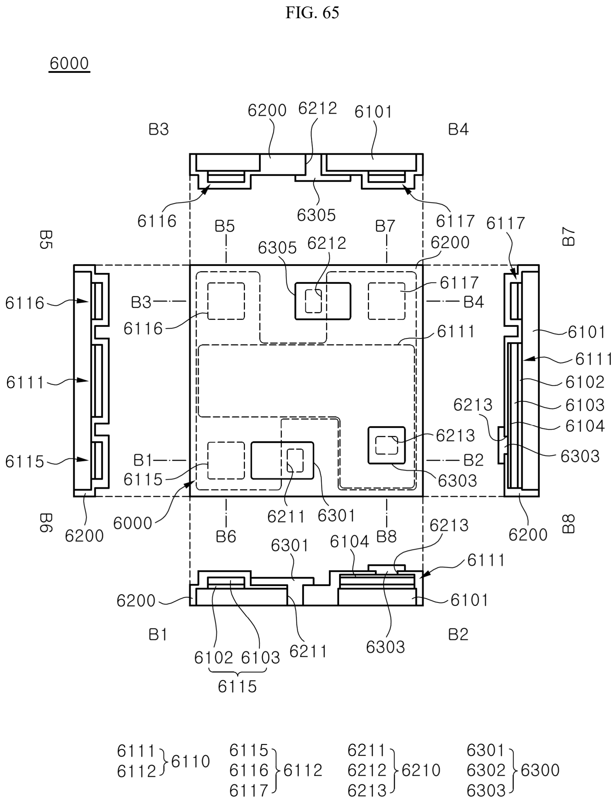

Referring to FIG. 65, the second base 1210 may be removed from a lower surface of the second light emitting source 6000.

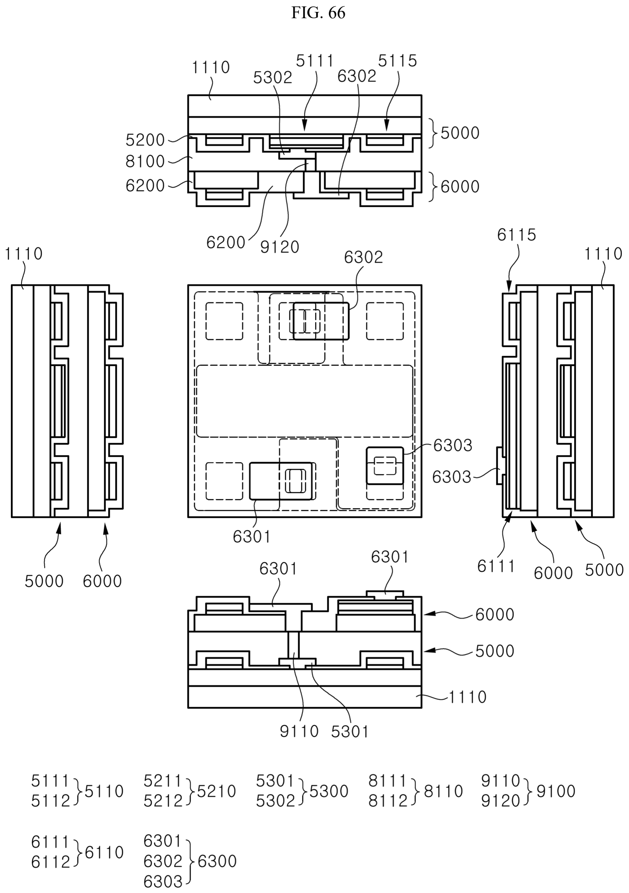

Referring to FIG. 66, the second light emitting source 6000 may be stacked on the first light emitting source 5000.

The second light emitting source 6000 may be stacked on the upper surface of the first transparent layer 8100 formed on the first light emitting source 5000. The upper surface of the first transparent layer 8100 has a flat structure. In addition, an upper surface of the first connection metal layer 9100 exposed on the upper surface of the first transparent layer 8100 is also coplanar with the upper surface of the first transparent layer 8100. Accordingly, the second light emitting source 6000 can be stably stacked on a flat surface composed of the first transparent layer 8100 and the first connection metal layer 9100.

In addition, the second light emitting source 6000 may be kept in a stacked structure on the first light emitting source 5000 by adhesive strength of the first transparent layer 8100.

When the second light emitting source 6000 is stacked on the first light emitting source 5000, the upper surface of the first-1 connection metal layer 9110 may partially or completely contact a lower surface of the second-1 metal layer 6301 of the second light emitting source 6000. Thus, the first-1 metal layer 5301 of the first light emitting source 5000 and the second-1 metal layer 6301 of the second light emitting source 6000 may be electrically connected to each other by the first-1 connection metal layer 9110.

Further, an upper surface of the first-2 connection metal layer 9120 may partially or completely contact a lower surface of the second-2 metal layer 6302 of the second light emitting source 6000. Thus, the first-2 metal layer 5302 of the first light emitting source 5000 and the second-2 metal layer 6302 of the second light emitting source 6000 may be electrically connected to each other by the first-2 connection metal layer 9120.

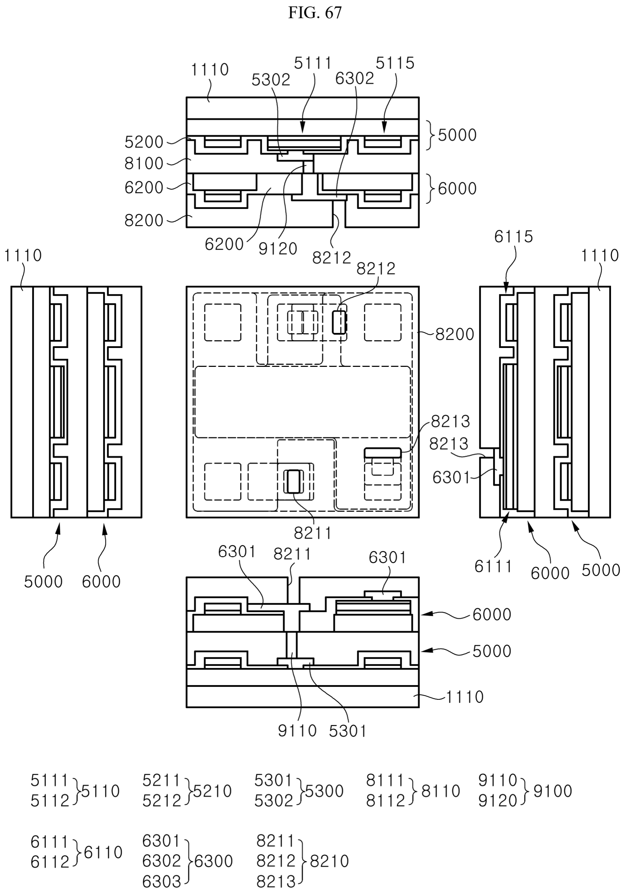

Referring to FIG. 67, a second transparent layer 8200 may be formed on the second light emitting source 6000.

The second transparent layer 8200 may cover the second light emitting source 6000 and the second metal layer 6300. The second transparent layer 8200 may include a flat upper surface.

The second transparent layer 8200 may be formed of an insulating light transmissive material. For example, the second transparent layer 8200 may be formed of the same material as the second insulating layer 6200. Further, the second transparent layer 8200 may exhibit adhesive strength. Accordingly, when the third light emitting source 7000 is stacked on the second light emitting source 6000, the third light emitting source 7000 may be secured to the second light emitting source 6000 by adhesive strength of the second transparent layer 8200.

According to this embodiment, the second light emitting structure 6111 is disposed in the light emitting region of the second light emitting source 6000 and the second buffer structures 6112 are distributed in the non-light emitting region. Thus, the second light emitting source 6000 has a structure in which structures with similar heights are distributed over the entire region. When the second transparent layer 8200 is formed to cover the second light emitting source 6000, the second buffer structures 6112 allow the non-light emitting region to be formed to have a similar height to the light emitting region. That is, the second buffer structures 6112 allow the second transparent layer 8200 having a flat upper surface to be easily formed.

After the second transparent layer 8200 is formed on the second light emitting source 6000, fifth openings 8120 may be formed in the second transparent layer 8200. The fifth opening 8120 may include a first opening 8121, a second opening 8122, and a third opening 8122.

The fifth-1 opening 8121 may be formed on the second-1 metal layer 6301 to expose at least a region of the upper surface of the second-1 metal layer 6301. Here, the fifth openings 8121 may be formed to include a region in which the second-1 metal layer 6301 overlaps the third-1 metal layer 7301 with reference to the vertical line when the third light emitting source 7000 is stacked on the second light emitting source 6000.

Further, the fifth-2 opening 8122 may be formed on the second-2 metal layer 6302 to expose at least a region of the upper surface of the second-2 metal layer 6302. Here, the fifth-2 opening 8122 may be formed to include a region in which the second-2 metal layer 6302 overlaps the third-2 metal layer 7302 with reference to the vertical line when the third light emitting source 7000 is stacked on the second light emitting source 6000.

Further, the fifth-3 opening 8123 may be formed on the second-3 metal layer 6303 to expose at least a region of the upper surface of the second-3 metal layer 6303. Here, the fifththird opening 8123 may be formed to include a region in which the second-third metal layer 6303 overlaps the third-third metal layer 7303 with reference to the vertical line when the third light emitting source 7000 is stacked on the second light emitting source 6000.

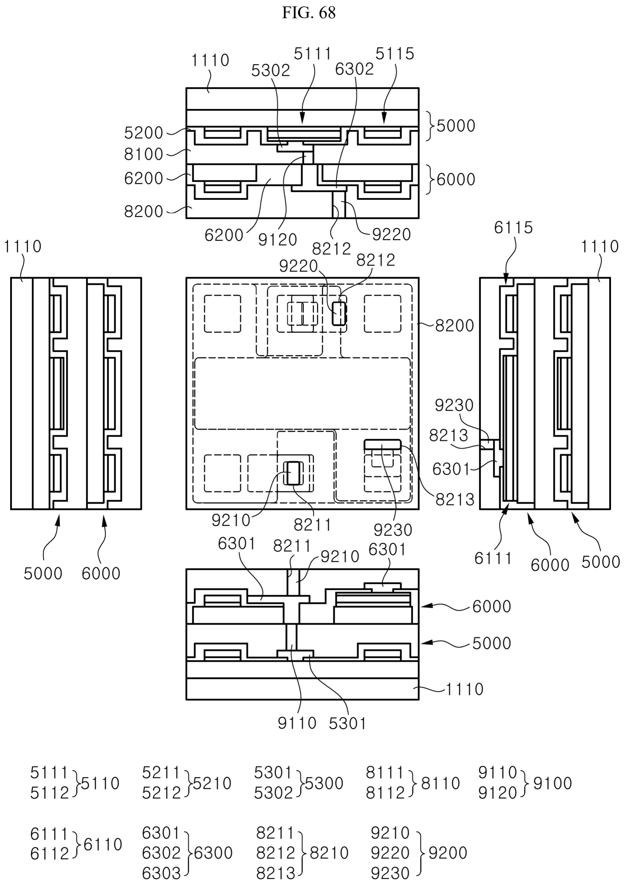

Referring to FIG. 68, a second connected metal layer 9200 may be formed to fill the fifth openings 8120 of the second transparent layer 8200.

The second connection metal layer 9200 may include a second-1 connection metal layer 9210, a second-2 connection metal layer 9220, and a second-3 connection metal layer 9230.

The second-1 connection metal layer 9210 may be formed to fill the fifth-1 opening 8121. Here, a lower surface of the second-1 connection metal layer 9210 contacts the upper surface of the second-1 metal layer 6301, which may be coplanar with an upper surface of the second transparent layer 8200.

In addition, the second-2 connection metal layer 9220 may be formed to fill the fifth-2 opening 8122. Here, a lower surface of the second-2 connection metal layer 9220 contacts the upper surface of the second-2 metal layer 6302, which may be coplanar with the upper surface of the second transparent layer 8200.

Further, the second-3 connection metal layer 9230 may be formed to fill the fifth-3 opening 8123. Here, a lower surface of the second-3 connection metal layer 9230 contacts an upper surface of the second-3 metal layer 6303, which may be coplanar with the upper surface of the second transparent layer 8200.

The second connection metal layer 9200 may be formed of a conductive material. For example, the second connection metal layer 9200 may be formed of at least a metal. Alternatively, the second connection metal layer 9200 may be formed of a conductive paste. Further, the second connection metal layer 9200 may be formed as a single layer or multiple layers.

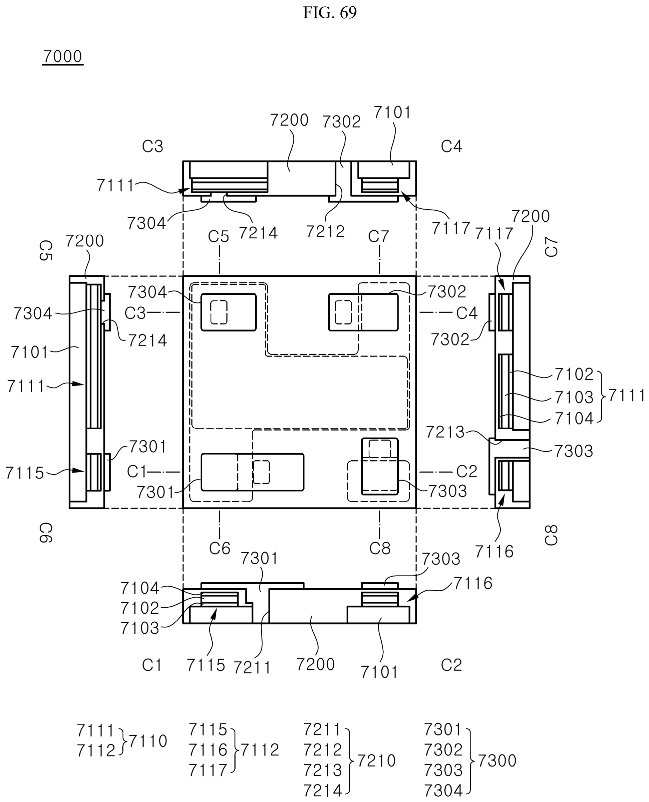

Referring to FIG. 69, the third base 1310 may be removed from a lower surface of the third light emitting source 7000.

Referring to FIG. 70, the third light emitting source 7000 may be stacked on the second light emitting source 6000.

The third light emitting source 7000 may be stacked on the upper surface of the second transparent layer 8200 formed on an upper surface of the second light emitting source 6000. The upper surface of the second transparent layer 8200 has a flat structure. Furthermore, the upper surface of the second connection metal layer 9200 exposed on the upper surface of the second transparent layer 8200 is also placed on the same line as the upper surface of the second transparent layer 8200. Accordingly, the third light emitting source 7000 can be stably stacked on the flat surface including the second transparent layer 8200 and the second connection metal layer 9200.

Further, the third light emitting source 7000 may be kept in a stacked structure on the second light emitting source 6000 by adhesive strength of the second transparent layer 8200.

When the third light emitting source 7000 is stacked on the second light emitting source 6000, an upper surface of the second-1 connection metal layer 9210 may partially or completely contact a lower surface of the third-1 metal layer 7301 of the third light emitting source 7000. Thus, the second-1 metal layer 6301 of the second light emitting source 6000 and the third-1 metal layer 7301 of the third light emitting source 7000 may be electrically connected to each other by the second-1 connection metal layer 9210.

Further, an upper surface of the second-2 connection metal layer 9220 may partially or completely contact a lower surface of the third-2 metal layer 7302 of the third light emitting source 7000. Thus, the second-2 metal layer 6302 of the second light emitting source 6000 and the third-2 metal layer 7302 of the third light emitting source 7000 may be electrically connected to each other by the second-2 connection metal layer 9220.

Further, an upper surface of the second-3 connection metal layer 9230 may partially completely contact a lower surface of the third-3 metal layer 7303 of the third light emitting source 7000. Thus, the second-3 metal layer 6303 of the second light emitting source 6000 and the third-2 metal layer 7302 of the third light emitting source 7000 may be electrically connected to each other by the second-3 connection metal layer 9230.

As such, the pixel device 5001 according to the fifth embodiment of the present disclosure may be formed through the sequence of FIG. 48 to FIG. 71.

Referring to FIG. 70, the first-1 metal layer 5301 may be electrically connected to the first-1 semiconductor layer 5101, the second-1 metal layer 6301 may be electrically connected to the second-1 semiconductor layer 6101, and the third-1 metal layer 7301 may be electrically connected to the third-1 semiconductor layer 7101. Further, the first-1 metal layer 5301, the second-1 metal layer 6301, and the third-1 metal layer 7301 may be electrically connected to one another by the first-1 connection metal layer 9110 and the second-1 connection metal layer 9210. That is, the first-1 metal layer 5301, the second-1 metal layer 6301, the third-1 metal layer 7301, the first-1 connection metal layer 9110, and the second-1 connection metal layer 9210 may be common electrodes of the pixel device 5001. In addition, the upper side or upper surface of the third-1 metal layer 7301 may become a common electrode pad of the pixel device 5001 that is electrically connected to the first semiconductor layers of the first light emitting source 5000, the second light emitting source 6000, and the third light emitting source 7000.

The first-2 metal layer 5302 of the first light emitting source 5000, which is electrically connected to the first-2 semiconductor layer 5103 through the first ohmic electrode 5104, is electrically connected to the second-2 metal layer 6302 of the second light emitting source 6000 through the first-2 connection metal layer 9120, and the second-2 metal layer 6302 thereof is electrically connected to the third-2 metal layer 7302 through the second-2 connection metal layer 9220. Here, the second-2 metal layer 6302 is insulated from the second light emitting source 6000 and the third-2 metal layer 7302 is insulated from the third light emitting source 7000. As a result, the second-2 electrode, the third-2 metal layer 7302, the first-2 connection metal layer 9120, and the second-2 connection metal layer 9220 may be electrically connected to the first-2 semiconductor layer 5103 of the first light emitting source 5000 to become electrodes for operation of the first light emitting source 5000. Further, the upper side or upper surface of the third-2 metal layer 7302 may become an electrode pad to which electricity is applied to operate the first light emitting source 5000. Accordingly, when electricity is supplied to the pixel device 5001 through the third-2 metal layer 7302, the first light emitting source 5000 may be operated to emit green light or blue light.

The second-3 metal layer 6303 of the second light emitting source 6000, which is electrically connected to the second-2 semiconductor layer 6103 through the second ohmic electrode 6104, is electrically connected to the third-3 metal layer 7303 of the third light emitting source 7000 through the second-3 connection metal layer 9230. Here, the third-3 metal layer 7303 is in an insulated state from the third light emitting source 7000. That is, the second-3 metal layer 6303, the third-3 metal layer 7303, and the second-3 connection metal layer 9230 are electrically connected to the second-2 semiconductor layer 6103 of the second light emitting source 6000 and may become electrodes for operation of the second light emitting source 6000. Further, the upper side or upper surface of the third-3 metal layer 7303 may become an electrode pad to which electricity is applied to operate the second light emitting source 6000. Accordingly, when electricity is supplied to the pixel device 5001 through the third-3 metal layer 7303, the second light emitting source 6000 may be operated to emit blue light or green light.

The third-4 metal layer 7304 of the third light emitting source 7000 electrically connected to the third-2 semiconductor layer 7103 through the third ohmic electrode 7104 may become an electrode for operation of the third light emitting source 7000. Further, the upper side or upper surface of the third-4 metal layer 7304 may become an electrode pad to which electricity is applied to operate the third light emitting source 7000. Accordingly, when electricity is supplied to the pixel device 5001 through the third-4 metal layer 7304, the third light emitting source 7000 may be operated to emit red light.

Referring to FIG. 70, the pixel device 5001 may include the first light emitting structure 5111, the second light emitting structure 6111, and the third light emitting structure 7111 all stacked in a central region thereof. Further, the first buffer structures 5112, the second buffer structures 6112, and the third buffer structures 7112 are disposed in an outer region of the central region in which the first light emitting structure 5111, the second light emitting structure 6111, and the third light emitting structure 7111 are stacked.

By further forming the buffer structures in the non-light emitting region, the pixel device 5001 according to this embodiment may allow a component, such as the transparent layer disposed between the light emitting sources, to be formed in a flat structure. Thus, by forming the transparent layer to have a flat upper surface, it is possible to prevent delamination between the transparent layer and the light emitting source disposed thereon. That is, it is possible to prevent delamination between the components constituting the pixel device 5001. Furthermore, the buffer structures can prevent a light emitting source placed at a lower side from being bent due to the weight of a light emitting source placed at an upper side. That is, the pixel device 5001 can be prevented from being bent. As such, the buffer structures of the pixel device 5001 according to this embodiment can prevent deformation of the pixel device 5001, thereby improving reliability of the pixel device 5001.

Referring to FIG. 71, a protective layer 8300 may be further formed on the third light emitting source 7000.

The protective layer 8300 may cover the third insulating layer 7200 of the third light emitting source 7000. Further, the protective layer 8300 may cover a side surface of the third metal layer 7300 while exposing an upper surface of the third metal layer 7300. The exposed third metal layer 7300 may become a region electrically connected to an external device.

The protective layer 8300 may be formed of an insulating material. Further, the protective layer 8300 may be formed of an insulating material reflecting light or may be formed of an insulating material including a light reflective material. However, the protective layer 8300 is not essentially formed of the light reflective material and may be formed of a light transmissive material, as needed.

The numbers of first buffer structures 5112, second buffer structures 6112, and third buffer structures 7112 disposed on each plane may be different. Alternatively, the numbers of first buffer structures 5112, second buffer structures 6112, or third buffer structures 7112 disposed on two different planes may be the same or different. The number of first buffer structures 5112 may be the same as or different from the number of second buffer structures 6112, the number of first buffer structures 5112 may be the same as or different from the number of third buffer structures 7112, and the number of second buffer structures 6112 may be the same as or different from the number of third buffer structures 7112.

The first buffer structure 5112, the second buffer structure 6112, or the third buffer structure 7112 may be surrounded by an insulating material.

Although some embodiments have been described herein with reference to the accompanying drawings, it should be understood that the foregoing embodiments are provided for illustration only and are not to be in any way construed as limiting the technical idea of the present disclosure. The scope of the present disclosure should be defined by the appended claims and equivalents thereto.

## Claims

1. A pixel device comprising:
a first light emitting source comprising a first light emitting structure formed by stacking a first-1 semiconductor layer, a first active layer, and a first-2 semiconductor layer;
a second light emitting source formed on the first light emitting source and comprising a second light emitting structure formed by stacking a second-1 semiconductor layer, a second active layer, and a second-2 semiconductor layer; and
a third light emitting source formed on the second light emitting source and comprising a third light emitting structure formed by stacking a third-1 semiconductor layer, a third active layer, and a third-2 semiconductor layer;
a common electrode electrically connected to the first-1 semiconductor layer, the second-1 semiconductor layer, and the third-1 semiconductor layer;
a first electrode electrically connected to the first-2 semiconductor layer;
a second electrode electrically connected to the second-2 semiconductor layer; and
a third electrode electrically connected to the third-2 semiconductor layer;
wherein the common electrode, the first electrode, the second electrode, and the third electrode are spaced apart from one another, and
the common electrode and the first electrode are formed along a side surface of the second-1 semiconductor layer and a side surface of the third-1 semiconductor layer to form a stepped structure.

2. The pixel device according to claim 1, wherein the first light emitting source, the second light emitting source, and the third light emitting source emit different colors of visible light.

3. The pixel device according to claim 1, further comprising:
a first transparent layer formed between the first light emitting source and the second light emitting source; and
a second transparent layer formed between the second light emitting source and the third light emitting source.

4. The pixel device according to claim 3, wherein
the common electrode is formed through the first transparent layer and the second transparent layer to be electrically connected to the second-1 semiconductor layer and the first-1 semiconductor layer,
the first electrode is formed through the first transparent layer and the second transparent layer to be electrically connected to the first-2 semiconductor layer, and
the second electrode is formed through the second transparent layer to be electrically connected to the second-2 semiconductor layer.

5. The pixel device according to claim 1, wherein each of the common electrode and the first electrode is placed on a vertical line on which a central axis of a region thereof formed on the first light emitting source, a central axis of a region thereof formed on the second light emitting source, and a central axis of a region thereof formed on the third light emitting source are different from one another.

6. The pixel device according to claim 3, wherein
the first light emitting source further comprises a first insulating layer covering the first light emitting structure,
the second light emitting source further comprises a second insulating layer covering the second light emitting structure,
the third light emitting source further comprises a third insulating layer covering the third light emitting structure.

7. The pixel device according to claim 6, wherein common electrode comprises:
a first-1 metal layer electrically connected to the first-1 semiconductor layer;
a second-1 metal layer electrically connected to the second-1 semiconductor layer; and
a third-1 metal layer electrically connected to the third-1 semiconductor layer,
the second-1 metal layer is formed from an upper surface of the first-1 metal layer to an upper surface of the second-1 semiconductor layer along an inner surface of the second-1 semiconductor layer, and
the third-1 metal layer is formed from an upper surface of the second-1 metal layer to an upper surface of the third-1 semiconductor layer along an inner surface of the third-1 semiconductor layer.

8. The pixel device according to claim 7, wherein
the first insulating layer comprises a first-1 opening in which the first-1 semiconductor layer adjoins the first-1 metal layer,
the second insulating layer comprises a second-3 opening in which the first-2 semiconductor layer adjoins the second-1 metal layer, and
the third insulating layer comprises a third-3 opening in which the third-1 semiconductor layer adjoins the third-1 metal layer,
the second-3 opening being placed above the first-1 opening to deviate therefrom,
the third-3 opening being placed above the second-3 opening.

9. The pixel device according to claim 8, comprising:
a second-1 opening in which the first-1 metal layer adjoins the second-1 metal layer; and
a third-1 opening in which the second-1 metal layer adjoins the third-1 metal layer,
wherein the second-1 opening is disposed on the first insulating layer and is formed through the first transparent layer and the second insulating layer to expose a region of the upper surface of the first-1 metal layer, and
the third-1 opening is disposed on the second insulating layer and is formed through the second transparent layer and the third insulating layer to expose a region of an upper surface of the second-1 metal layer.

10. The pixel device according to claim 9, wherein
the second-1 metal layer is formed to cover an inner surface of the second-1 opening while exposing the upper surface of the first-1 metal layer, and
the third-1 metal layer is formed to cover an inner surface of the third-1 opening while exposing the upper surface of the second-1 metal layer.

11. The pixel device according to claim 9, wherein the second-1 metal layer is formed to fill the second-1 opening and the third-1 metal layer is formed to fill the third-1 opening.

12. The pixel device according to claim 6, wherein the first electrode comprises:
a first-2 metal layer electrically connected to the first-2 semiconductor layer;
a second-2 metal layer formed from an upper surface of the first-2 metal layer to an upper region of the second-2 semiconductor layer along an inner surface of the second light emitting structure; and
a third-2 metal layer formed from an upper surface of the second-2 metal layer to an upper region of the third-2 semiconductor layer along an inner surface of the third light emitting structure.

13. The pixel device according to claim 12, wherein
the first insulating layer comprises a first-2 opening in which the first-2 semiconductor layer adjoins the first-2 metal layer,
the second insulating layer comprises a second-2 opening in which the first-2 metal layer adjoins the second-2 metal layer, and
the third insulating layer comprises a third-2 opening in which the second-2 metal layer adjoins the third-2 metal layer,
the second-2 opening being placed above the first-2 opening to deviate therefrom,
the third-2 opening being placed above the second-2 opening.

14. The pixel device according to claim 13, wherein
the second-2 opening is disposed on the first insulating layer and is formed through the first transparent layer and the second insulating layer to expose a region of the upper surface of the first-2 metal layer, and
the third-2 opening is disposed on the second insulating layer and is formed through the second transparent layer and the third insulating layer to expose a region of the upper surface of the second-2 metal layer.

15. The pixel device according to claim 14, wherein the second-2 metal layer is formed to fill the second-2 opening and the third-2 metal layer is formed to fill the third-2 opening.

16. The pixel device according to claim 6, wherein the second electrode comprises:
a second-3 metal layer electrically connected to the second-2 semiconductor layer; and
a third-3 metal layer formed from an upper surface of the second-3 metal layer to an upper surface of the third-2 semiconductor layer along an inner surface of the third light emitting structure.

17. The pixel device according to claim 16, wherein
the second insulating layer comprises a second-4 opening in which the second-2 semiconductor layer adjoins the second-3 metal layer, and
the third insulating layer comprises a third-4 opening in which the second-3 metal layer adjoins the third-3 metal layer,
the third-4 opening being placed above the second-4 opening.

18. The pixel device according to claim 16, wherein the third-4 opening is placed on the second insulating layer and is formed through the second transparent layer and the third insulating layer to expose a region of the upper surface of the second-3 metal layer.

19. The pixel device according to claim 18, wherein the third-3 metal layer is formed to fill the third-4 opening.

20. The pixel device according to claim 6, wherein the third electrode comprises a third-4 metal layer electrically connected to the third-3 semiconductor layer.

21. A pixel device comprising:
a first light emitting source comprising a first light emitting structure emitting first light and a first buffer structure spaced apart from the first light emitting structure;
a second light emitting source comprising a second light emitting structure emitting second light and a second buffer structure spaced apart from the second light emitting structure; and
a third light emitting source comprising a third light emitting structure emitting third light and a third buffer structure spaced apart from the third light emitting structure,
wherein the second light emitting source is stacked on the third light emitting source and the third light emitting source is stacked on the second light emitting source, and
wherein the first buffer structure, the second buffer structure, and the third buffer structure are non-emissive.

22. The pixel device according to claim 21, wherein the first light emitting source, the second light emitting source, and the third light emitting source emit different colors of visible light.

23. The pixel device according to claim 21, wherein
the first light emitting source comprises a first-1 semiconductor layer, a first-2 semiconductor layer, and a first active layer formed between the first-1 semiconductor layer and the first-2 semiconductor layer,
the second light emitting source comprises a second-1 semiconductor layer, a second-2 semiconductor layer, and a second active layer formed between the second-1 semiconductor layer and the second-2 semiconductor layer, and
the third light emitting source comprises a third-1 semiconductor layer, a third-2 semiconductor layer, and a third active layer formed between the third-1 semiconductor layer and the third-2 semiconductor layer.

24. The pixel device according to claim 23, wherein
the first light emitting structure comprises the first active layer and the first-2 semiconductor layer formed on the first-1 semiconductor layer,
the second light emitting structure comprises the second active layer and the second-2 semiconductor layer formed on the second-1 semiconductor layer, and
the third light emitting structure comprises the third active layer and the third-2 semiconductor layer formed on the third-1 semiconductor layer.

25. The pixel device according to claim 23, wherein
the first buffer structure comprises the first active layer and the first-2 semiconductor layer formed on the first-1 semiconductor layer,
the second buffer structure comprises the second active layer and the second-2 semiconductor layer formed on the second-1 semiconductor layer,
the third buffer structure comprises the third active layer and the third-2 semiconductor layer formed on the third-1 semiconductor layer.

26. The pixel device according to claim 23, comprising;
a common electrode electrically connected to all of the first-1 semiconductor layer, the second-1 semiconductor layer, and the third-1 semiconductor layer;
a first electrode electrically connected to the first-2 semiconductor layer;
a second electrode electrically connected to the second-2 semiconductor layer; and
a third electrode electrically connected to the third-2 semiconductor layer; and

27. The pixel device according to claim 26, comprising:
a first transparent layer disposed between the first light emitting source and the second light emitting source; and
a second transparent layer disposed between the second light emitting source and the third light emitting source.

28. The pixel device according to claim 27, wherein
the common electrode is formed through the first transparent layer and the second transparent layer to be electrically connected to the first-1 semiconductor layer and the second-1 semiconductor layer,
the first electrode is formed through the first transparent layer and the second transparent layer to be electrically connected to the first-2 semiconductor layer, and
the second electrode is formed through the second transparent layer to be electrically connected to the second-2 semiconductor layer.

29. The pixel device according to claim 28, wherein the common electrode comprises:
a first-1 metal layer formed on the first-1 semiconductor layer of the first light emitting source to contact first-1 semiconductor layer;
a first-1 connection metal layer formed through the first transparent layer to contact the first-1 metal layer;
a second-1 metal layer formed through the second-1 semiconductor layer of the second light emitting source to contact the second-1 semiconductor layer;
a second-1 connection metal layer formed through the second transparent layer to contact the second-1 metal layer; and
a third-1 metal layer formed through the third-1 semiconductor layer of the third light emitting source to contact the third-1 semiconductor layer,
at least a region of the first-1 connection metal layer being disposed on the first-1 metal layer,
at least a region of the second-1 metal layer being disposed on the first-1 connection metal layer,
at least a region of the second-1 connection metal layer being disposed on the second-1 metal layer, and
at least a region of the third-1 metal layer being disposed on the second-1 connection metal layer.

30. The pixel device according to claim 28, wherein the first electrode comprises:
a first-2 metal layer formed on the first-2 semiconductor layer of the first light emitting source to be electrically connected to the first-2 semiconductor layer;
a first-2 connection metal layer formed through the first transparent layer to contact the first-2 metal layer;
a second-2 metal layer formed through the second-1 semiconductor layer of the second light emitting source and insulated from the second-1 semiconductor layer;
a second-2 connection metal layer formed through the second transparent layer to contact the second-2 metal layer; and
a third-2 metal layer formed through the third-1 semiconductor layer of the third light emitting source and insulated from the third-1 semiconductor layer,
at least a region of the first-2 connection metal layer being disposed on the first-2 metal layer,
at least a region of the second-2 metal layer being disposed on the first-2 connection metal layer,
at least a region of the second-2 connection metal layer being disposed on the second-2 metal layer, and
at least a region of the third-2 metal layer being disposed on the second-2 connection metal layer.

31. The pixel device according to claim 28, wherein the second electrode comprises:
a second-3 metal layer formed on the second-2 semiconductor layer of the second light emitting source to be electrically connected to the second-2 semiconductor layer;
a second-3 connection metal layer formed through the second transparent layer to contact the second-3 metal layer; and
a third-3 metal layer formed through the third-1 semiconductor layer of the third light emitting source and insulated from the third-1 semiconductor layer,
at least a region of the second-3 connection metal layer being disposed on the second-3 metal layer, and
at least a region of the third-3 metal layer being disposed on the second-3 connection metal layer.

32. The pixel device according to claim 28, wherein the third electrode comprises a third-4 metal layer formed on the third-2 semiconductor layer of the third light emitting source to be electrically connected to the third-2 semiconductor layer.

33. The pixel device according to claim 21, wherein the second light emitting structure is partially disposed on the first light emitting structure and the third light emitting structure is partially disposed on the second light emitting structure.

34. The pixel device according to claim 33, wherein
the first buffer structure, the second buffer structure, and the second buffer structure are formed outside a region in which all of the first light emitting structure, the second light emitting structure, and the third light emitting structure are stacked.

35. The pixel device according to claim 26, wherein the common electrode, the first electrode, the second electrode, and the third electrode are formed outside a region in which all of the first light emitting structure, the second light emitting structure, and the third light emitting structure are stacked.
